# EUROPEAN PATENT SPECIFICATION

(11) **EP 3 490 019 B1**
(45) Date of publication and mention of the grant of the patent: **27.01.2021**
(21) Application number: 17856226.0
(22) Date of filing: 27.09.2017
(51) Int. Cl.: H01L 51/50, C08G 61/00, H05B 33/12, H01L 51/00

(54) **LIGHT-EMITTING ELEMENT**
LICHTEMITTIERENDES ELEMENT
ÉLÉMENT ÉLECTROLUMINESCENT

(30) Priority: 29.09.2016 JP 2016190838
(43) Date of publication of application: 29.05.2019
(73) Proprietor: Sumitomo Chemical Company Limited, Tokyo 104-8260 (JP)
(72) Inventor: SASADA, Toshiaki, Tsukuba-shi Ibaraki 300-3294 (JP); MATSUMOTO, Ryuji, Tsukuba-shi Ibaraki 300-3294 (JP); YOSHIDA, Tomoyasu, Tokyo 104-8260 (JP)
(74) Representative: J A Kemp LLP
(86) International application number: PCT/JP2017/034965
(87) International publication number: WO 2018/062277

(56) References cited:
- WO-A1-2012/096263
- WO-A1-2015/020217
- WO-A1-2015/135625
- WO-A1-2016/091351
- WO-A1-2016/091353
- JP-A- 2016 092 280
- JP-A- 2016 115 940
- JP-A- 2016 171 319
- JP-A- 2017 054 870

## Description

### Technical Field

The present invention relates to a light emitting device.

### Background Art

Organic electroluminescent devices (hereinafter, referred to also as light emitting device) can be used suitably for applications of display and illumination, and have been researched and developed. For example, Patent Document 1 describes a light emitting device having a hole transporting layer containing α-NPD and a light emitting layer containing a compound (D-5) represented by the following formula and a fluorescent compound (TTPA) represented by the following formula. The hole transporting layer described in Patent Document 1 is a layer not containing a crosslinked body of a crosslink material. Further, the compound (D-5) is not a compound represented by the formula (T) described later.

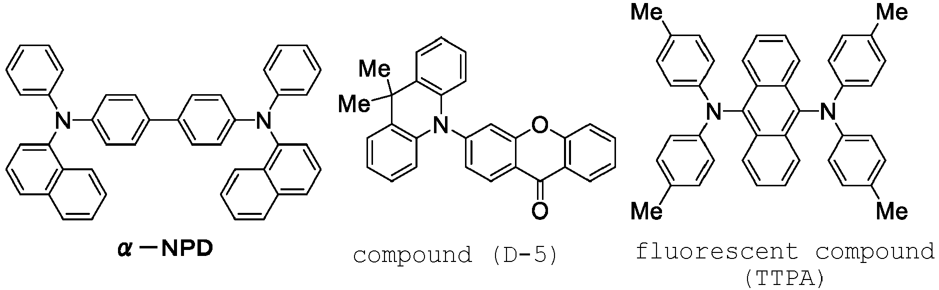

Patent Document 2 describes a formulation containing organic materials for producing organic electronic devices, comprising one or more organic solvents and at least one type of organic luminescent compound that exhibits thermally activated delayed fluoresence (a TADF compound) and has a separation between its lowest triplet state and first excited singlet state of less than or equal to 0.15 eV.

Patent Document 3 describes an organic luminescent compound that exhibits thermally activated delayed fluoresence (a TADF compound), contains at least one solubilising group, does not contain any metals, and has a separation between its first excited triplet state and first excited singlet state of less than or equal to 0.15 eV.

### Prior Art Document

### Patent Document

[Patent Document 1] Japanese Unexamined Patent Application Publication No. 2016-092280
[Patent Document 2] International Patent Application Publication No. WO 2015/135625 A1
[Patent Document 3] International Patent Application Publication No. WO 2016/091353 A1

### Summary of the Invention

### Problem to be Solved by the Invention

However, the above-described light emitting device is not necessarily sufficient in light emission efficiency.

Then, the present invention has an object of providing a light emitting device excellent in light emission efficiency.

### Means for Solving the Problem

The present invention provides the following [1] to [13].
[1] A light emitting device having an anode, a cathode, a first organic layer disposed between the anode and the cathode and a second organic layer disposed between the anode and the cathode, wherein
   the above-described first organic layer is a layer containing a compound represented by the formula (T) and a fluorescent compound represented by the formula (B),
   the above-described second organic layer is a layer containing a crosslinked body of a crosslink material,
   the absolute value of the difference between the energy level at the lowest triplet excited state and the energy level at the lowest singlet excited state of said compound represented by the formula (T) is 0.50 eV or less,
   the absolute value of the difference been the energy level at the lowest triplet excited state and the energy level at the lowest singlet excited state of saidfluorescent compound represented by the formula (B) is 0.55 eV or more and 2.5 eV or less,
   the compound represented by the formula (T) is a host material having at least one function selected from the group consisting of hole injectability, hole transportability, electron injectability and electron transportability,
   the fluorescent compound represented by the formula (B) is a light emitting material, and
   the lowest excited triplet state of the host material is at an energy level higher than that of the lowest excited triplet state of the light emitting material, and the lowest excited singlet state of the host material is at an energy level that is higher than the lowest excited singlet state of the light emitting material,
   wherein the energy level at the lowest triplet excited state and the energy level at the lowest singlet excited state of a compound are calculated by optimizing the structure of the ground state of the compound with the B3LYP level density functional method and using 6-31G* as the basis function in this operation, using Gaussian09 as a quantum chemical calculation program and the B3LYP level time-dependent density functional method, and, when an atom for which 6-31G* cannot be used is contained, using LANL2DZ for the atom: 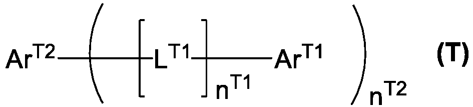 [wherein,
   n^{T1} represents an integer of 0 or more and 5 or less. When a plurality of n^{T1} are present, they may be the same or different.
   n^{T2} represents an integer of 1 or more and 10 or less.
   Ar^{T1} is a single-ring or condensed-ring monovalent hetero ring group containing a nitrogen atom having no double bond as a ring constituent atom and not containing a nitrogen atom having a double bond as a ring constituent atom, and the group optionally has a substituent. When a plurality of such substituents are present, they may be combined together to form a ring together with atoms to which they are attached. When a plurality of Ar^{T1} are present, they may be the same or different.
   L^{T1} represents an alkylene group, a cycloalkylene group, an arylene group, a divalent hetero ring group, a group represented by -N(R^{T1'}) -, an oxygen atom or a sulfur atom, and these groups optionally have a substituent. R^{T1'} represents a hydrogen atom, an alkyl group, a cycloalkyl group, an aryl group or a monovalent hetero ring group, and these groups optionally have a substituent. When a plurality of L^{T1} are present, they may be the same or different.
   Ar^{T2} is a single-ring or condensed-ring hetero ring group containing a nitrogen atom having a double bond as a ring constituent atom, and the group optionally has a substituent. When a plurality of such substituents are present, they may be combined together to form a ring together with atoms to which they are attached.]

   Ar^{1B}(̵R^{1B})_{n1B} **(B)**

   [wherein,
   n^{1B} represents an integer of 0 or more and 15 or less.
   Ar^{1B} represents a condensed-ring aromatic hydrocarbon group, and these groups optionally have a substituent. When a plurality of such substituents are present, they may be combined together to form a ring together with atoms to which they are attached.
   R^{1B} represents an alkyl group, a cycloalkyl group, an alkoxy group, a cycloalkoxy group, an aryl group, a monovalent hetero ring group, a substituted amino group, an alkenyl group, a cycloalkenyl group, an alkynyl group or a cycloalkynyl group, and these groups optionally have a substituent. When a plurality of R^{1B} are present, they may be the same or different and may be combined together to form a ring together with carbon atoms to which they are attached.].
[2] The light emitting device according to [1], wherein the above-described Ar^{1B} is a group obtained by removing from a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring at least one hydrogen atom bonding directly to a carbon atom constituting the ring (the group optionally has a substituent).
[3] The light emitting device according to [1] or [2], wherein the above-described R^{1B} is an alkyl group, an aryl group or a substituted amino group (these groups optionally have a substituent).
[4] The light emitting device according to any one of [1] to [3], wherein the above-described crosslink material is a low molecular compound having at least one crosslink group selected from Group A of crosslink group or a polymer compound containing a crosslink constitutional unit having at least one crosslink group selected from Group A of crosslink group: (Group A of crosslink group) 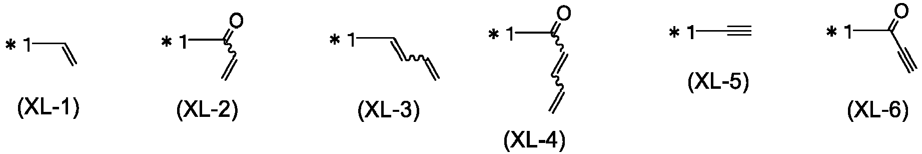 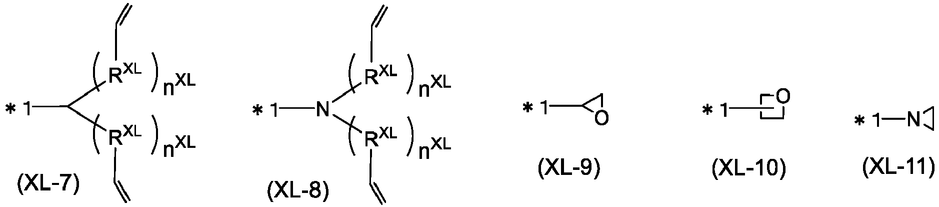 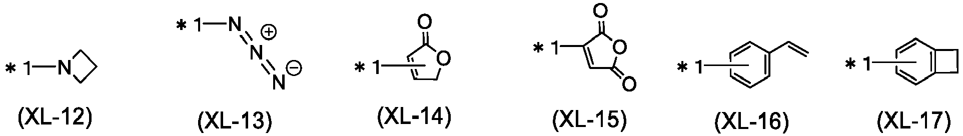 [wherein, R^{XL} represents a methylene group, an oxygen atom or a sulfur atom, and n^{XL} represents an integer of 0 to 5. When a plurality of R^{XL} are present, they may be the same or different and when a plurality of n^{XL} are present, they may be the same or different. *1 represents a binding position. These crosslink groups optionally have a substituent.].
[5] The light emitting device according to [4], wherein the above-described crosslink material is a polymer compound containing a crosslink constitutional unit having at least one crosslink group selected from Group A of crosslink group described above, and
   the above-described crosslink constitutional unit is a constitutional unit represented by the formula (2) or a constitutional unit represented by the formula (2'): 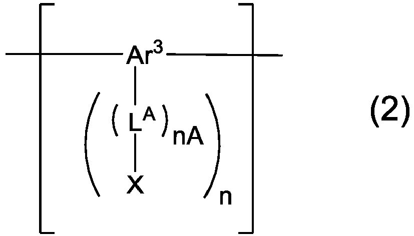 [wherein,
   nA represents an integer of 0 to 5, and n represents 1 or 2. When a plurality of nA are present, they may be the same or different.
   Ar³ represents an aromatic hydrocarbon group or a hetero ring group, and these groups optionally have a substituent.
   L^{A} represents an alkylene group, a cycloalkylene group, an arylene group, a divalent hetero ring group, a group represented by -N(R')-, an oxygen atom or a sulfur atom, and these groups optionally have a substituent. R' represents a hydrogen atom, an alkyl group, a cycloalkyl group, an aryl group or a monovalent hetero ring group, and these groups optionally have a substituent. When a plurality of L^{A} are present, they may be the same or different.
   X represents a crosslink group selected from Group A of crosslink group described above. When a plurality of X are present, they may be the same or different.] 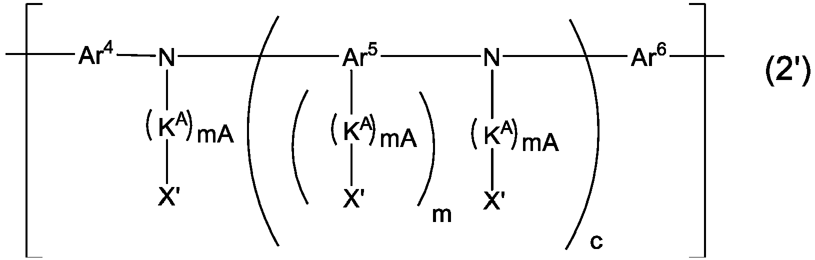
   [wherein,
   mA represents an integer of 0 to 5, m represents an integer of 1 to 4, and c represents an integer of 0 or 1. When a plurality of mA are present, they may be the same or different.
   Ar⁵ represents an aromatic hydrocarbon group, a hetero ring group or a group in which at least one aromatic hydrocarbon ring and at least one hetero ring are bonded directly, and these groups optionally have a substituent.
   Ar⁴ and Ar⁶ each independently represent an arylene group or a divalent hetero ring group, and these groups optionally have a substituent.
   Ar⁴, Ar⁵ and Ar⁶ each may be bonded directly or bonded via an oxygen atom or a sulfur atom to a group other than this group, bonded to a nitrogen atom to which the group is attached, to form a ring.
   K^{A} represents an alkylene group, a cycloalkylene group, an arylene group, a divalent hetero ring group, a group represented by -N(R')-, an oxygen atom or a sulfur atom, and these groups optionally have a substituent. R' represents a hydrogen atom, an alkyl group, a cycloalkyl group, an aryl group or a monovalent hetero ring group, and these groups optionally have a substituent. When a plurality of K^{A} are present, they may be the same or different.
   X' represents a crosslink group selected from Group A of crosslink group described above, a hydrogen atom, an alkyl group, a cycloalkyl group, an aryl group or a monovalent hetero ring group, and these groups optionally have a substituent. When a plurality of X' are present, they may be the same or different. However, at least one X' is a crosslink group selected from Group A of crosslink group described above.].
[6] The light emitting device according to any one of [1] to [3], wherein the above-described crosslink material is a low molecular compound represented by the formula (3): 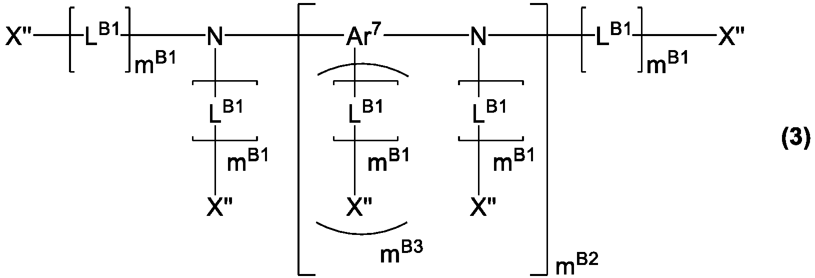 [wherein,
   m^{B1}, m^{B2} and m^{B3} each independently represent an integer of 0 or more and 10 or less. A plurality of m^{B1} may be the same or different. When a plurality of m^{B3} are present, they may be the same or different.
   Ar⁷ represents an aromatic hydrocarbon group, a hetero ring group or a group in which at least one aromatic hydrocarbon ring and at least one hetero ring are bonded directly, and these groups optionally have a substituent. When a plurality of Ar⁷ are present, they may be the same or different.
   L^{B1} represents an alkylene group, a cycloalkylene group, an arylene group, a divalent hetero ring group, a group represented by -N(R''') -, an oxygen atom or a sulfur atom, and these groups optionally have a substituent. R''' represents a hydrogen atom, an alkyl group, a cycloalkyl group, an aryl group or a monovalent hetero ring group, and these groups optionally have a substituent. When a plurality of L^{B1} are present, they may be the same or different.
   X'' represents a crosslink group selected from Group A of crosslink group described above, a hydrogen atom, an alkyl group, a cycloalkyl group, an aryl group or a monovalent hetero ring group, and these groups optionally have a substituent. A plurality of X'' may be the same or different. At least one of a plurality of X'' is a crosslink group selected from Group A of crosslink group described above.].
[7] The light emitting device according to any one of [1] to [6], wherein the above-described Ar^{T1} is a group represented by the formula (T1-1): 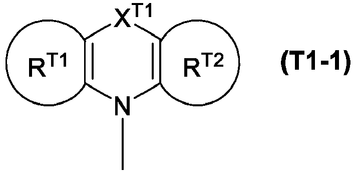 [wherein,
   the ring R^{T1} and the ring R^{T2} each independently represent an aromatic hydrocarbon ring or a hetero ring not containing a nitrogen atom having a double bond as a ring constituent atom, and these rings optionally have a substituent. When a plurality of such substituents are present, they may be combined together to form a ring together with atoms to which they are attached.
   X^{T1} represents a single bond, an oxygen atom, a sulfur atom, a group represented by -N(R^{XT1})- or a group represented by -C(R^{XT1'})₂-. R^{XT1} and R^{XT1'} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent. Aplurality of R^{XT1'} may be the same or different and may be combined together to form a ring together with carbon atoms to which they are attached.
   R^{XT1'} and the substituent which the ring R^{T1} optionally has, R^{XT1} and the substituent which the ring R^{T2} optionally has, R^{XT1'} and the substituent which the ring R^{T1} optionally has, and R^{XT1'} and the substituent which the ring R^{T2} optionally has each may be combined together to form a ring together with atoms to which they are attached.].
[8] The light emitting device according to [7], wherein the above-described group represented by the formula (T1-1) is a group represented by the formula (T1-1A), a group represented by the formula (T1-1B), a group represented by the formula (T1-1C) or a group represented by the formula (T1-1D): 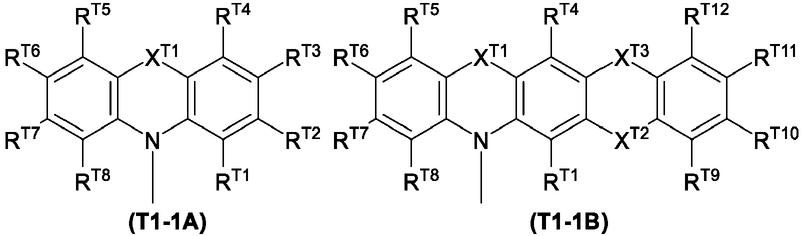 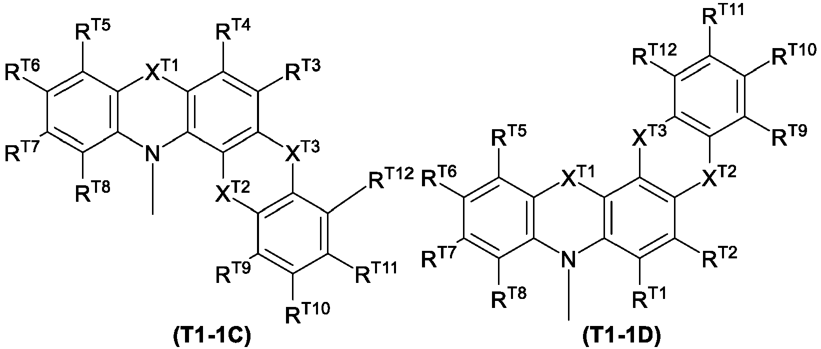 [wherein,
   X^{T1} represents the same meaning as described above.
   X^{T2} and X^{T3} each independently represent a single bond, an oxygen atom, a sulfur atom, a group represented by -N(R^{XT2})- or a group represented by -C(R^{XT2'})₂-. R^{XT2} and R^{XT2'} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent. A plurality of R^{XT2'} may be the same or different and may be combined together to form a ring together with carbon atoms to which they are attached.
   R^{T1}, R^{T2}, R^{T3}, R^{T4}, R^{T5}, R^{T6}, R^{T7}, R^{T8}, R^{T9}, R^{T10}, R^{T11} and R^{T12} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent.
   R^{T1} and R^{T2}, R^{T2} and R^{T3}, R^{T3} and R^{T4}, R^{T5} and R^{T6}, R^{T6} and R^{T7}, R^{T7} and R^{T8}, R^{T9} and R^{T10}, R^{T10} and R^{T11}, and R^{T11} and R^{T12} each may be combined together to form a ring together with carbon atoms to which they are attached.].
[9] The light emitting device according to any one of [1] to [8], wherein the above-described Ar^{T2} is a group obtained by removing from a diazole ring, a triazole ring, an oxadiazole ring, a thiadiazole ring, a thiazole ring, an oxazole ring, an isothiazole ring, an isooxazole ring, a benzodiazole ring, a benzotriazole ring, a benzooxadiazole ring, a benzothiadiazole ring, a benzothiazole ring, a benzooxazole ring, an azacarbazole ring, a diazacarbazole ring, a pyridine ring, a diazabenzene ring, a triazine ring, an azanaphthalene ring, a diazanaphthalene ring, a triazanaphthalene ring, a tetraazanaphthalene ring, an azaanthracene ring, a diazaanthracene ring, a triazaanthracene ring, a tetraazaanthracene ring, an azaphenanthrene ring, a diazaphenanthrene ring, a triazaphenanthrene ring or a tetraazaphenanthrene ring at least one hydrogen atom bonding directly to an atom constituting the ring (the group optionally has a substituent).
[10] The light emitting device according to any one of [1] to [9], wherein the above-described first organic layer is a layer not containing a phosphorescent metal complex.
[11] The light emitting device according to any one of [1] to [10], wherein the above-described first organic layer further contains at least one selected from the group consisting of a hole transporting material, a hole injection material, an electron transporting material, an electron injection material, a light emitting material and an antioxidant.
[12] The light emitting device according to any one of [1] to [11], wherein the above-described first organic layer and the above-described second organic layer are adjacent.
[13] The light emitting device according to any one of [1] to [12], wherein the above-described second organic layer is a layer disposed between the above-described anode and the above-described first organic layer.

### Effect of the Invention

According to the present invention, it is possible to provide a light emitting device excellent in light emission efficiency.

### Modes for Carrying Out the Invention

Suitable embodiments of the present invention will be illustrated in detail below.

### <Explanation of common terms>

Terms commonly used in the present specification have the following meanings unless otherwise stated.

Me represents a methyl group, Et represents an ethyl group, Bu represents a butyl group, i-Pr represents an isopropyl group and t-Bu represents a tert-butyl group.

A hydrogen atom may be a heavy hydrogen atom or a light hydrogen atom.

In the formula representing a metal complex, the solid line representing a bond with the central metal means a covalent bond or a coordination bond.

"Polymer compound" means a polymer having molecular weight distribution and having a polystyrene-equivalent number-average molecular weight of 1×10³ to 1×10⁸.

The polymer compound may be any of a block copolymer, a random copolymer, an alternating copolymer and a graft copolymer, and may also be another form.

The end group of the polymer compound is preferably a stable group since if a polymerization active group remains intact there, there is a possibility of a decrease in a light emitting property or luminance life when the polymer compound is used for fabrication of a light emitting device. The end group of the polymer compound is preferably a group conjugatively bonded to the main chain and includes, for example, an aryl group bonding to the main chain of the polymer compound via a carbon-carbon bond or a group bonded to a monovalent hetero ring group.

"Low molecular compound" means a compound having no molecular weight distribution and having a molecular weight of 1×10⁴ or less.

"Constitutional unit" means a unit occurring once or more times in the polymer compound.

"Alkyl group" may be any of linear and branched. The number of carbon atoms of the linear alkyl group is, not including the number of carbon atoms of the substituent, usually 1 to 50, preferably 3 to 30, more preferably 4 to 20. The number of carbon atoms of the branched alkyl group is, not including the number of carbon atoms of the substituent, usually 3 to 50, preferably 3 to 30, more preferably 4 to 20.

The alkyl group optionally has a substituent and examples thereof include, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3, 7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom and the like (for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group).

The number of carbon atoms of "cycloalkyl group" is, not including the number of carbon atoms of the substituent, usually 3 to 50, preferably 3 to 30, more preferably 4 to 20.

The cycloalkyl group optionally has a substituent and examples thereof include a cyclohexyl group, a cyclohexylmethyl group and a cyclohexylethyl group.

"Aryl group" means an atomic group remaining after removing from an aromatic hydrocarbon one hydrogen atom bonding directly to a carbon atom constituting the ring. The number of carbon atoms of the aryl group is, not including the number of carbon atoms of the substituent, usually 6 to 60, preferably 6 to 20, more preferably 6 to 10.

The aryl group optionally has a substituent and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom and the like.

"Alkoxy group" may be any of linear and branched. The number of carbon atoms of the linear alkoxy group is, not including the number of carbon atoms of the substituent, usually 1 to 40, preferably 4 to 10. The number of carbon atoms of the branched alkoxy group is, not including the number of carbon atoms of the substituent, usually 3 to 40, preferably 4 to 10.

The alkoxy group optionally has a substituent and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of the "cycloalkoxy group" is, not including the number of carbon atoms of the substituent, usually 3 to 40, preferably 4 to 10.

The cycloalkoxy group optionally has a substituent and examples thereof include a cyclohexyloxy group.

The number of carbon atoms of the "aryloxy group" is, not including the number of carbon atoms of the substituent, usually 6 to 60, preferably 6 to 48.

The aryloxy group optionally has a substituent and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom or the like.

"p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of the p-valent hetero ring groups, "p-valent aromatic hetero ring group" as an atomic group remaining after removing from an aromatic heterocyclic compound p hydrogen atoms among hydrogen atoms bonding directly to carbon atoms or hetero atoms constituting the ring is preferable.

"Aromatic heterocyclic compound " means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to the hetero ring even if the hetero ring itself shows no aromaticity such as phenoxazine, phenothiazine, dibenzoborole, dibenzosilole, benzopyran and the like.

The number of carbon atoms of the monovalent hetero ring group is, not including the number of carbon atoms of the substituent, usually 2 to 60, preferably 4 to 20.

The monovalent hetero ring group optionally has a substituent and examples thereof include a thienyl group, a pyrrolyl group, a furyl group, a pyridinyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferred. The substituent which the amino group has is preferably an alkyl group, a cycloalkyl group, an aryl group or a monovalent hetero ring group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear and branched. The number of carbon atoms of the linear alkenyl group is, not including the number of carbon atoms of the substituent, usually 2 to 30, preferably 3 to 20. The number of carbon atoms of the branched alkenyl group is, not including the number of carbon atoms of the substituent, usually 3 to 30, preferably 4 to 20.

The number of carbon atoms of the "cycloalkenyl group" is, not including the number of carbon atoms of the substituent, usually 3 to 30, preferably 4 to 20.

The alkenyl group and the cycloalkenyl group optionally have a substituent and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"Alkynyl group" may be any of linear and branched. The number of carbon atoms of the alkynyl group is, not including the number of carbon atoms of the substituent, usually 2 to 20, preferably 3 to 20. The number of carbon atoms of the branched alkynyl group is, not including the number of carbon atoms of the substituent, usually 4 to 30, preferably 4 to 20.

The number of carbon atoms of the "cycloalkynyl group" is, not including the number of carbon atoms of the substituent, usually 4 to 30, preferably 4 to 20.

The alkynyl group and the cycloalkynyl group optionally have a substituent and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"Arylene group" means an atomic group remaining after removing from an aromatic hydrocarbon two hydrogen atoms bonding directly to carbon atoms constituting the ring. The number of carbon atoms of the arylene group is, not including the number of carbon atoms of the substituent, usually 6 to 60, preferably 6 to 30, more preferably 6 to 18.

The arylene group optionally has a substituent and examples thereof include a phenylene group, a naphthalenediyl group, an anthracenediyl group, a phenanthrenedilyl group, a dihydrophenanthrenedilyl group, a naphthacenediyl group, a fluorenediyl group, a pyrenediyl group, a perylenediyl group and a chrysenediyl group, and these groups having a substituent, and groups represented by the formula (A-1) to the formula (A-20) are preferable. The arylene group includes groups obtained by bonding a plurality of these groups. 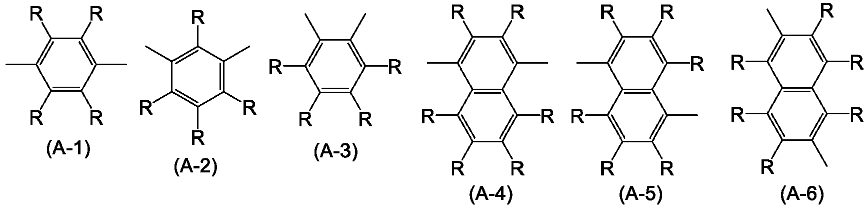 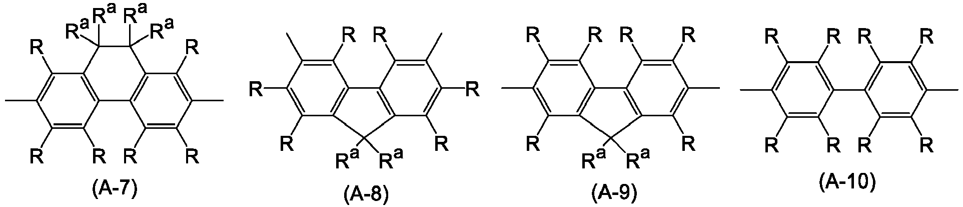 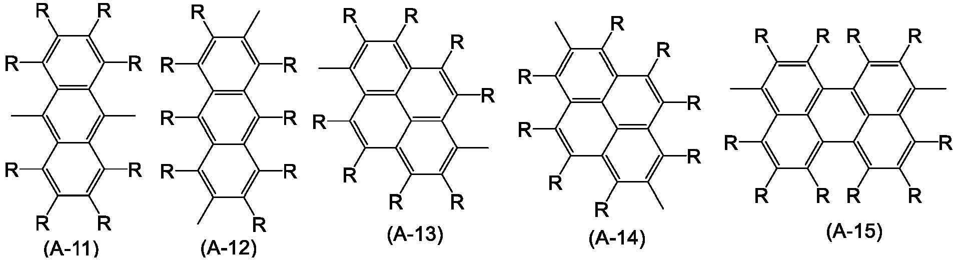 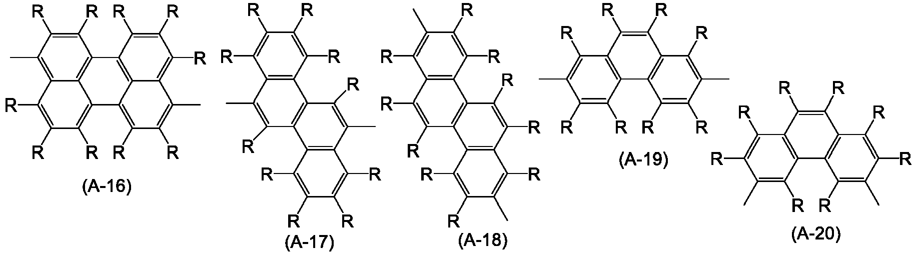 [wherein, R and R^{a} each independently represent a hydrogen atom, an alkyl group, a cycloalkyl group, an aryl group or a monovalent hetero ring group. A plurality of R and R^{a} may be the same or different at each occurrence, groups R^{a} may be combined together to form a ring together with atoms to which they are attached.]

The number of carbon atoms of the divalent hetero ring group is, not including the number of carbon atoms of the substituent, usually 2 to 60, preferably 3 to 20, more preferably 4 to 15.

The divalent hetero ring group optionally has a substituent and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms bonding directly to carbon atoms or hetero atoms constituting the ring, preferably groups represented by the formula (AA-1) to the formula (AA-34). The divalent hetero ring group includes groups obtained by bonding a plurality of these groups. 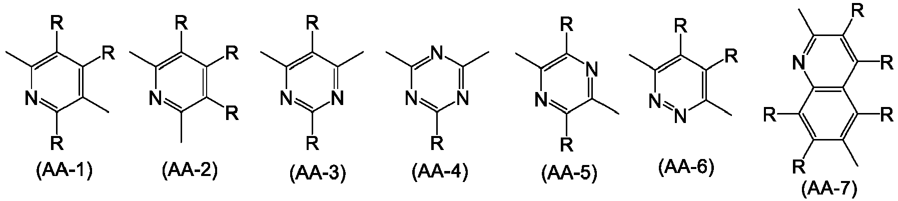 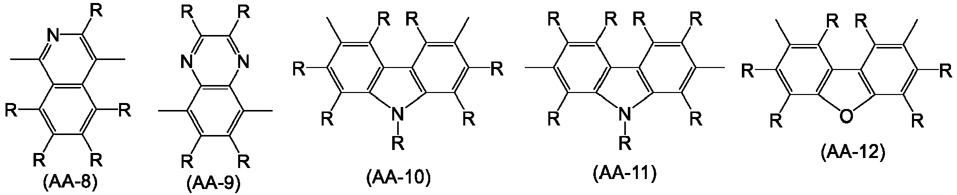 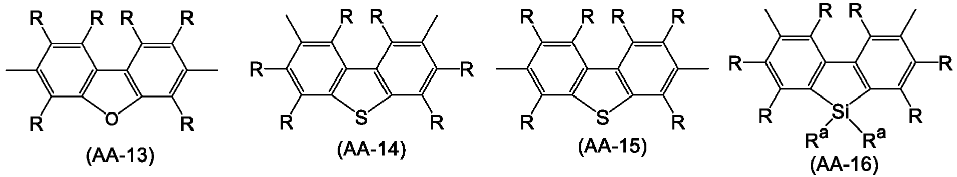 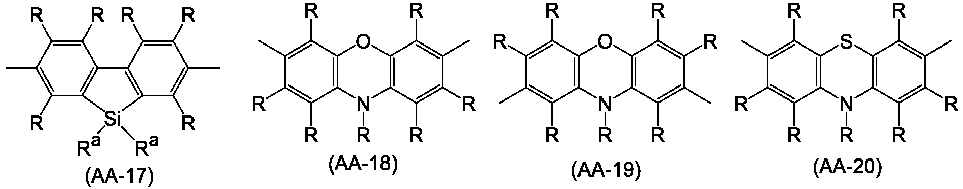 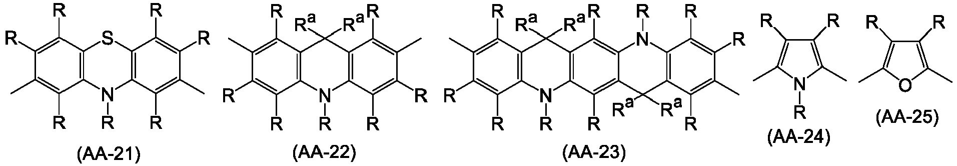 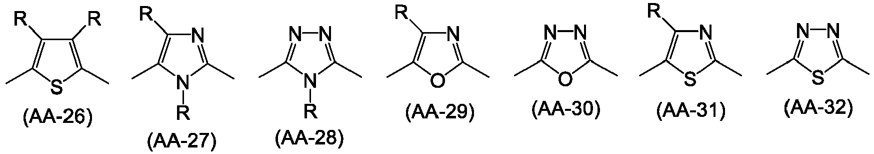 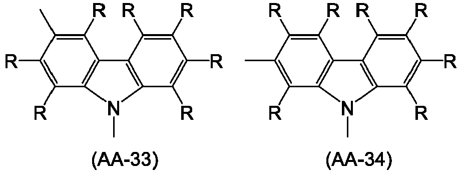 [wherein, R and R^{a} represent the same meaning as described above.]

"Crosslink group" refers to a group capable of generating a new bond by being subjected to a heating treatment, an ultraviolet irradiation treatment, a near-ultraviolet irradiation treatment, a visible light irradiation treatment, an infrared irradiation treatment, a radical reaction and the like, preferably includes crosslink groups represented by the formula (XL-1) to the formula (XL-17) in Group A of crosslink group.

"Substituent" denotes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may also be a crosslink group.

### <Light emitting device>

The light emitting device of the present invention is a light emitting device having an anode, a cathode, a first organic layer disposed between the anode and the cathode and a second organic layer disposed between the anode and the cathode, wherein the above-described first organic layer is a layer containing a compound represented by the formula (T) and a fluorescent compound represented by the formula (B) and the above-described second organic layer is a layer containing a crosslinked body of a crosslink material.

The method for forming the first organic layer and the second organic layer includes, for example, dry methods such as a vacuum vapor deposition method and the like and wet methods such as a spin coat method, an inkjet printing method and the like, and wet methods are preferable.

When the first organic layer is formed by a wet method, it is preferable to use a first ink described later.

When the second organic layer is formed by a wet method, it is preferable to use a second ink described later. After formation of the second organic layer, a crosslink material contained in the second organic layer can be crosslinked by heating or light irradiation, and it is preferable that a crosslink material contained in the second organic layer is crosslinked by heating. Since the second organic layer contains a crosslink material in cross-linked state (crosslinked body of a crosslink material), the second organic layer is substantially insolubilized with respect to a solvent Hence, the second organic layer can be suitably used for lamination of a light emitting device.

The temperature of heating for causing crosslinking is usually 25°C to 300°C, preferably 50°C to 260°C, more preferably 130°C to 230°C, further preferably 180°C to 210°C.

The time of heating is usually 0.1 minutes to 1000 minutes, preferably 0.5 minutes to 500 minutes, more preferably 1 minute to 120 minutes, further preferably 10 minutes to 60 minutes.

The kind of the light used for irradiation includes, for example, ultraviolet, near-ultraviolet and visible light.

The method for analyzing components contained in the first organic layer and the second organic layer includes, for example, chemical separation and analysis methods such as extraction and the like, instrumental analysis methods such as infrared spectroscopy (IR), nuclear magnetic resonance spectroscopy (NMR), mass spectrometry (MS) and the like, and analysis methods combining chemical separation and analysis methods with instrumental analysis methods.

By performing solid-liquid extraction on the first organic layer and the second organic layer using an organic solvent such as toluene, xylene, chloroform, tetrahydrofuran and the like, the components can be separated into components substantially insoluble in an organic solvent (insoluble component) and components soluble in an organic solvent (soluble component). The insoluble component can be analyzed by infrared spectroscopy or nuclear magnetic resonance spectroscopy and the soluble component can be analyzed by nuclear magnetic resonance spectroscopy or mass spectrometry.

### <First organic layer>

### [Compound represented by the formula (T)]

The compound represented by the formula (T) is a host material having at least one function selected from the group consisting of hole injectability, hole transportability, electron injectability and electron transportability.

The host material means a material which plays a role of transferring electric energy to the light emitting material The lowest excited triplet state of the host material is at energy level higher than the lowest excited triplet state of the light emitting material and the lowest excited singlet state of the host material is at energy level higher than the lowest excited singlet state of the light emitting material, since the light emitting material is allowed to emit light more efficiently by efficiently transferring electric energy from the host material to the light emitting material.

The compound represented by the formula (T) is preferably a thermally activated delayed fluorescence (TADF) material.

The absolute value of the difference between the energy level at the lowest triplet excited state and the energy level at the lowest singlet excited state (ΔE_{ST}) of the compound represented by the formula (T) is 0.50 eV or less, preferably 0.40 eV or less, more preferably 0.30 eV or less, further preferably 0.20 eV or less, particularly preferably 0.16 eV or less, especially preferably 0.13 eV or less. ΔE_{ST} of the compound represented by the formula (T) is preferably 0.0001 eV or more, more preferably 0.001 eV or more, further preferably 0.005 eV or more, particularly preferably 0.01 eV or more. ΔE_{ST} of the compound represented by the formula (T) is preferably 0.0001 eV or more and 0.40 eV or less, more preferably 0.001 eV or more and 0.20 eV or less, further preferably 0.005 eV or more and 0.16 eV or less, particularly preferably 0.01 eV or more and 0.13 eV or less, since the light emitting device of the present invention is excellent in light emission efficiency.

The oscillator strength of the compound represented by the formula (T) is preferably 0.0001 or more, more preferably 0.001 or more, further preferably 0.1 or more. The oscillator strength of the compound represented by the formula (T) is preferably 1 or less, more preferably 0.8 or less, further preferably 0.6 or less, particularly preferably 0.3 or less. The oscillator strength of the compound represented by the formula (T) is preferably 0.0001 or more and 1 or less, more preferably 0.001 or more and 0.3 or less, further preferably 0.1 or more and 0.3 or less, since the light emitting device of the present invention is excellent in light emission efficiency.

For calculation of ΔE_{ST} and oscillator strength value of a compound, the structure of the ground state of the compound is optimized by the B3LYP level density functional method, and 6-31G* is used as the basis function in this operation. Using Gaussian09 as a quantum chemical calculation program, ΔE_{ST} and oscillator strength of a compound are calculated by the B3LYP level time-dependent density functional method. However, when an atom for which 6-31G* cannot be used is contained, LANL2DZ is used for the atom.

The molecular weight of the compound represented by the formula (T) is preferably 1×10² to 1×10⁴, more preferably 2×10² to 5×10³, further preferably 3×10² to 3×10³, particularly preferably 5×10² to 1.5×10³.

n^{T1} is preferably an integer of 0 or more and 3 or less, more preferably an integer of 0 or more and 2 or less, further preferably 0 or 1, particularly preferably 0, since the light emitting device of the present invention is excellent in light emission efficiency.

n^{T2} is preferably an integer of 1 or more and 7 or less, more preferably an integer of 1 or more and 5 or less, further preferably an integer of 1 or more and 3 or less, particularly preferably 1 or 2, especially preferably 1, since the light emitting device of the present invention is excellent in light emission efficiency.

Ar^{T1} is a single-ring or condensed-ring monovalent hetero ring group containing a nitrogen atom having no double bond as a ring constituent atom and not containing a nitrogen atom having a double bond as a ring constituent atom. This monovalent hetero ring group optionally has a substituent.

"Nitrogen atom having no double bond" denotes a nitrogen atom having only a single bond between the nitrogen atom and all atoms bonded to the nitrogen atom.

"Containing a nitrogen atom having no double bond as a ring constituent atom" means that a group represented by -N(-R^{N})- (in the formula, R^{N} represents a hydrogen atom or a substituent.) or a group represented by the formula: 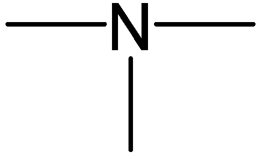 is contained in the ring.

"Nitrogen atom having a double bond" denotes a nitrogen atom having a double bond between the nitrogen atom and an atom bonded to the nitrogen atom.

"Containing a nitrogen atom having a double bond as a ring constituent atom" means that a group represented by -N= is contained in the ring.

In the single-ring or condensed-ring monovalent hetero ring group containing a nitrogen atom having no double bond as a ring constituent atom and not containing a nitrogen atom having a double bond as a ring constituent atom, the number of the nitrogen atom having no double bond constituting the ring is usually 1 to 10, preferably 1 to 5, more preferably 1 to 3, further preferably 1 or 2, particularly preferably 1.

In the single-ring or condensed-ring monovalent hetero ring group containing a nitrogen atom having no double bond as a ring constituent atom and not containing a nitrogen atom having a double bond as a ring constituent atom, the number of carbon atoms constituting the ring is usually 2 to 60, preferably 5 to 40, more preferably 10 to 25.

The single-ring monovalent hetero ring group containing a nitrogen atom having no double bond as a ring constituent atom and not containing a nitrogen atom having a double bond as a ring constituent atom includes, for example, groups obtained by removing from a pyrrole ring one hydrogen atom bonding directly to a carbon atom or a hetero atom constituting the ring, and these groups optionally have a substituent.

The condensed-ring monovalent hetero ring group containing a nitrogen atom having no double bond as a ring constituent atom and not containing a nitrogen atom having a double bond as a ring constituent atom includes, for example, groups obtained by removing from an indole ring, an isoindole ring, a carbazole ring, a 9,10-dihydroacridine ring, a 5,10-dihydrophenazine ring, an acridone ring, a quinacridone ring, a phenoxazine ring, a phenothiazine ring, an indolocarbazole ring, an indenocarbazole ring or rings obtained by condensing an aromatic hydrocarbon ring and/or a hetero ring not containing a nitrogen atom having a double bond as a ring constituent atom to these hetero rings one hydrogen atom bonding directly to a carbon atom or a hetero atom constituting the ring, and these groups optionally have a substituent. The examples and the preferable range of the aromatic hydrocarbon ring which may be condensed to a hetero ring are the same as the examples and the preferable range of the aromatic hydrocarbon ring represented by the ring R^{T1} and the ring R^{T2} described later. The examples and the preferable range of the hetero ring not containing a nitrogen atom having a double bond as a ring constituent atom which may be condensed to a hetero ring are the same as the examples and the preferable range of the hetero ring not containing a nitrogen atom having a double bond as a ring constituent atom represented by the ring R^{T1} and the ring R^{T2} described later.

The condensed-ring monovalent hetero ring group containing a nitrogen atom having no double bond as a ring constituent atom and not containing a nitrogen atom having a double bond as a ring constituent atom is preferably a group obtained by removing from a carbazole ring, a 9,10-dihydroacridine ring, a 5,10-dihydrophenazine ring, a phenoxazine ring, a phenothiazine ring, an indolocarbazole ring, an indenocarbazole ring or rings obtained by condensing an aromatic hydrocarbon ring and/or a hetero ring not containing a nitrogen atom having a double bond as a ring constituent atom to these hetero rings one hydrogen atom bonding directly to a carbon atom or a hetero atom constituting the ring, more preferably a group obtained by removing from a carbazole ring, a 9,10-dihydroacridine ring, a 5,10-dihydrophenazine ring, a phenoxazine ring, a phenothiazine ring, an indolocarbazole ring or an indenocarbazole ring one hydrogen atom bonding directly to a carbon atom or a hetero atom constituting the ring, further preferably a group obtained by removing from a carbazole ring, an indolocarbazole ring or an indenocarbazole ring one hydrogen atom bonding directly to a carbon atom or a hetero atom constituting the ring, particularly preferably a group obtained by removing from an indenocarbazole ring one hydrogen atom bonding directly to a carbon atom or a hetero atom constituting the ring, and these groups optionally have a substituent.

As the substituent which Ar^{T1} optionally has, an alkyl group, a cycloalkyl group, an alkoxy group, a cycloalkoxy group, an aryl group, an aryloxy group, a monovalent hetero ring group, a substituted amino group, a halogen atom or a cyano group is preferable, an alkyl group, a cycloalkyl group, an alkoxy group, a cycloalkoxy group, an aryl group, a monovalent hetero ring group, a substituted amino group or a cyano group is more preferable, an alkyl group, a cycloalkyl group, an aryl group, a monovalent hetero ring group or a substituted amino group is further preferable, an alkyl group, an aryl group or a substituted amino group is particularly preferable, an alkyl group is especially preferable, and these groups optionally further have a substituent.

The aryl group as the substituent which Ar^{T1} optionally has includes, for example, groups obtained by removing from a benzene ring, a naphthalene ring, an anthracene ring, a phenanthrene ring, a dihydrophenanthrene ring, a naphthacene ring, a fluorene ring, a spirobifluorene ring, an indene ring, a pyrene ring, a perylene ring, a chrysene ring or a ring obtained by condensing these rings one hydrogen atom bonding directly to a carbon atom constituting the ring, and is preferably a group obtained by removing from a benzene ring, a naphthalene ring, an anthracene ring, a phenanthrene ring, a dihydrophenanthrene ring, a naphthacene ring, a fluorene ring, a spirobifluorene ring, an indene ring, a pyrene ring, a perylene ring or a chrysene ring one hydrogen atom bonding directly to a carbon atom constituting the ring, more preferably a phenyl group, a naphthyl group, an anthracenyl group, a phenanthrenyl group, a dihydrophenanthrenyl group, a fluorenyl group or a spirobifluorenyl group, further preferably a phenyl group, a naphthyl group, a fluorenyl group or a spirobifluorenyl group, particularly preferably a phenyl group, and these groups optionally have a substituent.

The monovalent hetero ring group as the substituent which Ar^{T1} optionally has includes, for example, groups obtained by removing from a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring or rings obtained by condensing an aromatic ring to these rings one hydrogen atom bonding directly to a carbon atom or a hetero atom constituting the ring, preferably is a group obtained by removing from a pyrrole ring, a diazole ring, a triazole ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a carbazole ring, an azacarbazole ring or a diazacarbazole ring one hydrogen atom bonding directly to a carbon atom or a hetero atom constituting the ring, more preferably a group obtained by removing from a pyridine ring, a diazabenzene ring, a triazine ring, an azanaphthalene ring, a diazanaphthalene ring, an azaanthracene ring, a diazaanthracene ring, an azaphenanthrene ring, a diazaphenanthrene ring, a dibenzofuran ring, a dibenzothiophene ring, a carbazole ring, an azacarbazole ring or a diazacarbazole ring at least one hydrogen atom bonding directly to a carbon atom or a hetero atom constituting the ring, further preferably a group obtained by removing from a pyridine ring, a diazabenzene ring, a triazine ring, a dibenzofuran ring, a dibenzothiophene ring or a carbazole ring at least one hydrogen atom bonding directly to a carbon atom or a hetero atom constituting the ring, particularly preferably a group obtained by removing from a dibenzofuran ring, a dibenzothiophene ring or a carbazole ring at least one hydrogen atom bonding directly to a carbon atom or a hetero atom constituting the ring, and these groups optionally have a substituent.

In the substituted amino group as the substituent which Ar^{T1} optionally has, the substituent which the amino group has is preferably an aryl group or a monovalent hetero ring group, more preferably an aryl group, and these groups optionally further have a substituent. The examples and the preferable range of the aryl group as the substituent which the amino group has are the same as the examples and the preferable range of the aryl group as the substituent which Ar^{T1} optionally has. The examples and the preferable range of the monovalent hetero ring group as the substituent which the amino group has are the same as the examples and the preferable range of the monovalent hetero ring group as the substituent which Ar^{T1} optionally has.

When a plurality of such substituents which Ar^{T1} optionally has are present, it is preferable that they are not combined together to form a ring together with atoms to which they are attached.

The substituent which the substituent which Ar^{T1} optionally has optionally further has is preferably an alkyl group, a cycloalkyl group, an alkoxy group, a cycloalkoxy group, an aryl group, an aryloxy group, a monovalent hetero ring group, a substituted amino group, a halogen atom or a cyano group, more preferably an alkyl group, a cycloalkyl group, an alkoxy group, a cycloalkoxy group, an aryl group, a monovalent hetero ring group or a substituted amino group, further preferably an alkyl group, a cycloalkyl group, an aryl group, a monovalent hetero ring group or a substituted amino group, particularly preferably an alkyl group or a cycloalkyl group, and these groups optionally further have a substituent.

The examples and the preferable range of the aryl group, the monovalent hetero ring group and the substituted amino group as the substituent which the substituent which Ar^{T1} optionally has optionally further has are the same as the examples and the preferable range of the aryl group, the monovalent hetero ring group and the substituted amino group as the substituent which Ar^{T1} optionally has, respectively.

Ar^{T1} is preferably a condensed-ring monovalent hetero ring group containing a nitrogen atom having no double bond as a ring constituent atom, more preferably a group represented by the formula (T1-1), and these groups optionally have a substituent.

### Group represented by the formula (T1-1)

The number of carbon atoms of the aromatic hydrocarbon ring represented by the ring R^{T1} and the ring R^{T2} is, not including the number of carbon atoms of the substituent, usually 6 to 60, preferably 6 to 30, more preferably 6 to 18.

The aromatic hydrocarbon ring represented by the ring R^{T1} and the ring R^{T2} includes, for example, a benzene ring, a naphthalene ring, an anthracene ring, a phenanthrene ring, a dihydrophenanthrene ring, a naphthacene ring, a fluorene ring, a spirobifluorene ring, an indene ring, a pyrene ring, a perylene ring, a chrysene ring and a ring obtained by condensing these rings, and is preferably a benzene ring, a naphthalene ring, an anthracene ring, a phenanthrene ring, a dihydrophenanthrene ring, a naphthacene ring, a fluorene ring, a spirobifluorene ring, an indene ring, a pyrene ring, a perylene ring or a chrysene ring, more preferably a benzene ring, a naphthalene ring, an anthracene ring, a phenanthrene ring, a dihydrophenanthrene ring, a fluorene ring or a spirobifluorene ring, further preferably a benzene ring, a naphthalene ring, a fluorene ring or a spirobifluorene ring, particularly preferably a benzene ring or a fluorene ring, and these rings optionally have a substituent.

The number of carbon atoms of the hetero ring not containing a nitrogen atom having a double bond as a ring constituent atom represented by the ring R^{T1} and the ring R^{T2} is, not including the number of carbon atoms of the substituent, usually 2 to 60, preferably 3 to 30, more preferably 4 to 15.

The hetero ring not containing a nitrogen atom having a double bond as a ring constituent atom represented by the ring R^{T1} and the ring R^{T2} includes, for example, a pyrrole ring, a furan ring, a thiophene ring, a silole ring, a phosphole ring, an indole ring, a benzofuran ring, a benzothiophene ring, a benzosilole ring, a benzophosphole ring, a carbazole ring, a dibenzofuran ring, a dibenzothiophene ring, a dibenzosilole ring, a dibenzophosphole ring, a phenoxazine ring, a phenothiazine ring, a 9,10-dihydroacridine ring, an acridone ring, a phenazine ring, a 5,10-dihydrophenazine ring, a ring obtained by condensing these rings and a ring obtained by condensing an aromatic hydrocarbon ring to these rings, and is preferably a pyrrole ring, a furan ring, a thiophene ring, a silole ring, a phosphole ring, an indole ring, a benzofuran ring, a benzothiophene ring, a benzosilole ring, a benzophosphole ring, a carbazole ring, a dibenzofuran ring, a dibenzothiophene ring, a dibenzosilole ring, a dibenzophosphole ring, a phenoxazine ring, a phenothiazine ring, a 9,10-dihydroacridine ring, an acridone ring, a phenazine ring or a 5, 10-dihydrophenazine ring, more preferably an indole ring, a benzofuran ring, a benzothiophene ring, a carbazole ring, a dibenzofuran ring, a dibenzothiophene ring, a phenoxazine ring, a phenothiazine ring, a 9,10-dihydroacridine ring or a 5,10-dihydrophenazine ring, further preferably a carbazole ring, a dibenzofuran ring, a dibenzothiophene ring, a phenoxazine ring, a phenothiazine ring, a 9,10-dihydroacridine ring or a 5,10-dihydrophenazine ring, particularly preferably a carbazole ring, a dibenzofuran ring or a dibenzothiophene ring, especially preferably a carbazole ring, and these rings optionally have a substituent.

The examples and the preferable range of the substituent which the ring R^{T1} and the ring R^{T2} optionally have are the same as the examples and the preferable range of the substituent which Ar^{T1} optionally has.

The examples and the preferable range of the substituent which the substituent which the ring R^{T1} and the ring R^{T2} optionally have optionally further has are the same as the examples and the preferable range of the substituent which the substituent which Ar^{T1} optionally has optionally further has.

At least one of the ring R^{T1} and the ring R^{T2} is preferably an aromatic hydrocarbon ring, more preferably a benzene ring, and these rings optionally have a substituent.

The ring R^{T1} and the ring R^{T2} are each preferably an aromatic hydrocarbon ring, more preferably a benzene ring or a fluorene ring, and these rings optionally have a substituent.

X^{T1} is preferably a single bond, an oxygen atom, a sulfur atom or a group represented by -C(R^{XT1'})₂-, more preferably a single bond, an oxygen atom or a sulfur atom, further preferably a single bond.

R^{XT1} is preferably an alkyl group, a cycloalkyl group, an aryl group, a monovalent hetero ring group or a substituted amino group, more preferably an aryl group or a monovalent hetero ring group, further preferably an aryl group, and these groups optionally have a substituent.

R^{XT1'} is preferably an alkyl group, a cycloalkyl group, an aryl group or a monovalent hetero ring group, more preferably an alkyl group, a cycloalkyl group or an aryl group, further preferably an alkyl group or a cycloalkyl group, and these groups optionally have a substituent.

A plurality of R^{XT1'} may be the same or different and may be combined together to form a ring together with carbon atoms to which they are attached, however, it is preferable that they do not form a ring.

The examples and the preferable range of the aryl group, the monovalent hetero ring group and the substituted amino group represented by R^{XT1'} and R^{XT1'} are the same as the examples and the preferable range of the aryl group, the monovalent hetero ring group and the substituted amino group as the substituent which Ar^{T1} optionally has, respectively.

The examples and the preferable range of the substituent which R^{XT1} and R^{XT1'} optionally have are the same as the examples and the preferable range of the substituent which the substituent which Ar^{T1} optionally has optionally further has.

R^{XT1} and a substituent which the ring R^{T1} optionally has, R^{XT1} and a substituent which the ring R^{T2} optionally has, R^{XT1'} and a substituent which the ring R^{T1} optionally has, and R^{XT1'} and a substituent which the ring R^{T2} optionally has are each preferably not combined together to form a ring together with atoms to which they are attached.

The group represented by the formula (T1-1) is preferably a group represented by the formula (T1-1A), a group represented by the formula (T1-1B), a group represented by the formula (T1-1C) or a group represented by the formula (T1-1D), more preferably a group represented by the formula (T1-1A), a group represented by the formula (T1-1B) or a group represented by the formula (T1-1C), further preferably a group represented by the formula (T1-1B).

X^{T2} and X^{T3} are each preferably a single bond, a group represented by -N (R^{XT2})- or a group represented by -C (R^{XT2'})₂-, more preferably a single bond or a group represented by -C(R^{XT2'})₂-

It is preferable that at least one of X^{T2} and X^{T3} is a single bond, it is more preferable that X^{T3} is a single bond.

When at least one of X^{T2} and X^{T3} is a single bond, the other is preferably an oxygen atom, a sulfur atom, a group represented by -N(R^{XT2})- or a group represented by -C(R^{XT2'})₂ -, more preferably a group represented by -N(RXT2)- or a group represented by -C(R^{XT2'})₂-, further preferably a group represented by -C(R^{XT2'})₂-.

The examples and the preferable range of R^{XT2} are the same as the examples and the preferable range of R^{XT1}.

The examples and the preferable range of R^{XT2'} are the same as the examples and the preferable range of R^{XT1'}.

The examples and the preferable range of the substituent which R^{XT2} and R^{XT2'} optionally have are the same as the examples and the preferable range of the substituent which R^{XT1'} and R^{XT1'} optionally have.

R^{T1}, R^{T2}, R^{T3}, R^{T4}, R^{T5}, R^{T6}, R^{T7}, R^{T8}, R^{T9}, R^{T10}, R^{T11} and R^{T12} are each preferably a hydrogen atom, an alkyl group, a cycloalkyl group, an alkoxy group, a cycloalkoxy group, an aryl group, a monovalent hetero ring group, a substituted amino group or a cyano group, more preferably a hydrogen atom, an alkyl group, a cycloalkyl group, an aryl group, a monovalent hetero ring group or a substituted amino group, and these groups optionally further have a substituent.

In the group represented by the formula (T1-1A), R^{T1}, R^{T2}, R^{T4}, R^{T5}, R^{T7} and R^{T8} are each preferably a hydrogen atom, an alkyl group, an aryl group, a monovalent hetero ring group or a substituted amino group, more preferably a hydrogen atom or an alkyl group, further preferably a hydrogen atom, and these groups optionally further have a substituent.

In the group represented by the formula (T1-1A), R^{T3} and R^{T6} are each preferably an alkyl group, an aryl group, a monovalent hetero ring group or a substituted amino group, more preferably an aryl group, a monovalent hetero ring group or a substituted amino group, further preferably a substituted amino group, and these groups optionally further have a substituent.

In the groups represented by the formula (T1-1B), the formula (T1-1C) and the formula (T1-1D), R^{T1}, R^{T2}, R^{T3}, R^{T4}, R^{T5}, R^{T6}, R^{T7}, R^{T8}, R^{T9}, R^{T10}, R^{T11} and R^{T12} are each preferably a hydrogen atom, an alkyl group, an aryl group, a monovalent hetero ring group or a substituted amino group, more preferably a hydrogen atom or an alkyl group, further preferably a hydrogen atom, and these groups optionally further have a substituent.

The examples and the preferable range of the aryl group, the monovalent hetero ring group and the substituted amino group represented by R^{T1}, R^{T2}, R^{T3}, R^{T4}, R^{T5}, R^{T6}, R^{T7}, R^{T8}, R^{T9}, R^{T10}, R^{T11} and R^{T12} are the same as the examples and the preferable range of the aryl group, the monovalent hetero ring group and the substituted amino group as the substituent which Ar^{T1} optionally has, respectively.

The examples and the preferable range of the substituent which R^{T1}, R^{T2}, R^{T3}, R^{T4}, R^{T5}, R^{T6}, R^{T7}, R^{T8}, R^{T9}, R^{T10}, R^{T11} and R^{T12} optionally have are the same as the examples and the preferable range of the substituent which the substituent which Ar^{T1} optionally has optionally further has.

R^{T1} and R^{T2}, R^{T2} and R^{T3}, R^{T3} and R^{T4}, R^{T5} and R^{T6}, R^{T6} and R^{T7}, R^{T7} and R^{T8}, R^{T9} and R^{T10}, R^{T10} and R^{T11}, and R^{T11} and R^{T12} each may be combined together to form a ring together with carbon atoms to which they are attached, however, it is preferable that they do not form a ring.

L^{T1} represents an alkylene group, a cycloalkylene group, an arylene group, a divalent hetero ring group, a group represented by -N(R^{T1}')-, an oxygen atom or a sulfur atom, and these groups optionally have a substituent.

L^{T1} is preferably an alkylene group, a cycloalkylene group, an arylene group or a divalent hetero ring group, more preferably an arylene group or a divalent hetero ring group, further preferably an arylene group, and these groups optionally have a substituent.

The arylene group represented by L^{T1} is preferably a phenylene group, a naphthalenediyl group, a fluorenediyl group, a phenanthrenedilyl group or a dihydrophenanthrenedilyl group, more preferably a group represented by the formula (A-1) to the formula (A-9), the formula (A-19) or the formula (A-20), further preferably a group represented by the formula (A-1) to the formula (A-3), particularly preferably a group represented by the formula (A-1) or the formula (A-2), especially preferably a group represented by the formula (A-1), and these groups optionally have a substituent.

The divalent hetero ring group represented by L^{T1} is preferably a group represented by the formula (AA-1) to the formula (AA-34), more preferably a group represented by the formula (AA-1) to the formula (AA-6), the formula (AA-10) to the formula (AA-21) or the formula (AA-24) to the formula (AA-34), further preferably a group represented by the formula (AA-1) to the formula (AA-4), the formula (AA-10) to the formula (AA-15) or the formula (AA-29) to the formula (AA-34), particularly preferably a group represented by the formula (AA-2), the formula (AA-4), the formula (AA-10), the formula (AA-12) or the formula (AA-14).

The examples and the preferable range of the substituent which L^{T1} optionally has are the same as the examples and the preferable range of the substituent which Ar^{T1} optionally has.

The examples and the preferable range of the substituent which the substituent which L^{T1} optionally has optionally further has are the same as the examples and the preferable range of the substituent which the substituent which Ar^{T1} optionally has optionally further has.

R^{T1}' is preferably an aryl group or a monovalent hetero ring group, more preferably an aryl group, and these groups optionally have a substituent.

The examples and the preferable range of the aryl group and the monovalent hetero ring group represented by R^{T1}' are the same as the examples and the preferable range of the aryl group and the monovalent hetero ring group as the substituent which Ar^{T1} optionally has, respectively.

The examples and the preferable range of the substituent which R^{T1}' optionally has are the same as the examples and the preferable range of the substituent which the substituent which Ar^{T1} optionally has optionally further has.

Ar^{T2} is a single-ring or condensed-ring hetero ring group containing a nitrogen atom having a double bond as a ring constituent atom. This hetero ring group optionally has a substituent.

In the single-ring or condensed-ring hetero ring group containing a nitrogen atom having a double bond as a ring constituent atom, the number of the nitrogen atom having a double bond constituting the ring is usually 1 to 10, preferably 1 to 7, more preferably 1 to 5, further preferably 1 to 3, particularly preferably 3.

In the single-ring or condensed-ring hetero ring group containing a nitrogen atom having a double bond as a ring constituent atom, the number of carbon atoms constituting the ring is usually 1 to 60, preferably 2 to 30, more preferably 3 to 10, particularly preferably 3 to 5.

The single-ring or condensed-ring hetero ring group containing a nitrogen atom having a double bond as a ring constituent atom includes groups obtained by removing from a diazole ring, a triazole ring, an oxadiazole ring, a thiadiazole ring, a thiazole ring, an oxazole ring, an isothiazole ring, an isooxazole ring, a benzodiazole ring, a benzotriazole ring, a benzooxadiazole ring, a benzothiadiazole ring, a benzothiazole ring, a benzooxazole ring, an azacarbazole ring, a diazacarbazole ring, a pyridine ring, a diazabenzene ring, a triazine ring, an azanaphthalene ring, a diazanaphthalene ring, a triazanaphthalene ring, a tetraazanaphthalene ring, an azaanthracene ring, a diazaanthracene ring, a triazaanthracene ring, a tetraazaanthracene ring, an azaphenanthrene ring, a diazaphenanthrene ring, a triazaphenanthrene ring, a tetraazaphenanthrene ring or rings obtained by condensing an aromatic ring to these hetero rings at least one hydrogen atom bonding directly to a carbon atom or a hetero atom constituting the ring, and is preferably a group obtained by removing from a diazole ring, a triazole ring, an oxadiazole ring, a thiadiazole ring, a thiazole ring, an oxazole ring, an isothiazole ring, an isooxazole ring, a benzodiazole ring, a benzotriazole ring, a benzooxadiazole ring, a benzothiadiazole ring, a benzothiazole ring, a benzooxazole ring, an azacarbazole ring, a diazacarbazole ring, a pyridine ring, a diazabenzene ring, a triazine ring, an azanaphthalene ring, a diazanaphthalene ring, a triazanaphthalene ring, a tetraazanaphthalene ring, an azaanthracene ring, a diazaanthracene ring, a triazaanthracene ring, a tetraazaanthracene ring, an azaphenanthrene ring, a diazaphenanthrene ring, a triazaphenanthrene ring or a tetraazaphenanthrene ring at least one hydrogen atom bonding directly to a carbon atom or a hetero atom constituting the ring, more preferably a group obtained by removing from a triazole ring, an oxadiazole ring, a thiadiazole ring, an azacarbazole ring, a diazacarbazole ring, a pyridine ring, a diazabenzene ring, a triazine ring, an azanaphthalene ring, a diazanaphthalene ring, a triazanaphthalene ring, a tetraazanaphthalene ring, an azaanthracene ring, a diazaanthracene ring, a triazaanthracene ring, a tetraazaanthracene ring, an azaphenanthrene ring, a diazaphenanthrene ring, a triazaphenanthrene ring or a tetraazaphenanthrene ring at least one hydrogen atom bonding directly to a carbon atom or a hetero atom constituting the ring, further preferably a group obtained by removing from a triazole ring, an oxadiazole ring, a thiadiazole ring, a pyridine ring, a diazabenzene ring, a triazine ring, an azanaphthalene ring, a diazanaphthalene ring, an azaanthracene ring, a diazaanthracene ring, an azaphenanthrene ring or a diazaphenanthrene ring at least one hydrogen atom bonding directly to a carbon atom or a hetero atom constituting the ring, particularly preferably a group obtained by removing from a pyridine ring, a diazabenzene ring or a triazine ring at least one hydrogen atom bonding directly to a carbon atom constituting the ring, especially preferably a group obtained by removing from a triazine ring at least one hydrogen atom bonding directly to a carbon atom constituting the ring, and these groups optionally have a substituent.

The substituent which Ar^{T2} optionally has (different from a group represented by the formula (1T') described later, the same shall apply hereinafter) is preferably a monovalent hetero ring group other than a single-ring or condensed-ring monovalent hetero ring group containing a nitrogen atom having no double bond as a ring constituent atom and not containing a nitrogen atom having a double bond as a ring constituent atom (hereinafter, referred to also as "monovalent hetero ring group other than a donor type hetero ring group"), an alkyl group, a cycloalkyl group, an alkoxy group, a cycloalkoxy group, an aryl group, an aryloxy group, a substituted amino group, a halogen atom or a cyano group, more preferably an alkyl group, a cycloalkyl group, an alkoxy group, a cycloalkoxy group, an aryl group, a monovalent hetero ring group other than a donor type hetero ring group, a substituted amino group or a cyano group, further preferably an alkyl group, a cycloalkyl group, an aryl group, a monovalent hetero ring group other than a donor type hetero ring group or a substituted amino group, particularly preferably an alkyl group or an aryl group, especially preferably an aryl group, and these groups optionally further have a substituent.

The examples and the preferable range of the aryl group as the substituent which Ar^{T2} optionally has are the same as the examples and the preferable range of the aryl group as the substituent which Ar^{T1} optionally has.

In the monovalent hetero ring group other than a donor type hetero ring group as the substituent which Ar^{T2} optionally has, the number of carbon atoms constituting the ring is, not including the number of carbon atoms of the substituent, usually 2 to 60, preferably 3 to 20.

The monovalent hetero ring group other than a donor type hetero ring group as the substituent which Ar^{T2} optionally has includes, for example, groups obtained by removing from a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, an azacarbazole ring, a diazacarbazole ring, a ring obtained by condensing these hetero rings and a ring obtained by condensing an aromatic hydrocarbon ring to these hetero rings one hydrogen atom bonding directly to a carbon atom or a hetero atom constituting the ring, and is preferably a group obtained by removing from a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, an azacarbazole ring or a diazacarbazole ring one hydrogen atom bonding directly to a carbon atom or a hetero atom constituting the ring, more preferably a group obtained by removing from a pyridine ring, a diazabenzene ring, a triazine ring, an azanaphthalene ring, a diazanaphthalene ring, an azaanthracene ring, a diazaanthracene ring, an azaphenanthrene ring, a diazaphenanthrene ring, a dibenzofuran ring, a dibenzothiophene ring, an azacarbazole ring or a diazacarbazole ring at least one hydrogen atom bonding directly to a carbon atom or a hetero atom constituting the ring, further preferably a group obtained by removing from a pyridine ring, a diazabenzene ring, a triazine ring, a dibenzofuran ring or a dibenzothiophene ring one hydrogen atom bonding directly to a carbon atom constituting the ring, particularly preferably a group obtained by removing from a dibenzofuran ring or a dibenzothiophene ring one hydrogen atom bonding directly to a carbon atom constituting the ring, and these groups optionally have a substituent.

In the substituted amino group as the substituent which Ar^{T2} optionally has, the substituent which the amino group has is preferably an aryl group or a monovalent hetero ring group other than a donor type hetero ring group, more preferably an aryl group, and these groups optionally further have a substituent. The examples and the preferable range of the aryl group as the substituent which the amino group has are the same as the examples and the preferable range of the aryl group as the substituent which Ar^{T1} optionally has. The examples and the preferable range of the monovalent hetero ring group other than a donor type hetero ring group as the substituent which the amino group has are the same as the examples and the preferable range of the monovalent hetero ring group other than a donor type hetero ring group as the substituent which Ar^{T2} optionally has.

The substituent which the substituent which Ar^{T2} optionally has optionally further has is preferably an alkyl group, a cycloalkyl group, an alkoxy group, a cycloalkoxy group, an aryl group, an aryloxy group, a monovalent hetero ring group other than a donor type hetero ring group, a substituted amino group, a halogen atom or a cyano group, more preferably an alkyl group, a cycloalkyl group, an alkoxy group, a cycloalkoxy group, an aryl group, a monovalent hetero ring group other than a donor type hetero ring group or a substituted amino group, further preferably an alkyl group, a cycloalkyl group, an aryl group, a monovalent hetero ring group other than a donor type hetero ring group or a substituted amino group, particularly preferably an alkyl group or an aryl group, and these groups optionally further have a substituent.

The compound represented by the formula (T) is preferably a compound represented by the formula (T'-1) to the formula (T'-14) more preferably a compound represented by the formula (T'-1) to the formula (T'-11), further preferably a compound represented by the formula (T'-1) to the formula (T'-8), particularly preferably a compound represented by the formula (T'-1) to the formula (T'-4), especially preferably a compound represented by the formula (T'-4), since the light emitting device of the present invention is excellent in light emission efficiency. 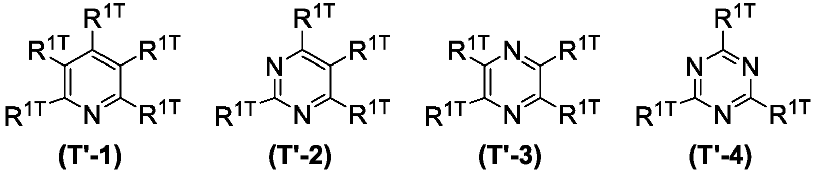 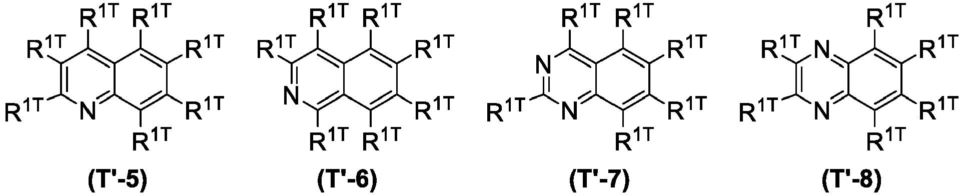 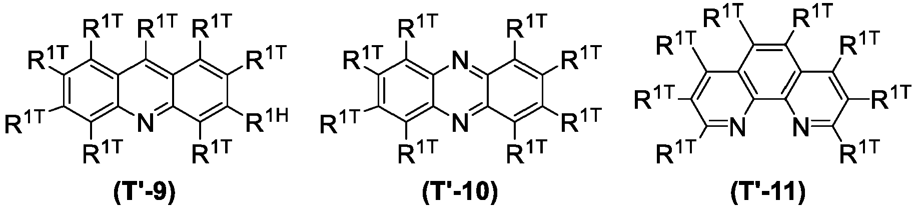 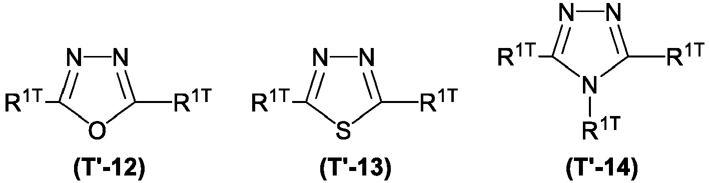 [wherein, R^{1T} represents a hydrogen atom, an alkyl group, a cycloalkyl group, an alkoxy group, a cycloalkoxy group, an aryl group, an aryloxy group, a monovalent hetero ring group other than a donor type hetero ring group, a substituted amino group, a halogen atom, a cyano group or a group represented by the formula (1T'), and these groups optionally have a substituent. A plurality of R^{1T} may be the same or different. However, at least one of a plurality of R^{1T} is a group represented by the formula (1T').]

It is preferable that one or two groups R^{1T} of a plurality of R^{1T} are each a group represented by the formula (1T'). 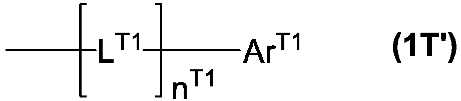 [wherein, L^{T1}, n^{T1} and Ar^{T1} represent the same meaning as described above.]

R^{1T} is preferably a hydrogen atom, an alkyl group, a cycloalkyl group, an alkoxy group, a cycloalkoxy group, an aryl group, a monovalent hetero ring group other than a donor type hetero ring group, a substituted amino group, a cyano group or a group represented by the formula (1T'), more preferably a hydrogen atom, an alkyl group, a cycloalkyl group, an aryl group, a monovalent hetero ring group other than a donor type hetero ring group, a substituted amino group or a group represented by the formula (1T'), further preferably a hydrogen atom, an alkyl group, an aryl group or a group represented by the formula (1T'), particularly preferably a hydrogen atom, an aryl group or a group represented by the formula (1T'), and these groups optionally have a substituent.

The examples and the preferable range of the aryl group, the monovalent hetero ring group other than a donor type hetero ring group and the substituted amino group represented by R^{1T} are the same as the examples and the preferable range of the aryl group, the monovalent hetero ring group other than a donor type hetero ring group and the substituted amino group as the substituent which Ar^{T2} optionally has, respectively.

The examples and the preferable range of the substituent which R^{1T} optionally has are the same as the examples and the preferable range of the substituent which the substituent which Ar^{T2} optionally has optionally further has.

The compound represented by the formula (T'-1) to the formula (T'-14) includes, for example, compounds represented by the formula (T"-1) to the formula (T"-25), and is preferably a compound represented by the formula (T"-1) to the formula (T"-22), more preferably a compound represented by the formula (T"-1) to the formula (T"-18), further preferably a compound represented by the formula (T"-1) to the formula (T" -8), particularly preferably a compound represented by the formula (T"-8). 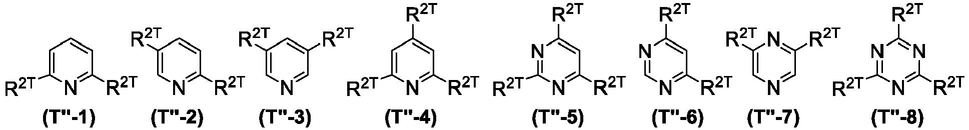 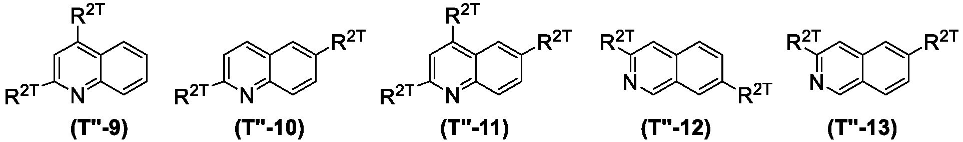 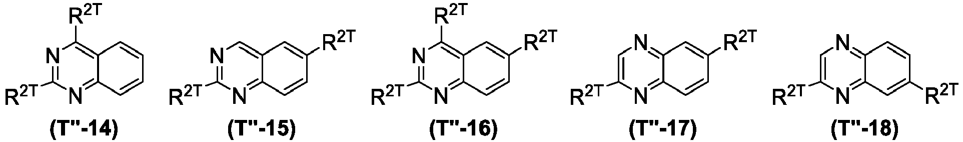 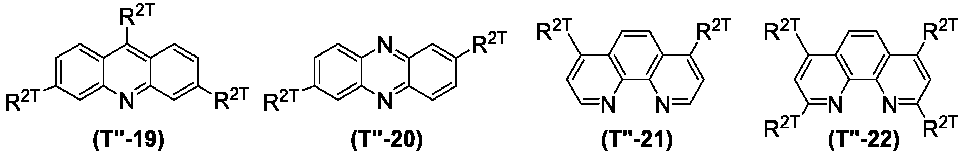 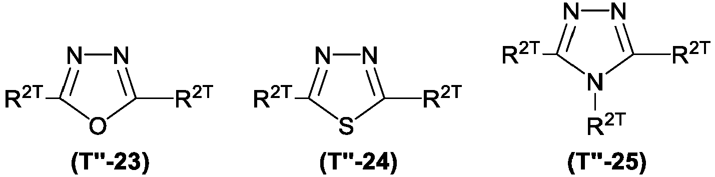 [wherein, R^{2T} represents an alkyl group, a cycloalkyl group, an aryl group, a monovalent hetero ring group other than a donor type hetero ring group, a substituted amino group or a group represented by the formula (1T'), and these groups optionally have a substituent. A plurality of R^{2T} may be the same or different. However, at least one of a plurality of R^{2T} is a group represented by the formula (1T').]

It is preferable that one or two groups R^{2T} of a plurality of R^{2T} are each a group represented by the formula (1T').

R^{2T} is preferably an alkyl group, an aryl group or a group represented by the formula (1T'), more preferably an aryl group or a group represented by the formula (1T'), and these groups optionally further have a substituent.

The examples and the preferable range of the aryl group, the monovalent hetero ring group and the substituted amino group represented by R^{2T} are the same as the examples and the preferable range of the aryl group, the monovalent hetero ring group and the substituted amino group as the substituent which Ar^{T2} optionally has, respectively.

The examples and the preferable range of the substituent which R^{2T} optionally has are the same as the examples and the preferable range of the substituent which the substituent which Ar^{T2} optionally has optionally further has.

The compound represented by the formula (T) includes, for example, compounds represented by the following formulae. In the formulae, Z¹ represents a group represented by -N= or a group represented by -CH=. Z² represents an oxygen atom or a sulfur atom. A plurality of Z¹ and Z² may be the same or different at each occurrence.

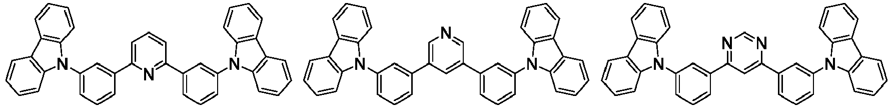

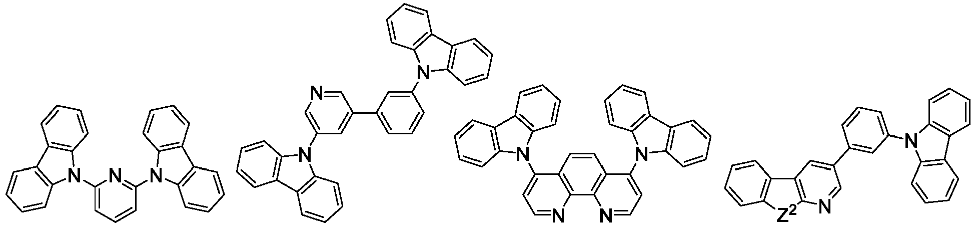

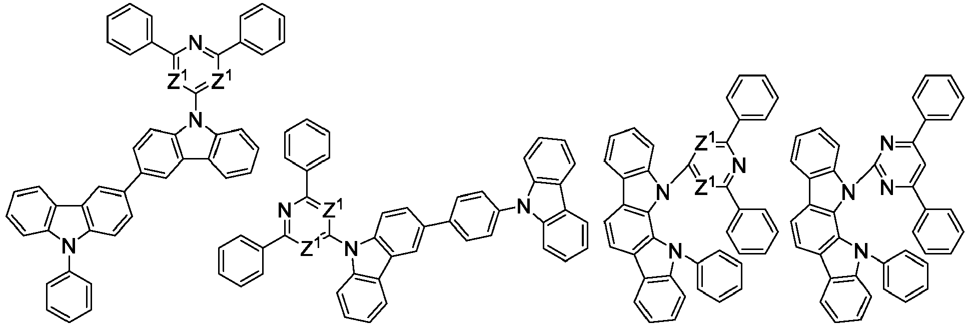

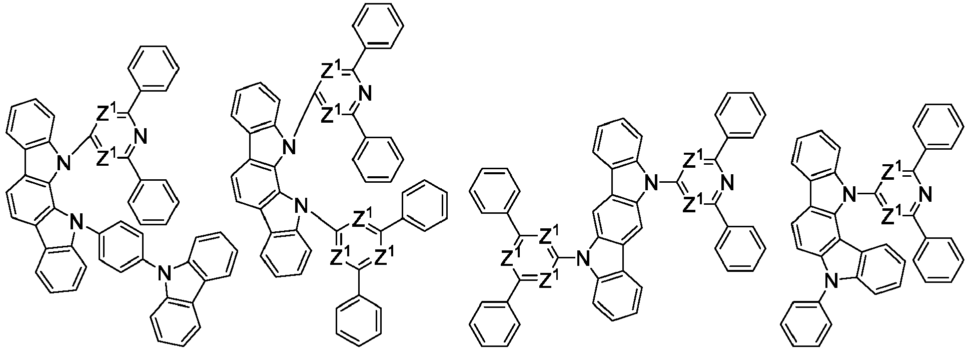

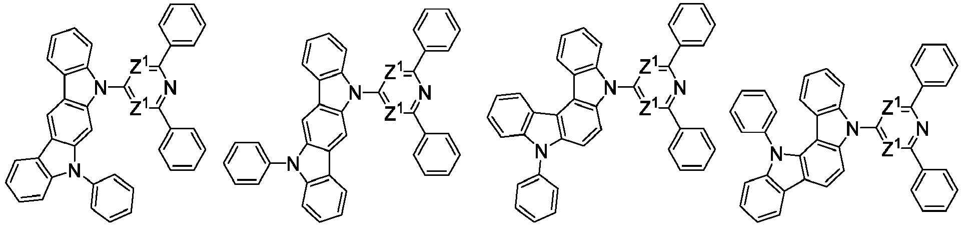

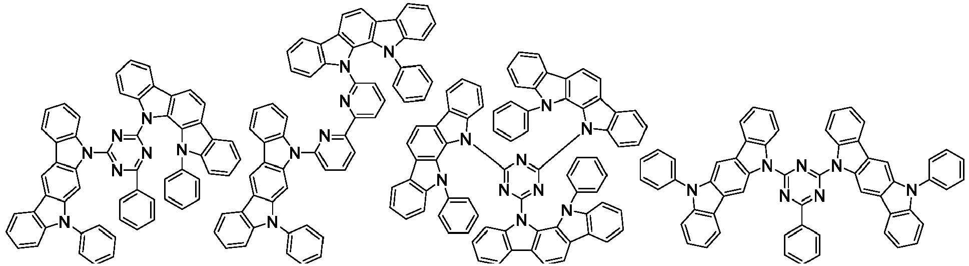

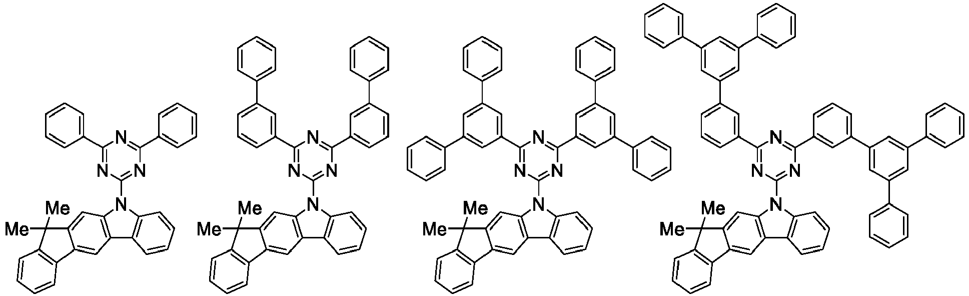

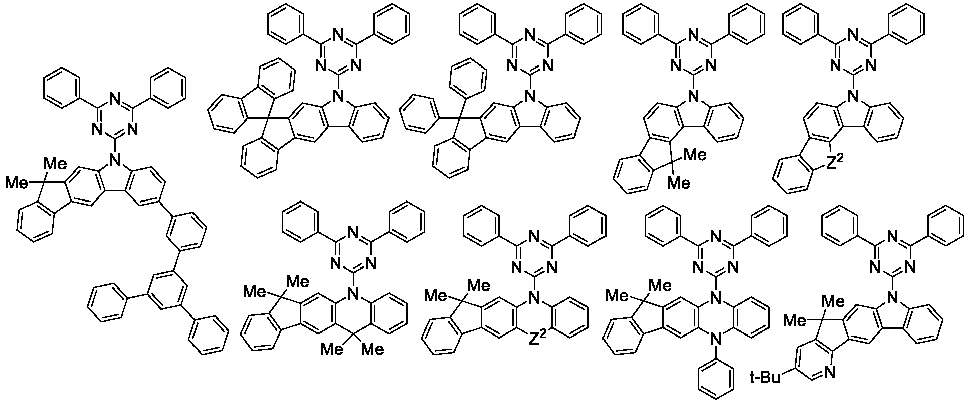

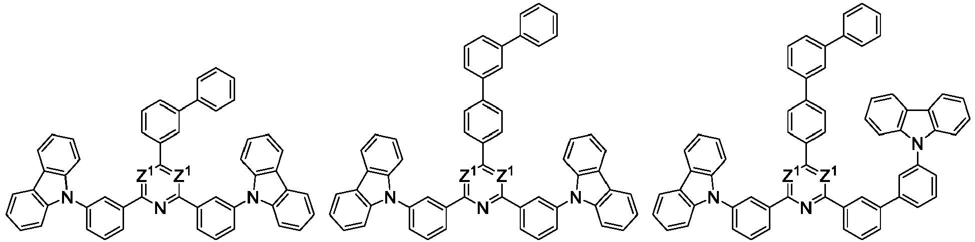

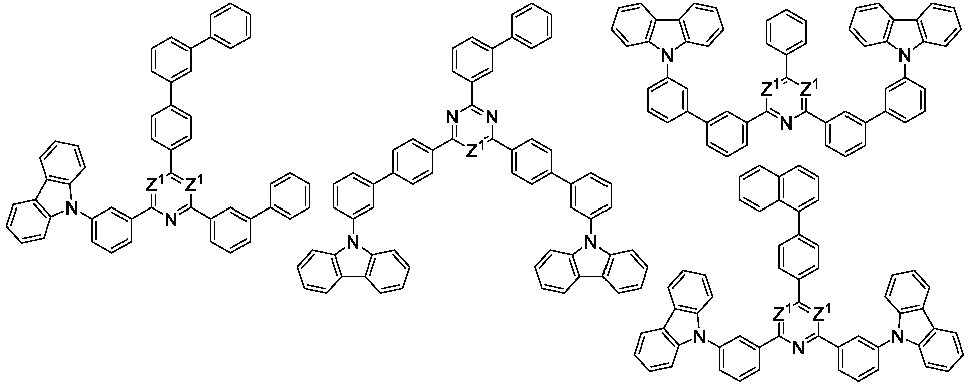

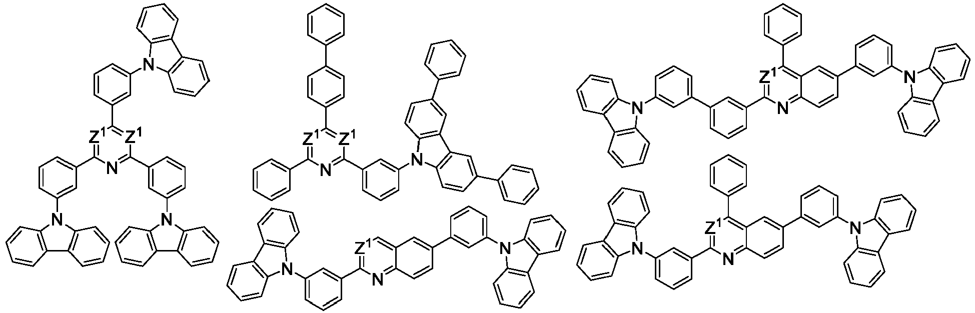

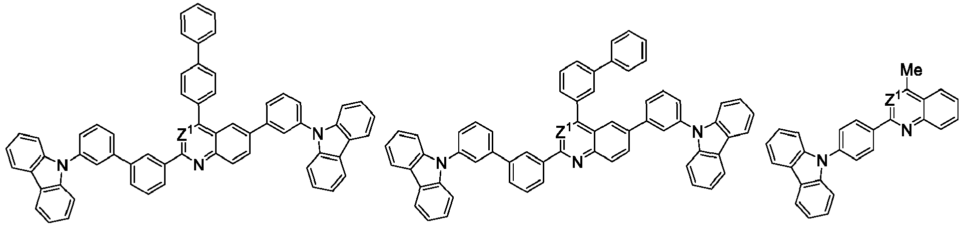

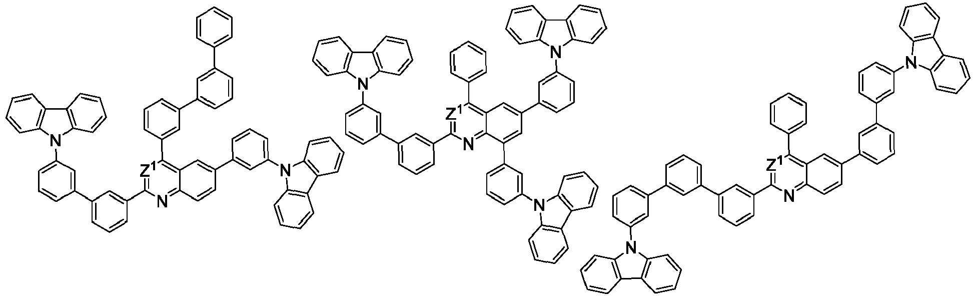

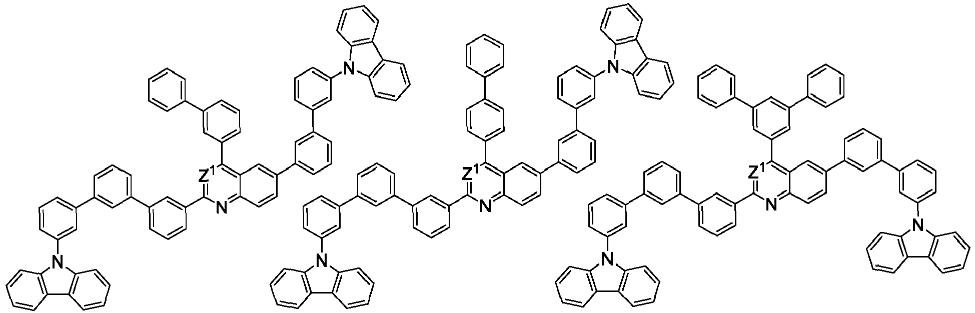

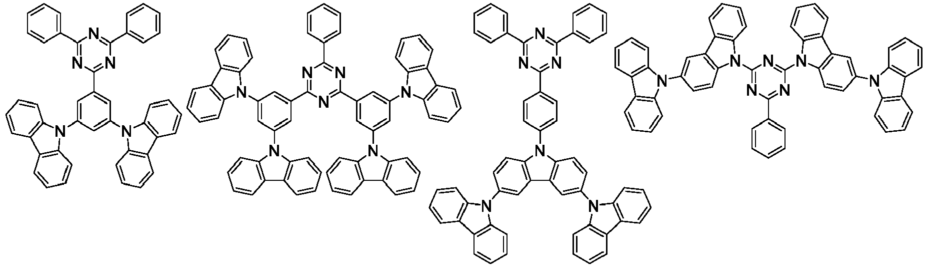

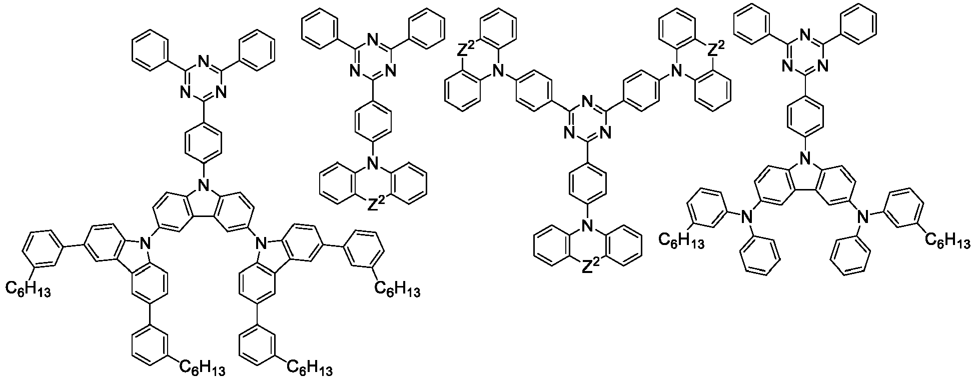

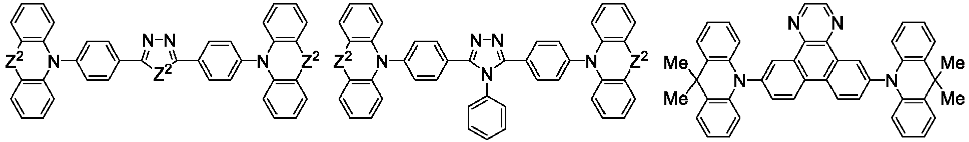

Z¹ represents preferably a group represented by -N=. Z² is preferably an oxygen atom.

The compound represented by the formula (T) is available from Aldrich, Luminescence Technology Corp. and the like. Additionally, the compound represented by the formula (T) can be synthesized according to methods described in, for example, International Publication WO2007/063754, International Publication WO2008/056746, International Publication WO2011/032686, International Publication WO2012/096263, JP-A No. 2009-227663, JP-ANo. 2010-275255, Advanced Materials (Adv. Mater), vol. 26, pp. 7931-7958, 2014.

### [Fluorescent compound represented by the formula (B)]

ΔE_{ST} of the fluorescent compound represented by the formula (B) is 0.55 eV or more, preferably 0.60 eV or more, further preferably 0.65 eV or more, particularly preferably 0.70 eV or more, especially preferably 0.75 eV or more. ΔE_{ST} of the fluorescent compound represented by the formula (B) is 2.5 eV or less, preferably 2.0 eV or less, further preferably 1.5 eV or less, particularly preferably 1.0 eV or less. ΔE_{ST} of the fluorescent compound represented by the formula (B) is 0.55 eV or more and 2.5 eV or less, preferably 0.60 eV or more and 2.0 eV or less, further preferably 0.65 eV or more and 1.5 eV or less, particularly preferably 0.70 eV or more and 1.0 eV or less, especially preferably 0.75 eV or more and 1.0 eV or less, since the light emitting device of the present invention is excellent in light emission efficiency.

The oscillator strength of the fluorescent compound represented by the formula (B) is preferably 0.001 or more, more preferably 0.01 or more, further preferably 0.1 or more. The oscillator strength of the fluorescent compound represented by the formula (B) is preferably 1 or less, more preferably 0.6 or less, further preferably 0.3 or less. The oscillator strength of the fluorescent compound represented by the formula (B) is preferably 0.001 or more and 1 or less, more preferably 0.01 or more and 0.6 or less, further preferably 0.1 or more and 0.3 or less, since the light emitting device of the present invention is excellent in light emission efficiency.

n^{1B} is preferably an integer of 1 to 8, more preferably an integer of 1 to 6, further preferably an integer of 1 to 4, particularly preferably 2.

The number of carbon atoms of the condensed-ring aromatic hydrocarbon group represented by Ar^{1B} is, not including the number of carbon atoms of the substituent, usually 7 to 60, preferably 8 to 40, more preferably 9 to 30, further preferably 10 to 20.

The condensed-ring aromatic hydrocarbon group represented by Ar^{1B} includes, for example, groups obtained by removing from a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring at least one hydrogen atom bonding directly to a carbon atom constituting the ring, and since the light emitting device of the present invention is excellent in light emission efficiency, it is preferably a group obtained by removing from a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, a fluoranthene ring, a benzofluoranthene ring or an acenaphthofluoranthene ring at least one hydrogen atom bonding directly to a carbon atom constituting the ring, more preferably a group obtained by removing from a naphthalene ring, an anthracene ring, a phenanthrene ring, a triphenylene ring, a naphthacene ring, a pyrene ring, a perylene ring or a chrysene ring at least one hydrogen atom bonding directly to a carbon atom constituting the ring, further preferably a group obtained by removing from an anthracene ring, a naphthacene ring, a pyrene ring or a perylene ring at least one hydrogen atom bonding directly to a carbon atom constituting the ring, particularly preferably a group obtained by removing from an anthracene ring at least one hydrogen atom bonding directly to a carbon atom constituting the ring, and these groups optionally have a substituent.

The substituent which Ar^{1B} optionally has is preferably a halogen atom, a cyano group, an aryloxy group or an amino group, more preferably a fluorine atom or a cyano group, and these groups optionally further have a substituent.

The examples and the preferable range of the substituent which the substituent which Ar^{1B} optionally has optionally further has are the same as the examples and the preferable range of the substituent which R^{1B} optionally has described later.

R^{1B} is preferably an alkyl group, a cycloalkyl group, an alkoxy group, a cycloalkoxy group, an aryl group, a monovalent hetero ring group, a substituted amino group, an alkenyl group or cycloalkenyl group, more preferably an alkyl group, a cycloalkyl group, an aryl group, a monovalent hetero ring group or a substituted amino group, further preferably an alkyl group, an aryl group or a substituted amino group, particularly preferably an aryl group or a substituted amino group, especially preferably a substituted amino group, and these groups optionally have a substituent, since the light emitting device of the present invention is excellent in light emission efficiency.

The number of carbon atoms of the aryl group represented by R^{1B} is, not including the number of carbon atoms of the substituent, usually 6 to 60, preferably 6 to 40, more preferably 6 to 30, further preferably 6 to 14.

The aryl group represented by R^{1B} includes, for example, groups obtained by removing from a benzene ring, a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring one hydrogen atom bonding directly to a carbon atom constituting the ring, and preferably is a group obtained by removing from a benzene ring, a naphthalene ring, an anthracene ring, a phenanthrene ring, a dihydrophenanthrene ring, a fluorene ring, a spirobifluorene ring, a pyrene ring, a fluoranthene ring or benzofluoranthene ring one hydrogen atom bonding directly to a carbon atom constituting the ring, more preferably a group obtained by removing from a benzene ring, a naphthalene ring, an anthracene ring, a phenanthrene ring, a fluorene ring, a spirobifluorene ring or a pyrene ring one hydrogen atom bonding directly to a carbon atom constituting the ring, further preferably a group obtained by removing from a benzene ring, a naphthalene ring or an anthracene ring one hydrogen atom bonding directly to a carbon atom constituting the ring, particularly preferably a phenyl group, and these groups optionally further have a substituent.

The number of carbon atoms of the monovalent hetero ring group represented by R^{1B} is, not including the number of carbon atoms of the substituent, usually 2 to 60, preferably 3 to 30, more preferably 3 to 20.

The monovalent hetero ring group represented by R^{1B} includes, for example, groups obtained by removing from a pyrrole ring, a diazole ring, a triazole ring, a pyridine ring, a diazabenzene ring, a triazine ring, an azanaphthalene ring, a diazanaphthalene ring, a triazanaphthalene ring, an indole ring, a carbazole ring, an azacarbazole ring, a diazacarbazole ring, a dibenzofuran ring, a dibenzothiophene ring, a phenoxazine ring, a phenothiazine ring, acridine ring, a 9,10-dihydroacridine ring, an acridone ring, a phenazine ring and a 5,10-dihydrophenazine ring one hydrogen atom bonding directly to a carbon atom or a hetero atom constituting the ring, and preferably is a group obtained by removing from a pyridine ring, a diazabenzene ring, a triazine ring, an azanaphthalene ring, a diazanaphthalene ring, a carbazole ring, an azacarbazole ring, a diazacarbazole ring, a dibenzofuran ring, a dibenzothiophene ring, a phenoxazine ring, a phenothiazine ring, a 9,10-dihydroacridine ring or a 5,10-dihydrophenazine ring one hydrogen atom bonding directly to a carbon atom or a hetero atom constituting the ring, more preferably a group obtained by removing from a pyridine ring, a diazabenzene ring, a triazine ring, an azanaphthalene ring, a diazanaphthalene ring, a carbazole ring, a dibenzofuran ring or a dibenzothiophene ring one hydrogen atom bonding directly to a carbon atom or a hetero atom constituting the ring, further preferably a group obtained by removing from a dibenzofuran ring or a dibenzothiophene ring one hydrogen atom bonding directly to a carbon atom constituting the ring, and these groups optionally further have a substituent.

In the substituted amino group represented by R^{1B}, the substituent which the amino group has is preferably an aryl group or a monovalent hetero ring group, more preferably an aryl group, and these groups optionally further have a substituent. The examples and the preferable range of the aryl group as the substituent which the amino group has are the same as the examples and the preferable range of the aryl group represented by R^{1B}. The examples and the preferable range of the monovalent hetero ring group as the substituent which the amino group has are the same as the examples and the preferable range of the monovalent hetero ring group represented by R^{1B}.

The substituent which R^{1B} optionally has is preferably an alkyl group, a cycloalkyl group, an alkoxy group, a cycloalkoxy group, an aryl group, a monovalent hetero ring group, a substituted amino group or a halogen atom, more preferably an alkyl group, a cycloalkyl group, an aryl group, a monovalent hetero ring group or a substituted amino group, further preferably an alkyl group, a cycloalkyl group or an aryl group, particularly preferably an alkyl group or a cycloalkyl group, and these groups optionally further have a substituent.

The examples and the preferable range of the aryl group, the monovalent hetero ring group and the substituted amino group as the substituent which R^{1B} optionally has are the same as the examples and the preferable range of the aryl group, the monovalent hetero ring group and the substituted amino group represented by R^{1B}, respectively.

The substituent which the substituent which R^{1B} optionally has optionally further has is preferably an alkyl group, a cycloalkyl group, an alkoxy group, a cycloalkoxy group, an aryl group, a monovalent hetero ring group, a substituted amino group or a halogen atom, more preferably an alkyl group, a cycloalkyl group, an aryl group or a monovalent hetero ring group, further preferably an alkyl group or a cycloalkyl group, and these groups optionally further have a substituent.

The examples and the preferable range of the aryl group, the monovalent hetero ring group and the substituted amino group as the substituent which the substituent which R^{1B} optionally has optionally further has are the same as the examples and the preferable range of the aryl group, the monovalent hetero ring group and the substituted amino group represented by R^{1B}, respectively.

When a plurality of R^{1B} are present, it is preferable that they are not combined together to form a ring together with atoms to which they are attached.

The fluorescent compound represented by the formula (B) includes, for example, compounds represented by the following formulae.

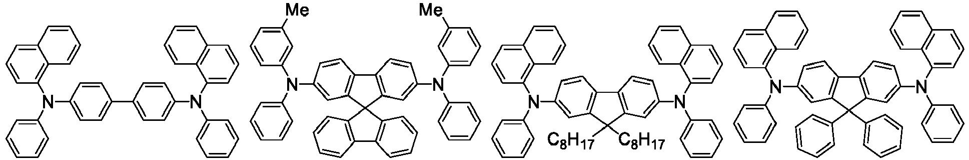

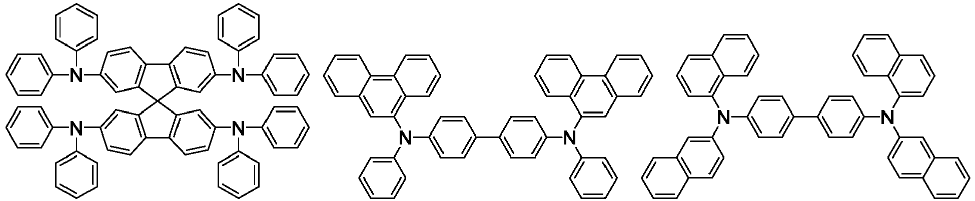

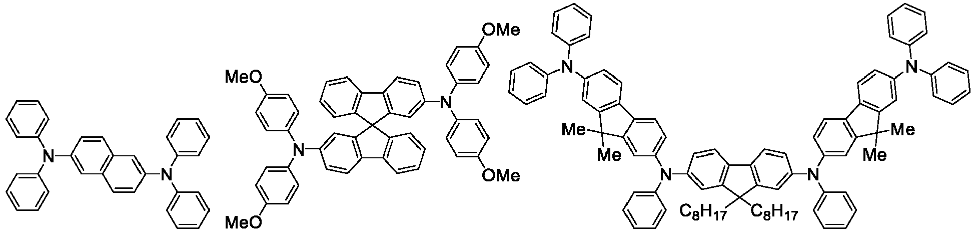

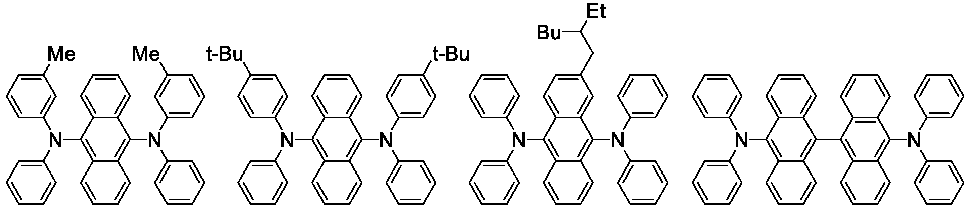

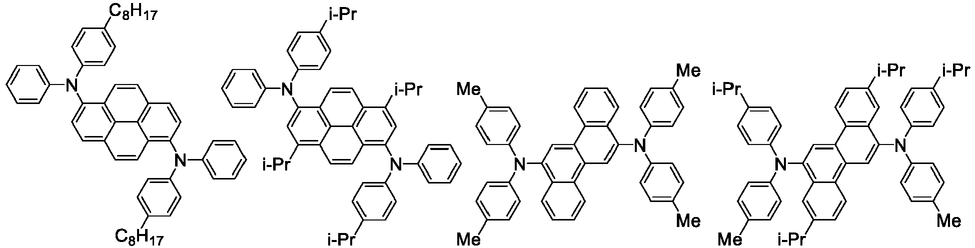

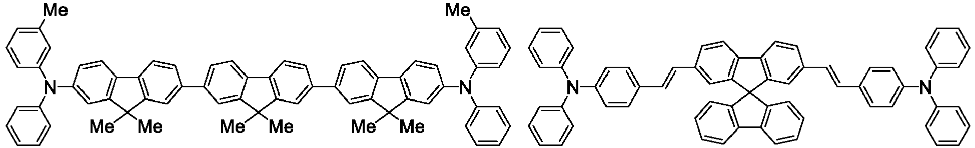

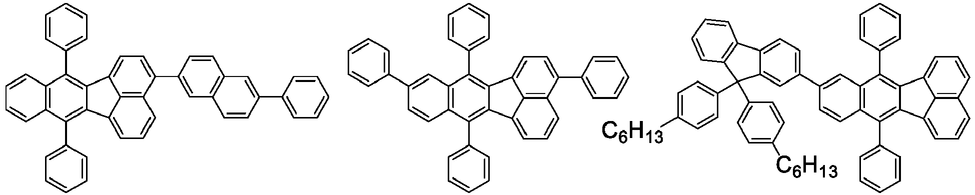

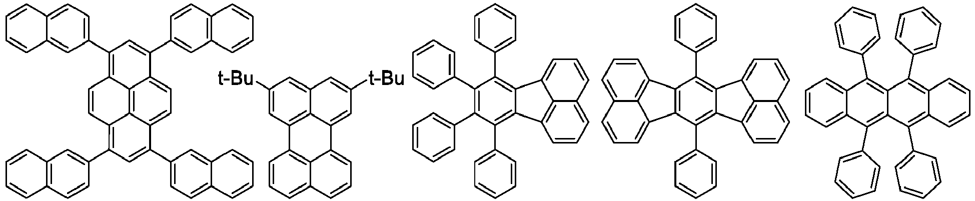

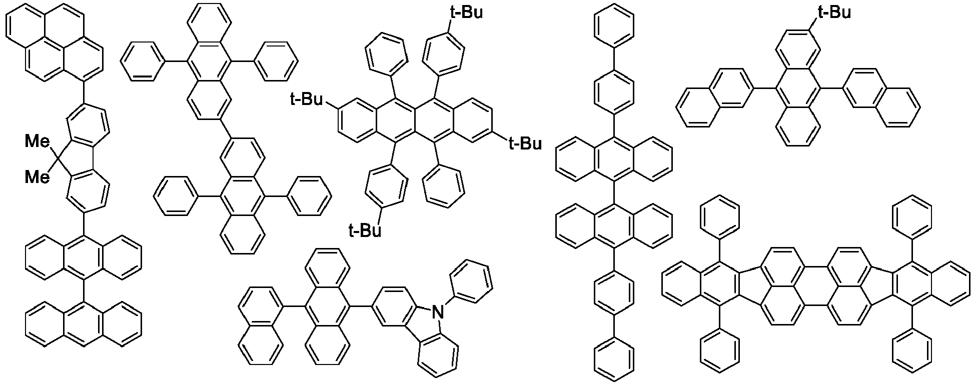

### [Composition ratio and the like of first organic layer]

In the first organic layer, the compound represented by the formula (T) may be contained singly or contained in combination of two or more kinds thereof.

In the first organic layer, the fluorescent compound represented by the formula (B) may be contained singly or contained in combination of two or more kinds thereof.

In the first organic layer, the content of the fluorescent compound represented by the formula (B) is usually 0.1 to 50 parts by mass, preferably 1 to 45 parts by mass, more preferably 5 to 40 parts by mass, further preferably 10 to 30 parts by mass when the sum of the compound represented by the formula (T) and the fluorescent compound represented by the formula (B) is taken as 100 parts by mass.

The first organic layer may be a layer containing a composition containing the compound represented by the formula (T), the fluorescent compound represented by the formula (B) and at least one further material selected from the group consisting of a hole transporting material, a hole injection material, an electron transporting material, an electron injection material, a light emitting material and an antioxidant (hereinafter, referred to also as "first composition"). However, in the first composition, the further light emitting material is different from the light emitting fluorescent compound represented by the formula (B). Further, in the first composition, the further hole transporting material, the further hole injection material, the further light emitting material, the further electron transporting material and the further electron injection material are different from the compound represented by the formula (T).

### [Hole transporting material]

The hole transporting material is classified into low molecular compounds and polymer compounds, and polymer compounds are preferable. The hole transporting material may have a crosslink group.

The polymer compound includes, for example, polyvinylcarbazole and derivatives thereof; polyarylenes having an aromatic amine structure in the side chain or main chain and derivatives thereof. The polymer compound may also be a compound in which an electron accepting site is bonded. The electron accepting site includes, for example, fullerene, tetrafluorotetracyanoquinodimethane, tetracyanoethylene, trinitrofluorenone and the like, and fullerene is preferable.

In the first composition, the compounding amount of the hole transporting material is usually 0.1 to 1000 parts by mass, preferably 1 to 400 parts by mass, more preferably 5 to 150 parts by mass when the sum of the compound represented by the formula (T) and the fluorescent compound represented by the formula (B) is taken as 100 parts by mass.

The hole transporting material may be used singly or in combination of two or more.

### [Electron transporting material]

The electron transporting material is classified into low molecular compounds and polymer compounds. The electron transporting material may have a crosslink group.

The low molecular compound includes, for example, metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene and derivatives thereof. The polymer compound may be doped with a metal.

In the first composition, the compounding amount of the electron transporting material is usually 0.1 to 1000 parts by mass, preferably 1 to 400 parts by mass, more preferably 5 to 150 parts by mass when the sum of the compound represented by the formula (T) and the fluorescent compound represented by the formula (B) is taken as 100 parts by mass.

The electron transporting material may be used singly or in combination of two or more kinds thereof.

### [Hole injection material and electron injection material]

The hole injection material and the electron injection material are each classified into low molecular compounds and polymer compounds. The hole injection material and the electron injection material may have a crosslink group.

The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer containing an aromatic amine structure in the main chain or side chain, and the like.

In the first composition, the compounding amount of the hole injection material and the electron injection material are each usually 0.1 to 1000 parts by mass, preferably 1 to 400 parts by mass, more preferably 5 to 150 parts by mass when the sum of the compound represented by the formula (T) and the fluorescent compound represented by the formula (B) is taken as 100 parts by mass.

The electron injection material and the hole injection material each may be used singly or in combination of two or more kinds thereof.

### [Ion doping]

When the hole injection material or the electron injection material contains an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with an appropriate amount of ions.

The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more kinds thereof.

### [Light emitting material]

The light emitting material is classified into low molecular compounds and polymer compounds. The light emitting material may have a crosslink group.

The low molecular compound includes phosphorescent metal complexes having iridium, platinum or europium as the central metal.

The polymer compound includes polymer compounds containing, for example, a phenylene group, a naphthalenediyl group, anthracenediyl group, a fluorenediyl group, a phenanthrenedilyl group, a dihydrophenanthrenedilyl group, a group represented by the formula (X), a carbazolediyl group, a phenoxazinediyl group, a phenothiazinediyl group, a pyrenediyl group and the like.

In the first composition, the compounding amount of the light emitting material is usually 0.1 to 1000 parts by mass, preferably 1 to 400 parts by mass, more preferably 5 to 150 parts by mass when the sum of the compound represented by the formula (T) and the fluorescent compound represented by the formula (B) is taken as 100 parts by mass.

The light emitting material may be used singly or in combination of two or more kinds thereof.

### [Antioxidant]

The antioxidant may be a compound which is soluble in a solvent which is the same as the solvent for the compound represented by the formula (T) and the fluorescent compound represented by the formula (B) and does not inhibit light emission and charge transportation, and includes, for example, phenol type antioxidants and phosphorus-based antioxidants.

In the first composition, the compounding amount of the antioxidant is usually 0.001 to 10 parts by mass when the sum of the compound represented by the formula (T) and the fluorescent compound represented by the formula (B) is taken as 100 parts by mass.

The antioxidant may be used singly or in combination of two or more kinds thereof.

### [First ink]

The composition containing the compound represented by the formula (T), the fluorescent compound represented by the formula (B) and a solvent (hereinafter, referred to also as "first ink") can be suitably used for application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method and the like.

The viscosity of the first ink may be adjusted according to the type of the application method, and when applied printing methods in which a solution passes through a discharge device such as an inkjet printing method and the like, the viscosity is preferably 1 to 20 mPa•s at 25°C since clogging and flight deflection during discharge scarcely occur.

The solvent contained in the first ink is preferably a solvent capable of dissolving or uniformly dispersing solid components in the ink. The solvent includes, for example, chlorine-based solvents such as 1,2-dichloroethane, 1,1,2-trichloroethane, chlorobenzene, o-dichlorobenzene and the like; ether type solvents such as tetrahydrofuran, dioxane, anisole, 4-methylanisole and the like; aromatic hydrocarbon type solvents such as toluene, xylene, mesitylene, ethylbenzene, n-hexylbenzene, cyclohexylbenzene and the like; aliphatic hydrocarbon type solvents such as cyclohexane, methylcyclohexane, n-pentane, n-hexane, n-heptane, n-octane, n-nonane, n-decane, n-dodecane, bicyclohexyl and the like; ketone type solvents such as acetone, methyl ethyl ketone, cyclohexanone, acetophenone and the like; ester type solvents such as ethyl acetate, butyl acetate, ethyl cellosolve acetate, methyl benzoate, phenyl acetate and the like; polyhydric alcohol type solvents such as ethylene glycol, glycerin, 1,2-hexanediol and the like; alcohol type solvents such as isopropyl alcohol, cyclohexanol and the like; sulfoxide type solvents such as dimethyl sulfoxide and the like; and amide type solvents such as N-methyl-2-pyrrolidone, N,N-dimethylformamide and the like. The solvent may be used singly or in combination of two or more kinds thereof.

In the first ink, the compounding amount of the solvent is usually 1000 to 100000 parts by mass, preferably 2000 to 20000 parts by mass when the sum of the compound represented by the formula (T) and the fluorescent compound represented by the formula (B) is taken as 100 parts by mass.

### <Second organic layer>

The crosslinked body of a crosslink material is obtained by bringing the crosslink material into a crosslinked state by the above-described method.

The crosslink material may be a low molecular compound or a polymer compound, and it is preferably a low molecular compound having at least one crosslink group selected from Group A of crosslink group (hereinafter, referred to also as "low molecular compound of second organic layer") or a polymer compound containing a crosslink constitutional unit having at least one crosslink group selected from Group A of crosslink group (hereinafter, referred to also as "polymer compound of second organic layer"), more preferably a polymer compound containing a crosslink constitutional unit having at least one crosslink group selected from Group A of crosslink group, since the light emitting device of the present invention is more excellent in light emission efficiency.

The crosslink group selected from Group A of crosslink group is preferably a crosslink group represented by the formula (XL-1) to the formula (XL-4), the formula (XL-7) to the formula (XL-10) or the formula (XL-14) to the formula (XL-17), more preferably a crosslink group represented by the formula (XL-1), the formula (XL-3), the formula (XL-9), the formula (XL-10), the formula (XL-16) or the formula (XL-17), further preferably a crosslink group represented by the formula (XL-1), the formula (XL-16) or the formula (XL-17), particularly preferably a crosslink group represented by the formula (XL-1) or the formula (XL-17), especially preferably a crosslink group represented by the formula (XL-17), since the light emitting device of the present invention is more excellent in light emission efficiency.

The crosslink group selected from Group A of crosslink group is preferably a crosslink group represented by the formula (XL-2) to the formula (XL-4), the formula (XL-7) to the formula (XL-10), the formula (XL-14), the formula (XL-15) or the formula (XL-17), more preferably a crosslink group represented by the formula (XL-9), the formula (XL-10) or the formula (XL-17), particularly preferably a crosslink group represented by the formula (XL-17), since the light emitting device of the present invention is more excellent in light emission efficiency and the crosslink material is more excellent in crosslinkability.

### [Polymer compound of second organic layer]

The constitutional unit having at least one crosslink group selected from Group A of crosslink group contained in the polymer compound of the second organic layer is preferably a constitutional unit represented by the formula (2) or a constitutional unit represented by the formula (2'), and may also be a constitutional unit represented by the following formulae.

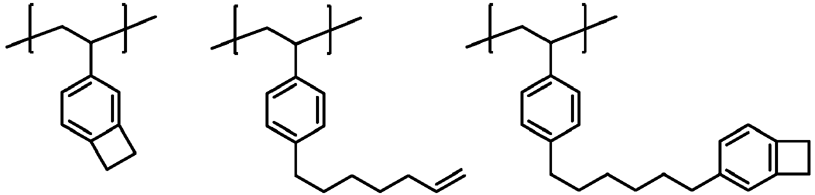

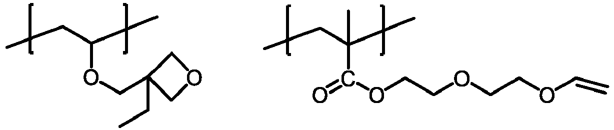

When the polymer compound of the second organic layer contains two or more constitutional units having at least one crosslink group selected from Group A of crosslink group, it is preferable that the crosslink groups are mutually different in at least two constitutional units having at least one crosslink group selected from Group A of crosslink group. The combination of the mutually different crosslink groups is preferably a combination of a crosslink group represented by the formula (XL-1), the formula (XL-2), the formula (XL-5) to the formula (XL-8) or the formula (XL-14) to the formula (XL-16) with a crosslink group represented by the formula (XL-3), the formula (XL-4), the formula (XL-13) or the formula (XL-17), more preferably a combination of a crosslink group represented by the formula (XL-1) or the formula (XL-16) with a crosslink group represented by the formula (XL-17), further preferably a combination of a crosslink group represented by the formula (XL-1) with a crosslink group represented by the formula (XL-17).

### Constitutional unit represented by the formula (2)

nA is preferably an integer of 0 to 3, more preferably an integer of 0 to 2, further preferably 1 or 2, particularly preferably 2, since the light emitting device of the present invention is more excellent in light emission efficiency.

n is preferably 2, since the light emitting device of the present invention is more excellent in light emission efficiency.

Ar³ is preferably an aromatic hydrocarbon group optionally having a substituent, since the light emitting device of the present invention is more excellent in light emission efficiency.

The number of carbon atoms of the aromatic hydrocarbon group represented by Ar³ is, not including the number of carbon atoms of the substituent, usually 6 to 60, preferably 6 to 30, more preferably 6 to 18.

The arylene group portion obtained by removing n substituents from the aromatic hydrocarbon group represented by Ar³ is preferably a group represented by the formula (A-1) to the formula (A-20), more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19), and these groups optionally have a substituent.

The number of carbon atoms of the hetero ring group represented by Ar³ is, not including the number of carbon atoms of the substituent, usually 2 to 60, preferably 3 to 30, more preferably 4 to 18.

The divalent hetero ring group portion obtained by removing n substituents from the hetero ring group represented by Ar³ is preferably a group represented by the formula (AA-1) to the formula (AA-34).

The aromatic hydrocarbon group and the hetero ring group represented by Ar³ optionally have a substituent, and the substituent is preferably an alkyl group, a cycloalkyl group, an alkoxy group, a cycloalkoxy group, an aryl group, an aryloxy group, a halogen atom, a monovalent hetero ring group and a cyano group.

The number of carbon atoms of the alkylene group represented by L^{A} is, not including the number of carbon atoms of the substituent, usually 1 to 20, preferably 1 to 15, more preferably 1 to 10. The number of carbon atoms of the cycloalkylene group represented by L^{A} is, not including the number of carbon atoms of the substituent, usually 3 to 20.

The alkylene group and the cycloalkylene group optionally have a substituent and examples thereof include a methylene group, an ethylene group, a propylene group, a butylene group, a hexylene group, a cyclohexylene group and an octylene group.

The alkylene group and the cycloalkylene group represented by L^{A} optionally have a substituent. The substituent which the alkylene group and the cycloalkylene group optionally have is preferably an alkyl group, a cycloalkyl group, an alkoxy group, a cycloalkoxy group, a halogen atom or a cyano group, and these groups optionally further have a substituent.

The arylene group represented by L^{A} optionally has a substituent. The arylene group is preferably a phenylene group or a fluorenediyl group, more preferably a m-phenylene group, a p-phenylene group, a fluorene-2,7-diyl group or a fluorene-9,9-diyl group. The substituent which the arylene group optionally has is preferably an alkyl group, a cycloalkyl group, an alkoxy group, a cycloalkoxy group, an aryl group, an aryloxy group, a monovalent hetero ring group, a halogen atom, a cyano group or a crosslink group selected from Group A of crosslink group, and these groups optionally further have a substituent.

The divalent hetero ring group represented by L^{A} is preferably a group represented by the formula (AA-1) to the formula (AA-34).

L^{A} is preferably an arylene group or an alkylene group, more preferably a phenylene group, a fluorenediyl group or an alkylene group, and these groups optionally have a substituent, since production of the polymer compound of the second organic layer becomes easy.

The crosslink group represented by X is preferably a crosslink group represented by the formula (XL-1) to the formula (XL-4), the formula (XL-7) to the formula (XL-10) or the formula (XL-14) to the formula (XL-17), more preferably a crosslink group represented by the formula (XL-1), the formula (XL-3), the formula (XL-9), the formula (XL-10), the formula (XL-16) or the formula (XL-17), further preferably a crosslink group represented by the formula (XL-1), the formula (XL-16) or the formula (XL-17), particularly preferably a crosslink group represented by the formula (XL-1) or the formula (XL-17), especially preferably a crosslink group represented by the formula (XL-17), since the light emitting device of the present invention is more excellent in light emission efficiency.

The crosslink group represented by X is preferably a crosslink group represented by the formula (XL-2) to the formula (XL-4), the formula (XL-7) to the formula (XL-10), the formula (XL-14), the formula (XL-15) or the formula (XL-17), more preferably a crosslink group represented by the formula (XL-9), the formula (XL-10) or the formula (XL-17), particularly preferably a crosslink group represented by the formula (XL-17), since the light emitting device of the present invention is more excellent in light emission efficiency and the polymer compound of the second organic layer is more excellent in crosslinkability.

The amount of the constitutional unit represented by the formula (2) is preferably 0.5 to 80% by mol, more preferably 3 to 65% by mol, further preferably 5 to 50% by mol with respect to the total amount of constitutional units contained in the polymer compound of the second organic layer, since the polymer compound of the second organic layer is excellent in stability and crosslinkability.

The constitutional unit represented by the formula (2) may be contained only singly or in combination of two or more kinds thereof in the polymer compound of the second organic layer.

When the polymer compound of the second organic layer contains two or more constitutional units represented by the formula (2), it is preferable that the crosslink groups represented by X are mutually different in at least two constitutional units represented by the formula (2). The preferable range of the combination of the mutually different crosslink groups represented by X is the same as the preferable range of the combination of the mutually different crosslink groups described above.

### Constitutional unit represented by the formula (2')

mA is preferably an integer of 0 to 3, more preferably an integer of 0 to 2, further preferably 0 or 1, particularly preferably 0, since the light emitting device of the present invention is more excellent in light emission efficiency.

m is preferably 1 or 2, more preferably 2, since the light emitting device of the present invention is more excellent in light emission efficiency.

c is preferably 0, since production of the polymer compound of the second organic layer becomes easy and the light emitting device of the present invention is more excellent in light emission efficiency.

Ar⁵ is preferably an aromatic hydrocarbon group optionally having a substituent, since the light emitting device of the present invention is more excellent in light emission efficiency.

The definition and the examples of the arylene group portion obtained by removing m substituents of the aromatic hydrocarbon group represented by Ar⁵ are the same as the definition and the examples of the arylene group represented by Ar^{X2} in the formula (X) described later.

The definition and the examples of the divalent hetero ring group portion obtained by removing m substituents of the aromatic hydrocarbon group represented by Ar⁵ are the same as the definition and the examples of the divalent hetero ring group portion represented by Ar^{X2} in the formula (X) described later.

The definition and the examples of the divalent group obtained by removing m substituents of the group in which at least one aromatic hydrocarbon ring and at least one hetero ring are bonded directly represented by Ar⁵ are the same as the definition and the examples of the divalent group in which at least one arylene ring and at least one divalent hetero ring group are bonded directly represented by Ar^{X2} in the formula (X) described later.

Ar⁴ and Ar⁶ are each preferably an arylene group optionally having a substituent, since the light emitting device of the present invention is more excellent in light emission efficiency.

The definition and the examples of the arylene group represented by Ar⁴ and Ar⁶ are the same as the definition and the examples of the arylene group represented by Ar^{X1} and Ar^{X3} in the formula (X) described later.

The definition and the examples of the divalent hetero ring group represented by Ar⁴ and Ar⁶ are the same as the definition and the examples of the divalent hetero ring group represented by Ar^{X1} and Ar^{X3} in the formula (X) described later.

The group represented by Ar⁴, Ar⁵ and Ar⁶ optionally has a substituent, and the substituent is preferably an alkyl group, a cycloalkyl group, an alkoxy group, a cycloalkoxy group, an aryl group, an aryloxy group, a halogen atom, a monovalent hetero ring group and a cyano group.

The definition and the examples of the alkylene group, the cycloalkylene group, the arylene group and the divalent hetero ring group represented by K^{A} are the same as the definition and the examples of the alkylene group, the cycloalkylene group, the arylene group and the divalent hetero ring group represented by L^{A}, respectively.

K^{A} is preferably a phenylene group or a methylene group, since production of the polymer compound of the second organic layer becomes easy.

on and the examples of the crosslink group represented by X' are the same as the definition and the examples of the crosslink group represented by X described above.

The amount of the constitutional unit represented by the formula (2') is preferably 0.5 to 50% by mol, more preferably 3 to 30% by mol, further preferably 5 to 20% by mol with respect to the total amount of constitutional units contained in the polymer compound of the second organic layer, since the polymer compound of the second organic layer is excellent in stability and the polymer compound of the second organic layer is excellent in crosslinkability.

The constitutional unit represented by the formula (2') may be contained only singly or in combination of two or more kinds thereof in the polymer compound of the second organic layer.

When the polymer compound of the second organic layer contains two or more constitutional units represented by the formula (2'), it is preferable that the crosslink groups represented by X' are mutually different in at least two constitutional units represented by the formula (2'). The preferable range of the combination of the mutually different crosslink groups represented by X' is the same as the preferable range of the combination of the mutually different crosslink groups described above.

### Preferable embodiment of constitutional unit represented by the formula (2) or (2')

The constitutional unit represented by the formula (2) includes, for example, constitutional units represented by the formula (2-1) to the formula (2-30), and the constitutional unit represented by the formula (2') includes, for example, constitutional units represented by the formula (2'-1) to the formula (2'-9). Of them, preferable are constitutional units represented by the formula (2-1) to the formula (2-30), more preferable are constitutional units represented by the formula (2-1) to the formula (2-15), the formula (2-19), the formula (2-20), the formula (2-23), the formula (2-25) or the formula (2-30), further preferable are constitutional units represented by the formula (2-1) to the formula (2-9) or the formula (2-30), since the polymer compound of the second organic layer is excellent in crosslinkability.

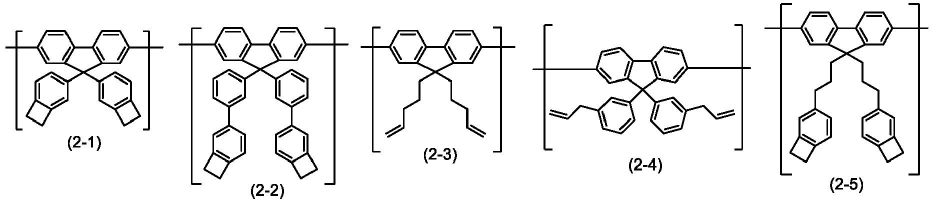

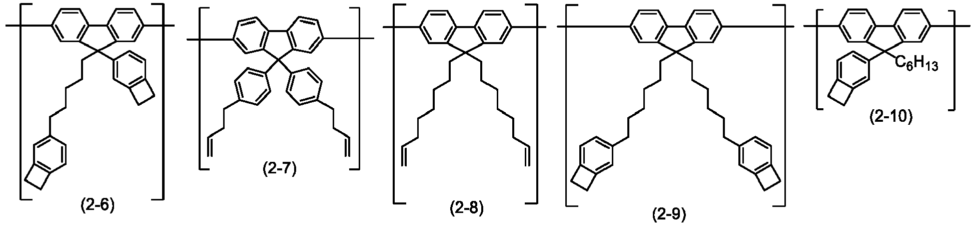

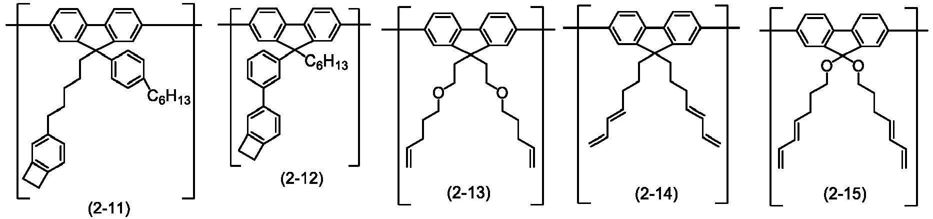

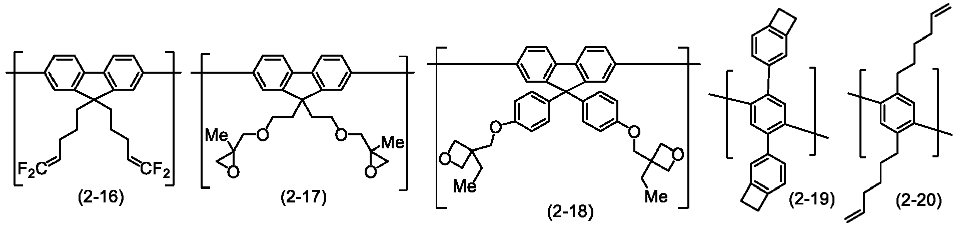

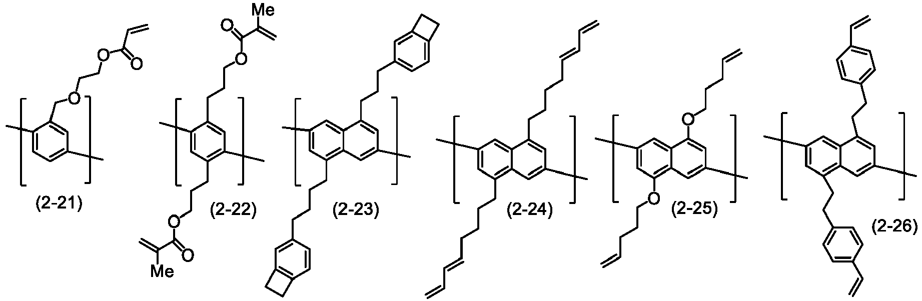

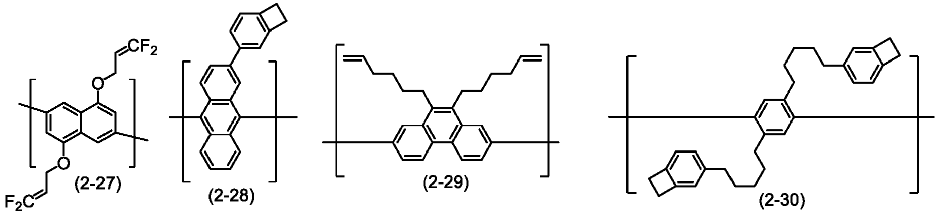

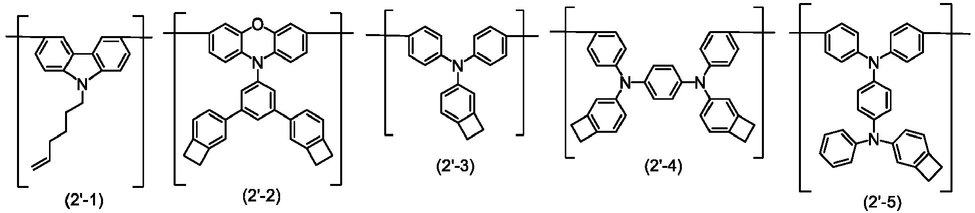

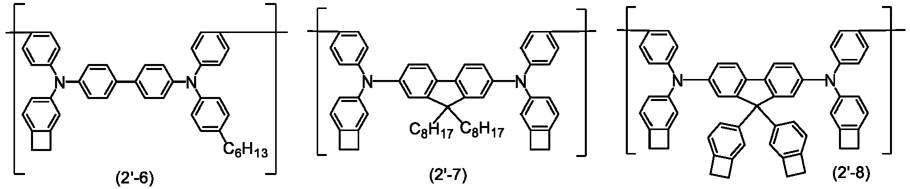

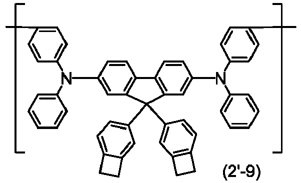

### Other constitutional unit

It is preferable that the polymer compound of the second organic layer further contains a constitutional unit represented by the formula (X), since excellent hole transportability is obtained. It is preferable that the polymer compound of the second organic layer further contains a constitutional unit represented by the formula (Y), since the light emitting device of the present invention is more excellent in light emission efficiency.

It is preferable that the polymer compound of the second organic layer further contains a constitutional unit represented by the formula (X) and a constitutional unit represented by the formula (Y) since excellent hole transportability is obtained and the light emitting device of the present invention is more excellent in light emission efficiency. 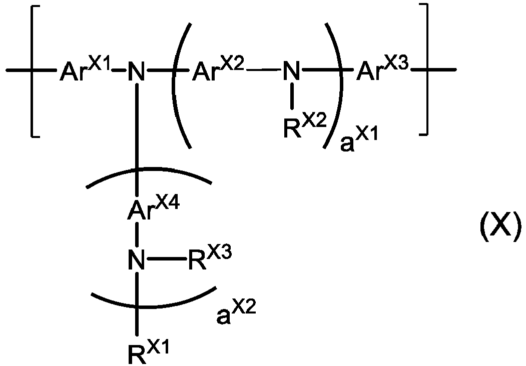 [wherein,
a^{X1} and a^{X2} each independently represent an integer of 0 or more.
Ar^{X1} and Ar^{X3} each independently represent an arylene group or a divalent hetero ring group, and these groups optionally have a substituent.
Ar^{X2} and Ar^{X4} each independently represent an arylene group, a divalent hetero ring group or a divalent group in which at least one arylene group and at least one divalent hetero ring group are bonded directly, and these groups optionally have a substituent. When a plurality of Ar^{X2} and Ar^{X4} are present, they may be the same or different at each occurrence.
R^{X1}, R^{X2} and R^{X3} each independently represent a hydrogen atom, an alkyl group, a cycloalkyl group, an aryl group or a monovalent hetero ring group, and these groups optionally have a substituent. When a plurality of R^{X2} and R^{X3} are present, they may be the same or different at each occurrence.]

a^{X1} is preferably an integer of 2 or less, more preferably 1, since the light emitting device of the present invention is more excellent in light emission efficiency,.

a^{X2} is preferably an integer of 2 or less, more preferably 0, since the light emitting device of the present invention is more excellent in light emission efficiency.

R^{X1}, R^{X2} and R^{X3} are each preferably an alkyl group, a cycloalkyl group, an aryl group or a monovalent hetero ring group, more preferably an aryl group, and these groups optionally have a substituent.

The arylene group represented by Ar^{X1} and Ar^{X3} is more preferably a group represented by the formula (A-1) or the formula (A-9), further preferably a group represented by the formula (A-1), and these groups optionally have a substituent.

The divalent hetero ring group represented by Ar^{X1} and Ar^{X3} is more preferably a group represented by the formula (AA-1), the formula (AA-2) or the formula (AA-7) to the formula (AA-26), and these groups optionally have a substituent.

Ar^{X1} and Ar^{X3} are each preferably an arylene group optionally having a substituent.

The arylene group represented by Ar^{X2} and Ar^{X4} is more preferably a group represented by the formula (A-1), the formula (A-6), the formula (A-7), the formula (A-9) to the formula (A-11) or the formula (A-19), and these groups optionally have a substituent.

The more preferable range of the divalent hetero ring group represented by Ar^{X2} and Ar^{X4} is the same as the more preferable range of the divalent hetero ring group represented by Ar^{X1} and Ar^{X3}.

In the divalent group in which at least one arylene group and at least one divalent hetero ring group are bonded directly represented by Ar^{X2} and Ar^{X4}, the more preferable range and the further preferable range of the arylene group and the divalent hetero ring group are the same as the more preferable range and the further preferable range of the arylene group and the divalent hetero ring group represented by Ar^{X1} and Ar^{X3}, respectively.

The divalent group in which at least one arylene group and at least one divalent hetero ring group are bonded directly represented by Ar^{X2} and Ar^{X4} includes, for example, groups represented by the following formulae, and these groups optionally have a substituent. 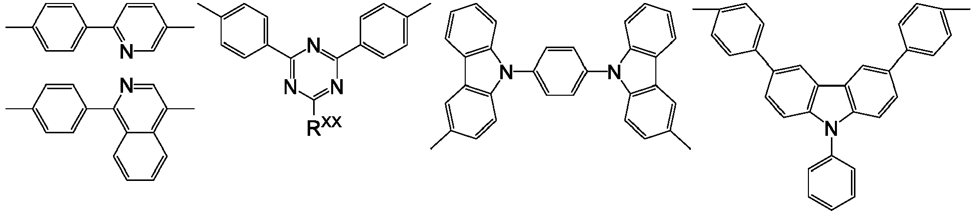 [wherein, R^{XX} represents a hydrogen atom, an alkyl group, a cycloalkyl group, an aryl group or a monovalent hetero ring group, and these groups optionally have a substituent.]

R^{XX} is preferably an alkyl group, a cycloalkyl group or an aryl group, and these groups optionally have a substituent.

Ar^{X2} and Ar^{X4} are each preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups optionally further have a substituent.

The constitutional unit represented by the formula (X) is preferably a constitutional unit represented by the formula (X-1) to the formula (X-7), more preferably a constitutional unit represented by the formula (X-3) to the formula (X-7), further preferably a constitutional unit represented by the formula (X-3) to the formula (X-6). 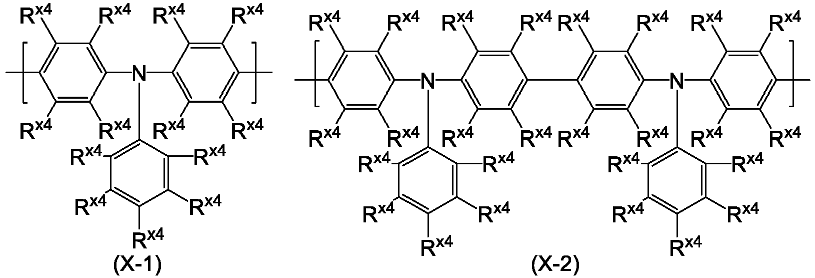 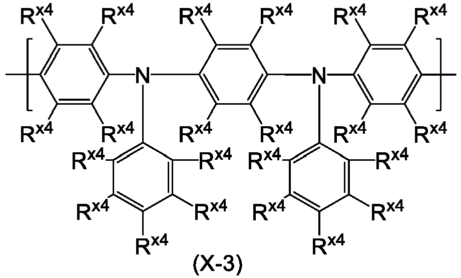 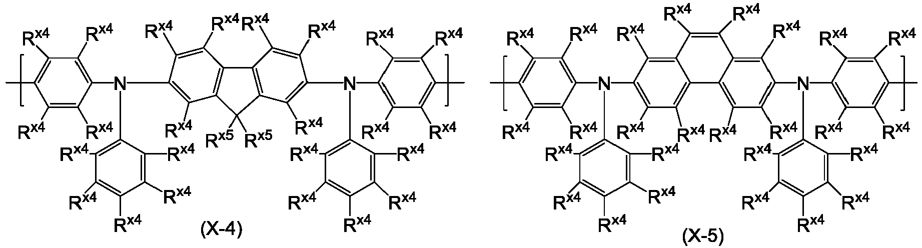 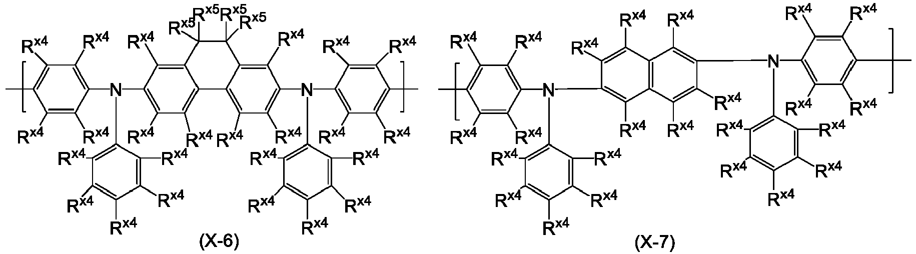 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent hetero ring group or a cyano group, and these groups optionally have a substituent. A plurality of R^{X4} may be the same or different. A plurality of R^{X5} may be the same or different, and adjacent R^{X5} may be combined together to form a ring together with carbon atoms to which they are attached.]

The amount of the constitutional unit represented by the formula (X) is preferably 0.1 to 90% by mol, more preferably 1 to 70% by mol, further preferably 10 to 50% by mol with respect to the total amount of constitutional units contained in the polymer compound of the second organic layer, since excellent hole transportability is obtained.

The constitutional unit represented by the formula (X) includes, for example, constitutional units represented by the formula (X1-1) to the formula (X1-19), preferably constitutional units represented by the formula (X1-6) to the formula (X1-14).

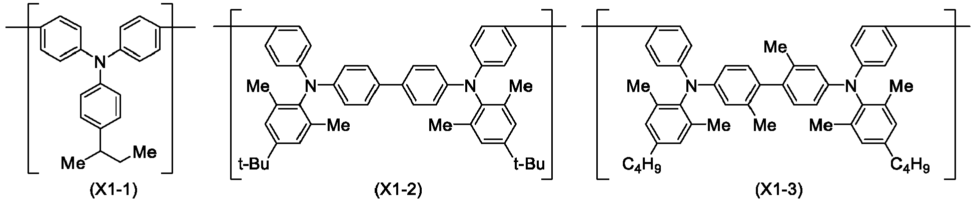

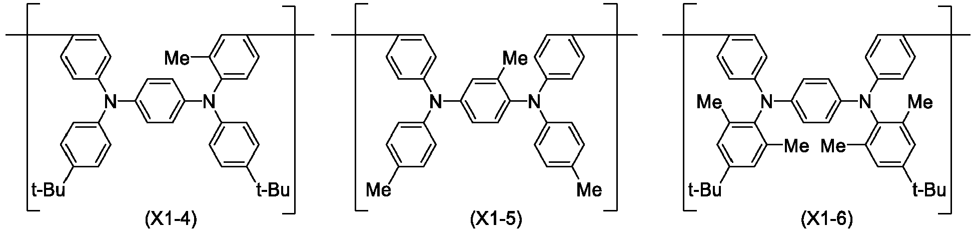

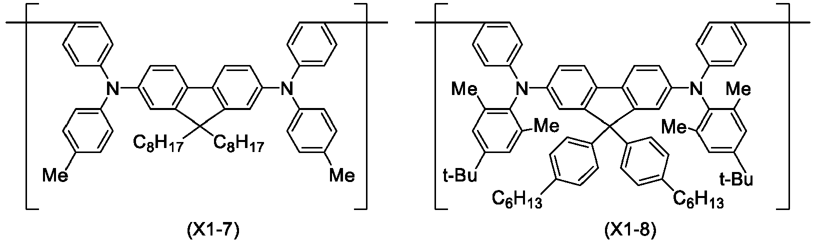

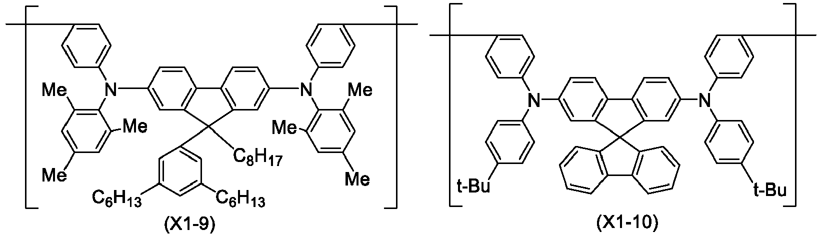

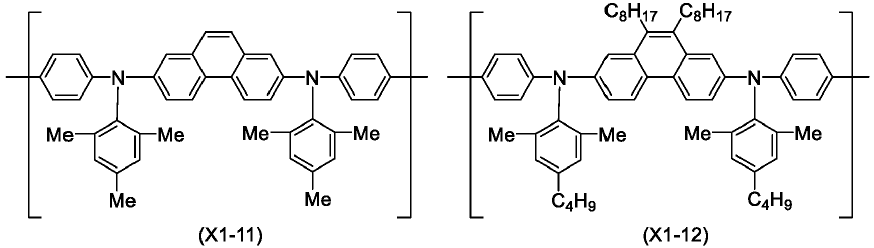

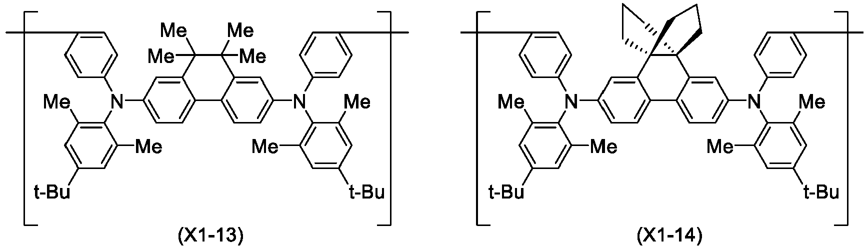

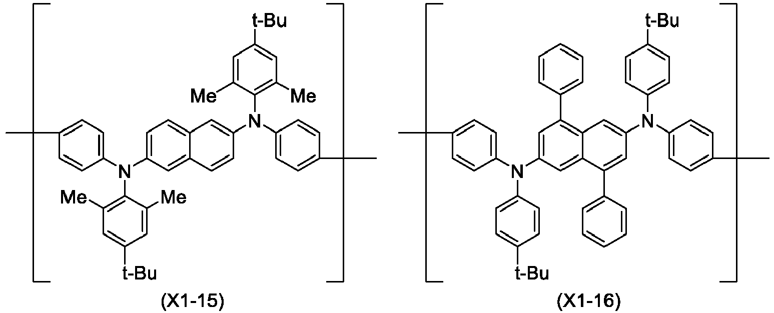

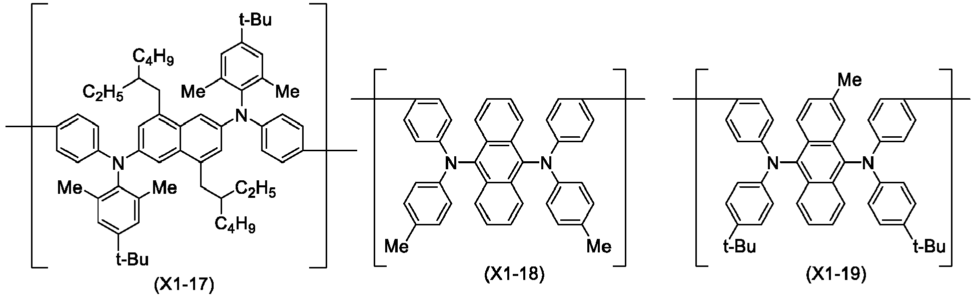

In the polymer compound of the second organic layer, the constitutional unit represented by the formula (X) may be contained only singly or in combination of two or more kinds thereof.

-[-Ar^{Y1}-]- (Y)

[wherein, Ar^{Y1} represents an arylene group, a divalent hetero ring group, or a divalent group in which at least one arylene group and at least one divalent hetero ring group are bonded directly, and these groups optionally have a substituent.]

The arylene group represented by Ar^{Y1} is more preferably a group represented by the formula (A-1), the formula (A-6), the formula (A-7), the formula (A-9) to the formula (A-11), the formula (A-13) or the formula (A-19), further preferably a group represented by the formula (A-1), the formula (A-7), the formula (A-9) or the formula (A-19), and these groups optionally have a substituent.

The divalent hetero ring group represented by Ar^{Y1} is more preferably a group represented by the formula (AA-4), the formula (AA-10), the formula (AA-13), the formula (AA-15), the formula (AA-18) or the formula (AA-20), especially preferably a group represented by the formula (AA-4), the formula (AA-10), the formula (AA-18) or the formula (AA-20), and these groups optionally have a substituent.

In the divalent group in which at least one arylene group and at least one divalent hetero ring group are bonded directly represented by Ar^{Y1}, the more preferable range and the further preferable range of the arylene group and the divalent hetero ring group are the same as the more preferable range and the further preferable range of the arylene group and the divalent hetero ring group represented by Ar^{Y1} described above, respectively.

The divalent group in which at least one arylene group and at least one divalent hetero ring group are bonded directly represented by Ar^{Y1} includes those which are the same as the divalent group in which at least one arylene group and at least one divalent hetero ring group are bonded directly represented by Ar^{X2} and Ar^{X4} in the formula (X).

The substituent which the group represented by Ar^{Y1} optionally has is preferably an alkyl group, a cycloalkyl group or an aryl group, and these groups optionally further have a substituent.

The constitutional unit represented by the formula (Y) includes, for example, constitutional units represented by the formula (Y-1) to the formula (Y-7), and includes preferably constitutional units represented by the formula (Y-1) or the formula (Y-2) from the standpoint of light emission efficiency of the light emitting device of the present invention, preferably constitutional units represented by the formula (Y-3) or the formula (Y-4) from the standpoint of electron transportability of the polymer compound of the second organic layer, and preferably constitutional units represented by the formula (Y-5) to the formula (Y-7) from the standpoint of hole transportability of the polymer compound of the second organic layer. 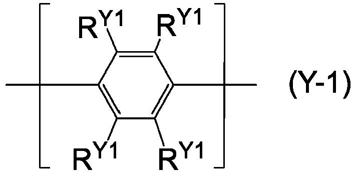 [wherein, R^{Y1} represents a hydrogen atom, an alkyl group, a cycloalkyl group, an alkoxy group, a cycloalkoxy group, an aryl group or a monovalent hetero ring group, and these groups optionally have a substituent. A plurality of R^{Y1} may be the same or different, and adjacent R^{Y1} may be combined together to form a ring together with carbon atoms to which they are attached.]

R^{Y1} is preferably a hydrogen atom, an alkyl group, a cycloalkyl group or an aryl group, and these groups optionally have a substituent.

The constitutional unit represented by the formula (Y-1) is preferably a constitutional unit represented by the formula (Y-1'). 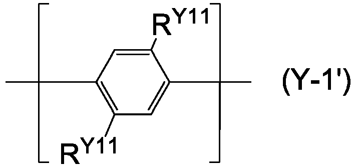 [wherein, R^{Y11} represents an alkyl group, a cycloalkyl group, an alkoxy group, a cycloalkoxy group, an aryl group or a monovalent hetero ring group, and these groups optionally have a substituent. A plurality of R^{Y11} may be the same or different.]

R^{Y11} is preferably an alkyl group, a cycloalkyl group or an aryl group, more preferably an alkyl group or a cycloalkyl group, and these groups optionally have a substituent. 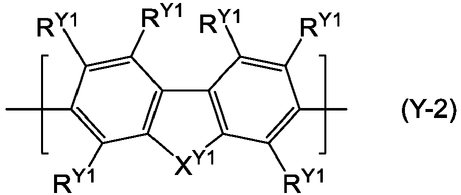 [wherein,
R^{Y1} represents the same meaning as described above.
X^{Y1} represents a group represented by -C(R^{Y2})₂-, -C(R^{Y2}) = C(R^{Y2}) - or C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent hetero ring group, and these groups optionally have a substituent. A plurality of R^{Y2} may be the same or different, and groups R^{Y2} may be combined together to form a ring together with carbon atoms to which they are attached.]

R^{Y2} is preferably an alkyl group, a cycloalkyl group, an aryl group or a monovalent hetero ring group, more preferably an alkyl group, a cycloalkyl group or an aryl group, and these groups optionally have a substituent.

In X^{Y1}, the combination of two groups R^{Y2} in the group represented by -C(R^{Y2})₂- is preferably a combination in which both represent an alkyl group or a cycloalkyl group, both represent an aryl group, both represent a monovalent hetero ring group, or one represents an alkyl group or a cycloalkyl group and the other represents an aryl group or a monovalent hetero ring group, more preferably a combination in which one represents an alkyl group or a cycloalkyl group and the other represents an aryl group, and these groups optionally have a substituent. Two groups R^{Y2} may be combined together to form a ring together with atoms to which they are attached, and when R^{Y2} forms a ring, the group represented by -C(R^{Y2})₂- is preferably a group represented by the formula (Y-A1) to the formula (Y-A5), more preferably a group represented by the formula (Y-A4), and these groups optionally have a substituent.

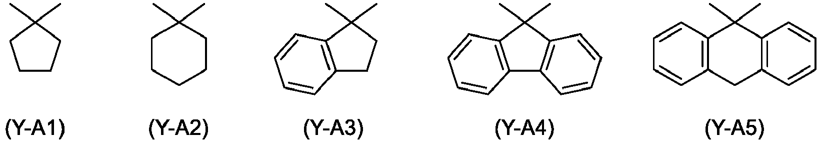

In X^{Y1}, the combination of two groups R^{Y2} in the group represented by -C(R^{Y2})=C(R^{Y2})- is preferably a combination in which both represent an alkyl group or a cycloalkyl group, or one represents an alkyl group or a cycloalkyl group and the other represents an aryl group, and these groups optionally have a substituent.

In X^{Y1}, four groups R^{Y2} in the group represented by -C(R^{Y2})₂-C(R^{Y2})₂- represent preferably an alkyl group or a cycloalkyl group optionally having a substituent. A plurality of R^{Y2} may be combined together to form a ring together with atoms to which they are attached, and when R^{Y2} forms a ring, the group represented by -C(R^{Y2})₂-C(R^{Y2})₂- is preferably a group represented by the formula (Y-B1) to the formula (Y-B5), more preferably a group represented by the formula (Y-B3), and these groups optionally have a substituent. 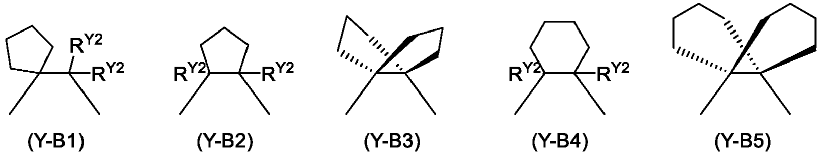 [wherein, R^{Y2} represents the same meaning as described above.]

The constitutional unit represented by the formula (Y-2) is preferably a constitutional unit represented by the formula (Y-2'). 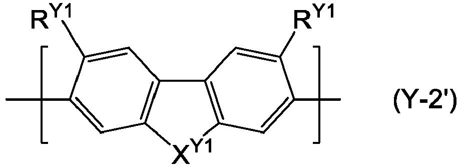 [wherein, R^{Y1} and X^{Y1} represent the same meaning as described above.] 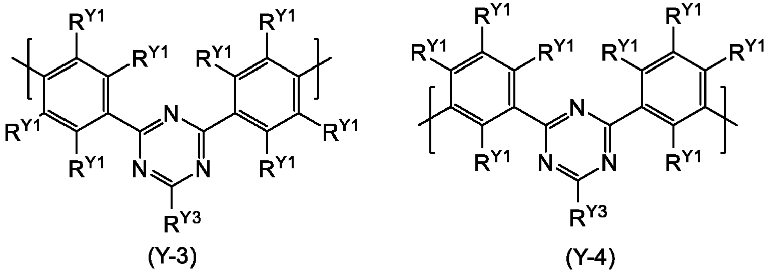 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent hetero ring group, and these groups optionally have a substituent.]

R^{Y3} is preferably an alkyl group, a cycloalkyl group, an alkoxy group, a cycloalkoxy group, an aryl group or a monovalent hetero ring group, more preferably an aryl group, and these groups optionally have a substituent. 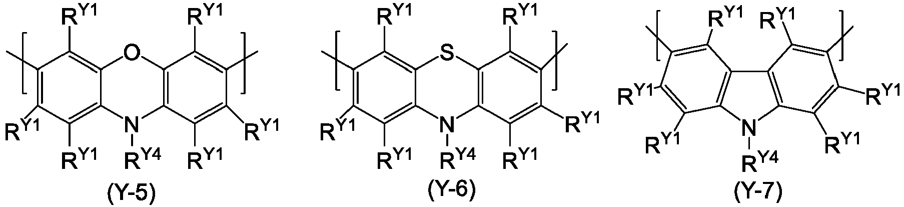 [wherein,
R^{Y1} represents the same meaning as described above.
R^{Y4} represents a hydrogen atom, an alkyl group, a cycloalkyl group, an alkoxy group, a cycloalkoxy group, an aryl group or a monovalent hetero ring group, and these groups optionally have a substituent.]

R^{Y4} is preferably an alkyl group, a cycloalkyl group, an alkoxy group, a cycloalkoxy group, an aryl group or a monovalent hetero ring group, more preferably an aryl group, and these groups optionally have a substituent.

The constitutional unit represented by the formula (Y) includes, for example, constitutional units represented by the formula (Y-11) to the formula (Y-56).

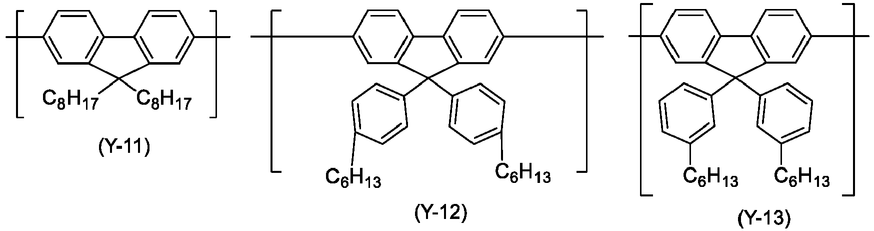

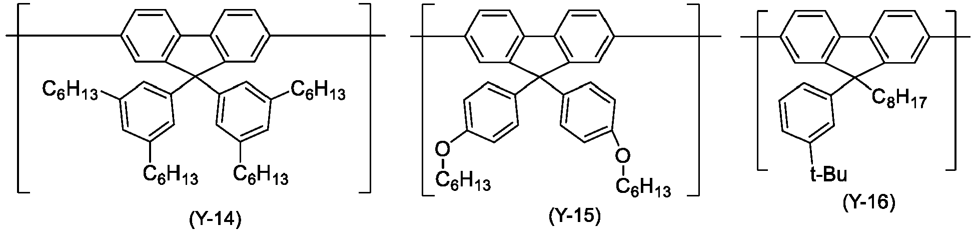

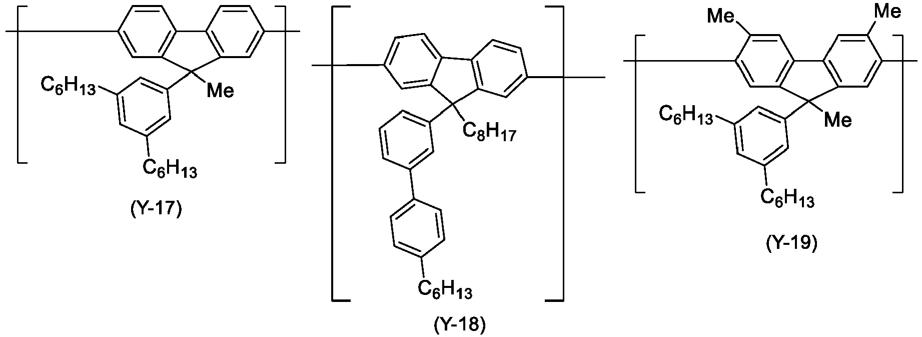

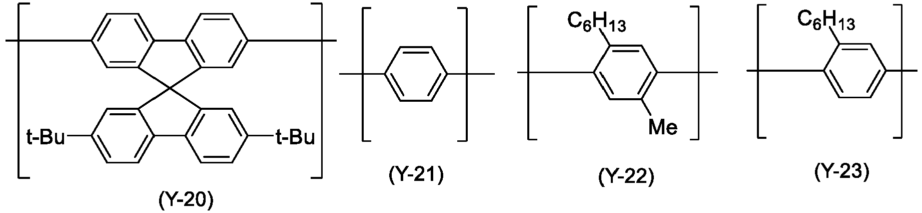

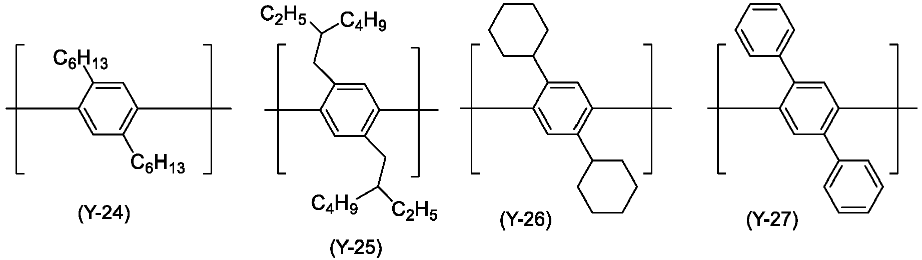

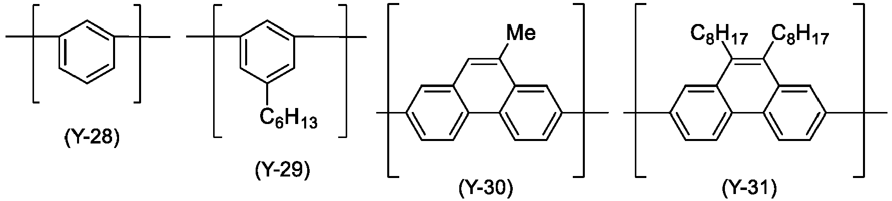

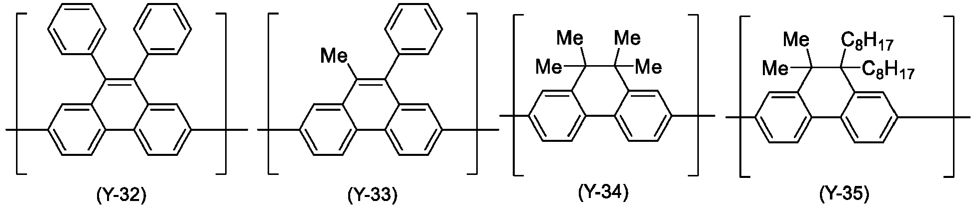

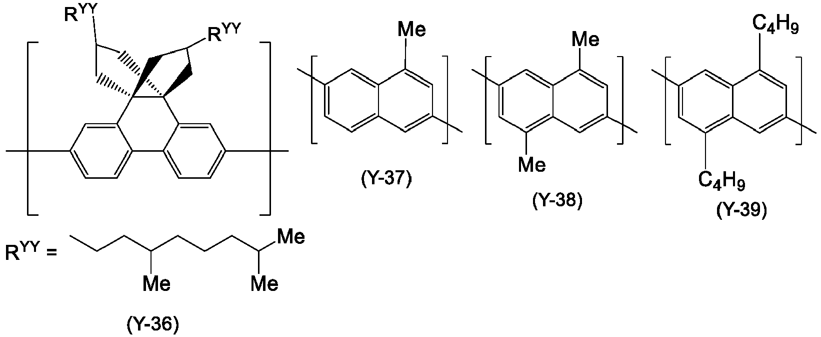

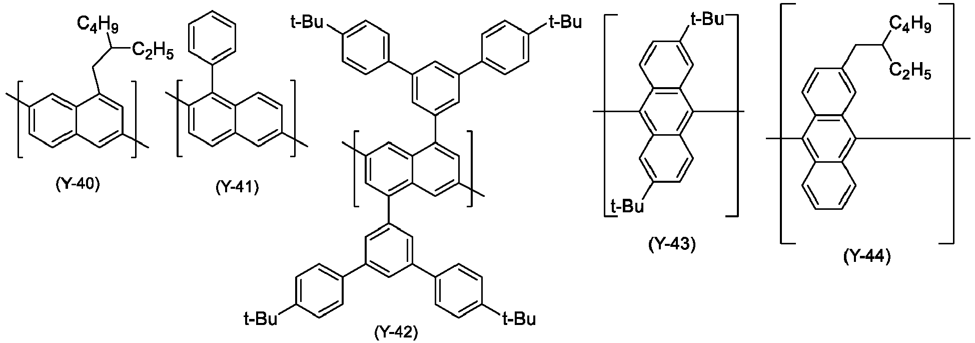

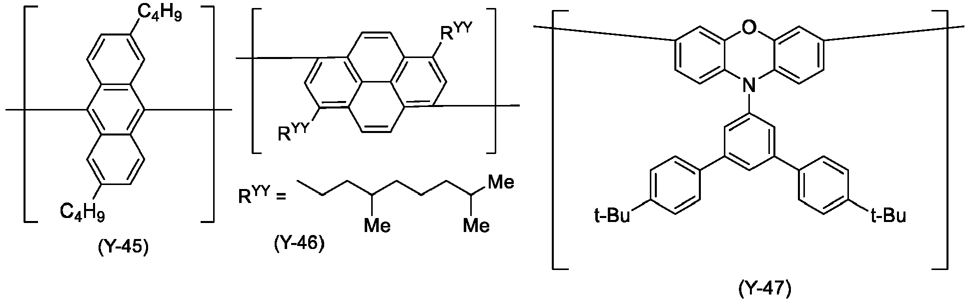

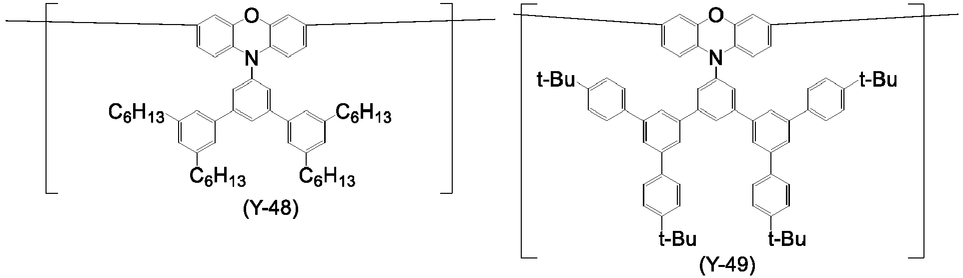

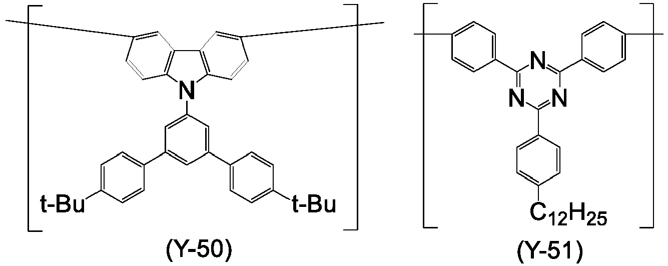

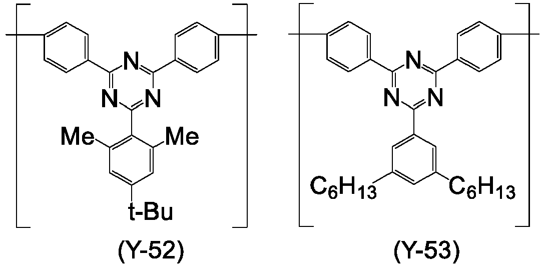

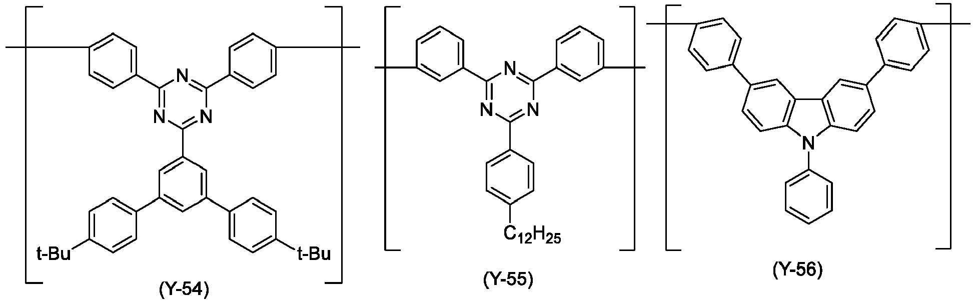

The amount of the constitutional unit represented by the formula (Y) in which Ar^{Y1} is an arylene group is preferably 0.5 to 80% by mol, more preferably 30 to 60% by mol with respect to total amount of constitutional units contained in the polymer compound of the second organic layer, since the light emitting device of the present invention is more excellent in light emission efficiency.

The amount of the constitutional unit represented by the formula (Y) in which Ar^{Y1} is a divalent hetero ring group or a divalent group in which at least one arylene group and at least one divalent hetero ring group are bonded directly is preferably 0.1 to 90% by mol, more preferably 1 to 70% by mol, further preferably 10 to 50% by mol with respect to the total amount of constitutional units contained in the polymer compound of the second organic layer, since the polymer compound of the second organic layer is excellent in charge transportability.

The constitutional unit represented by the formula (Y) may be contained only singly or in combination of two or more kinds thereof in the polymer compound of the second organic layer.

The polymer compound of the second organic layer includes, for example, polymer compounds P-1 to P-8. In the present specification, "other constitutional unit" denotes a constitutional unit other than the constitutional units represented by the formula (2), the formula (2'), the formula (X) and the formula (Y).

**[Table 1]**

| polymer compound | constitutional unit and mole fraction thereof | | | | |
|---|---|---|---|---|---|
| | formula (2) | formula (2') | formula (X) | formula (Y) | other |
| | p' | q' | r' | s' | t' |
| P-1 | 0.1 to 99.9 | 0.1 to 99.9 | 0 | 0 | 0 to 30 |
| P-2 | 0.1 to 99.9 | 0 | 0.1 to 99.9 | 0 | 0 to 30 |
| P-3 | 0.1 to 99.9 | 0 | 0 | 0.1 to 99.9 | 0 to 30 |
| P-4 | 0 | 0.1 to 99.9 | 0.1 to 99.9 | 0 | 0 to 30 |
| P-5 | 0 | 0.1 to 99.9 | 0 | 0.1 to 99.9 | 0 to 30 |
| P-6 | 0.1 to 99.8 | 0.1 to 99.8 | 0.1 to 99.8 | 0 | 0 to 30 |
| P-7 | 0.1 to 99.8 | 0.1 to 99.8 | 0 | 0.1 to 99.8 | 0 to 30 |
| P-8 | 0.1 to 99.7 | 0.1 to 99.7 | 0.1 to 99.7 | 0.1 to 99.7 | 0 to 30 |

[in the table, p' , q' , r' , s' and t' represent the mole fraction of each constitutional unit. p'+q'+r'+s'+t' = 100 and 70 ≤ p'+q'+r'+s' ≤ 100.]

The polymer compound of the second organic layer may be any of a block copolymer, a random copolymer, an alternating copolymer and a graft copolymer, and may also be another form, and is preferably a copolymer obtained by copolymerizing a plurality of raw material monomers.

The polymer compound of the second organic layer has a polystyrene-equivalent number-average molecular weight of preferably 5×10³ to 1×10⁶, more preferably 1×10⁴ to 5×10⁵, further preferably 1.5×10⁴ to 1×10⁵.

### [Production method of polymer compound of second organic layer]

The polymer compound of the second organic layer can be produced using known polymerization methods described in Chemical Review (Chem. Rev.), vol. 109, pp. 897 to 1091 (2009) and the like, and methods of polymerizing by a coupling reaction using a transition metal catalyst such as the Suzuki reaction, the Yamamoto reaction, the Buchwald reaction, the Stille reaction, the Negishi reaction, the Kumada reaction and the like are exemplified.

In the above-described polymerization methods, the method of charging monomers includes a method in which the entire monomers are charged all at once into the reaction system, a method in which a part of the monomers is charged and reacted, then, the remaining monomers are charged all at once, continuously or in a divided manner, a method of charging monomers continuously or dividedly, and other methods.

The transition metal catalyst includes a palladium catalyst, a nickel catalyst and the like.

For the post treatment of the polymerization reaction, known methods, for example, a method in which water-soluble impurities are removed by liquid separation, a method in which a reaction solution after the polymerization reaction is added to a lower alcohol such as methanol and the like, the deposited precipitate is filtrated, then, dried, and other methods, are used each singly or used in combination. When the purity of the polymer compound of the second organic layer is low, it can be purified by usual methods such as, for example, crystallization, reprecipitation, continuous extraction with a Soxhlet extractor, column chromatography and the like.

### [Low molecular compound of second organic layer]

The low molecular compound of the second organic layer is preferably a low molecular compound represented by the formula (3).

m^{B1} is preferably an integer of 0 to 5, more preferably an integer of 0 to 2, further preferably 0 or 1, particularly preferably 0, since synthesis of a crosslink material becomes easy.

m^{B2} is preferably an integer of 0 to 5, more preferably an integer of 0 to 3, further preferably 1 or 2, particularly preferably 1, since synthesis of a crosslink material becomes easy and the light emitting device of the present invention is more excellent in light emission efficiency.

m^{B3} is preferably an integer of 0 to 4, more preferably an integer of 0 to 2, further preferably 0, since synthesis of a crosslink material becomes easy.

The definition and the examples of the arylene group portion obtained by removing m^{B3} substituents from the aromatic hydrocarbon group represented by Ar⁷ are the same as the definition and the examples of the arylene group represented by Ar^{X2} in the formula (X) described above.

The definition and the examples of the divalent hetero ring group portion obtained by removing m^{B3} substituents from the hetero ring group represented by Ar⁷ are the same as the definition and the examples of the divalent hetero ring group portion represented by Ar^{X2} in the formula (X) described above.

The definition and the examples of the divalent group obtained by removing m^{B3} substituents from the group in which at least one aromatic hydrocarbon ring and at least one hetero ring are bonded directly represented by Ar⁷ are the same as the definition and the examples of the divalent group in which at least one arylene group and at least one divalent hetero ring group are bonded directly represented by Ar^{X2} in the formula (X) described above.

The definition and the examples of the substituent which the group represented by Ar⁷ optionally has are the same as the definition and the examples of the substituent which the group represented by Ar^{X2} optionally has in the formula (X) described above.

Ar⁷ is preferably an aromatic hydrocarbon group, and this aromatic hydrocarbon group optionally has a substituent, since the light emitting device of the present invention is excellent in light emission efficiency.

The definition and the examples of the alkylene group, the cycloalkylene group, the arylene group and the divalent hetero ring group represented by L^{B1} are the same as the definition and the examples of the alkylene group, the cycloalkylene group, the arylene group and the divalent hetero ring group represented by L^{A} described above, respectively.

L^{B1} is preferably an alkylene group, an arylene group or an oxygen atom, more preferably an alkylene group or an arylene group, further preferably a phenylene group, a fluorenediyl group or an alkylene group, particularly preferably a phenylene group or an alkylene group, and these groups optionally have a substituent, since synthesis of a crosslink material becomes easy.

X" is preferably a constitutional unit represented by any of the formula (XL-1) to the formula (XL-17), an aryl group or a monovalent hetero ring group, more preferably a constitutional unit represented by the formula (XL-1), the formula (XL-3), the formula (XL-7) to the formula (XL-10), the formula (XL-16) or the formula (XL-17), or an aryl group, further preferably a constitutional unit represented by the formula (XL-1), the formula (XL-16) or the formula (XL-17), a phenyl group, a naphthyl group or a fluorenyl group, particularly preferably a constitutional unit represented by the formula (XL-16) or the formula (XL-17), a phenyl group or a naphthyl group, especially preferably a constitutional unit represented by the formula (XL-16) or a naphthyl group, and these groups optionally have a substituent.

The crosslink material includes, for example, low molecular compounds represented by the formula (3-1) to the formula (3-16), and is preferably a low molecular compound represented by the formula (3-1) to the formula (3-10), more preferably a low molecular compound represented by the formula (3-5) to the formula (3-9).

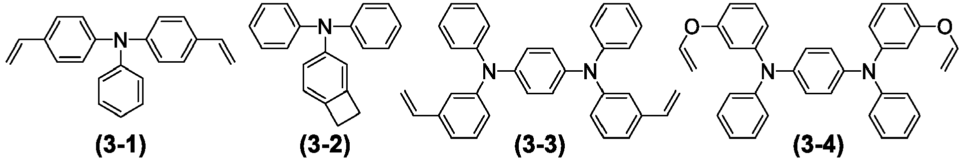

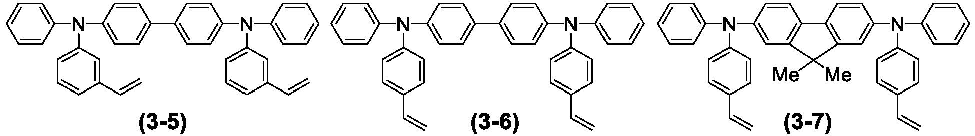

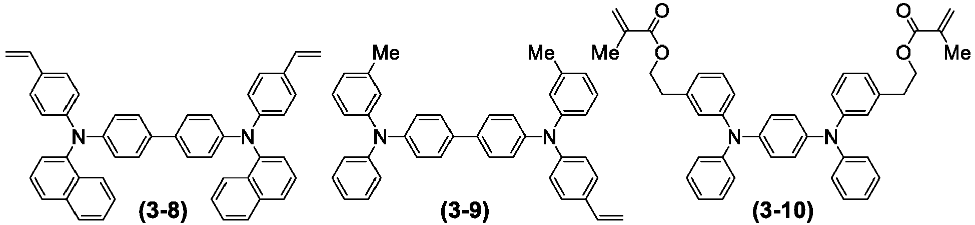

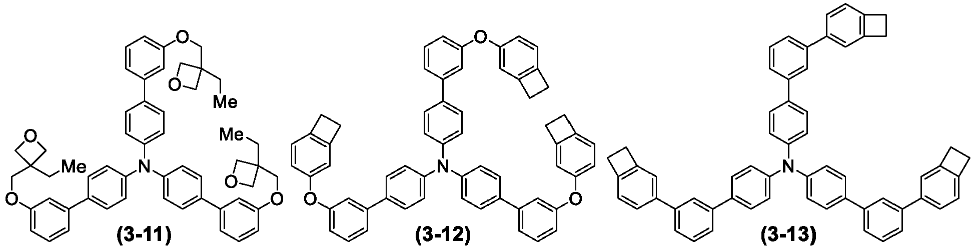

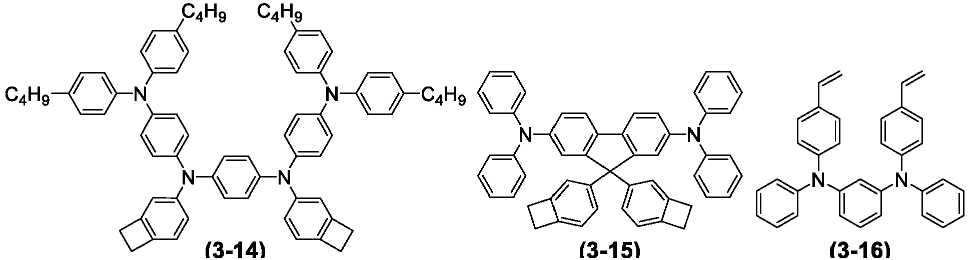

The low molecular compound of the second organic layer is available from Aldrich, Luminescence Technology Corp., American Dye Source and the like. Additionally, the compound can be synthesized according to methods described in, for example, International Publication WO1997/033193, International Publication WO2005/035221 and International Publication WO2005/049548.

In the second organic layer, the crosslinked body of a crosslink material may be contained singly or in combination of two or more kinds thereof.

### [Second composition]

The second organic layer may be a layer containing a composition containing a crosslinked body of a crosslink material and at least one material selected from the group consisting of a hole transporting material, a hole injection material, an electron transporting material, an electron injection material, a light emitting material and an antioxidant (hereinafter, referred to also as "second composition").

The examples and the preferable range of the hole transporting material, the electron transporting material, the hole injection material, the electron injection material and the light emitting material contained in the second composition are the same as the examples and the preferable range of the hole transporting material, the electron transporting material, the hole injection material, the electron injection material and the light emitting material contained in the first composition. In the second composition, the compounding amounts of the hole transporting material, the electron transporting material, the hole injection material, the electron injection material and the light emitting material are each usually 1 to 400 parts by mass, preferably 5 to 150 parts by mass when the amount of the crosslinked body of a crosslink material is taken as 100 parts by mass.

The examples and the preferable range of the antioxidant contained in the second composition are the same as the examples and the preferable range of the antioxidant contained in the first composition. In the second composition, the compounding amount of the antioxidant is usually 0.001 to 10 parts by mass when the amount of the crosslinked body of a crosslink material is taken as 100 parts by mass.

### [Second ink]

A composition containing a crosslink material and a solvent (hereinafter, referred to also as "second ink") can be suitably used in wet methods explained in the section of the first ink. The preferable range of the viscosity of the second ink is the same as the preferable range of the viscosity of the first ink. The examples and the preferable range of the solvent contained in the second ink are the same as the examples and the preferable range of the solvent contained in the first ink.

In the second ink, the compounding amount of the solvent is usually 1000 to 100000 parts by mass, preferably 2000 to 20000 parts by mass when the amount of the crosslink material is taken as 100 parts by mass.

### [Layer constitution of light emitting device]

The light emitting device of the present invention may have layers other than the anode, the cathode, the first organic layer and the second organic layer.

In the light emitting device of the present invention, the first organic layer is usually a light emitting layer (hereinafter, referred to as "first light emitting layer"). The first organic layer is preferably a layer not containing a phosphorescent metal complex. The phosphorescent metal complex is a metal complex showing emission from the triplet excited state at room temperature (25°C).

In the light emitting device of the present invention, the second organic layer is usually a hole transporting layer, a second light emitting layer or an electron transporting layer, preferably a hole transporting layer or a second light emitting layer, more preferably a hole transporting layer.

In the light emitting device of the present invention, it is preferable that the first organic layer and the second organic layer are adjacent, since the light emitting device of the present invention is more excellent in light emission efficiency.

In the light emitting device of the present invention, the second organic layer is preferably a layer disposed between the anode and the first organic layer, more preferably a hole transporting layer or a second light emitting layer disposed between the anode and the first organic layer, further preferably a hole transporting layer disposed between the anode and the first organic layer, since the light emitting device of the present invention is more excellent in light emission efficiency.

In the light emitting device of the present invention, if the second organic layer is a hole transporting layer disposed between the anode and the first organic layer, it is preferable that a hole injection layer is further provided between the anode and the second organic layer, since the light emitting device of the present invention is more excellent in light emission efficiency. If the second organic layer is a hole transporting layer disposed between the anode and the first organic layer, it is preferable that at least one of an electron injection layer and an electron transporting layer is further provided between the cathode and the first organic layer, since the light emitting device of the present invention is more excellent in light emission efficiency.

In the light emitting device of the present invention, if the second organic layer is a second light emitting layer disposed between the anode and the first organic layer, at least one of a hole injection layer and a hole transporting layer is further provided between the anode the second organic layer, since the light emitting device of the present invention is more excellent in light emission efficiency. If the second organic layer is a second light emitting layer disposed between the anode and the first organic layer, it is preferable that at least one of an electron injection layer and an electron transporting layer is further provided between the cathode and the first organic layer, since the light emitting device of the present invention is more excellent in light emission efficiency.

In the light emitting device of the present invention, if the second organic layer is a second light emitting layer disposed between the cathode and the first organic layer, it is preferable that at least one of a hole injection layer and a hole transporting layer is further prodided between the anode and the first organic layer, since the light emitting device of the present invention is more excellent in light emission efficiency. If the second organic layer is a second light emitting layer disposed between the cathode and the first organic layer, it is preferable that at least one of an electron injection layer and an electron transporting layer is further provided between the cathode and the second organic layer, since the light emitting device of the present invention is more excellent in light emission efficiency.

In the light emitting device of the present invention, if the second organic layer is an electron transporting layer disposed between the cathode and the first organic layer, it is preferable that at least one of a hole injection layer and a hole transporting layer is further provided between the anode and the first organic layer, since the light emitting device of the present invention is more excellent in light emission efficiency. If the second organic layer is an electron transporting layer disposed between the cathode and the first organic layer, it is preferable that an electron injection layer is further provided between the cathode and the second organic layer, since the light emitting device of the present invention is more excellent in light emission efficiency.

The specific layer constitution of the light emitting device of the present invention includes, for example, layer constitutions represented by (D1) to (D15) . The light emitting device of the present invention usually has a substrate, and an anode may be first laminated on the substrate, or a cathode may be first laminated on the substrate.
(D1) anode/second light emitting layer (second organic layer)/first light emitting layer (first organic layer)/cathode
(D2) anode/hole transporting layer (second organic layer)/first light emitting layer (first organic layer)/cathode
(D3) anode/hole injection layer/second light emitting layer (second organic layer) /first light emitting layer (first organic layer)/cathode
(D4) anode/hole injection layer/second light emitting layer (second organic layer) /first light emitting layer (first organic layer)/electron transporting layer/cathode
(D5) anode/hole injection layer/second light emitting layer (second organic layer) /first light emitting layer (first organic layer)/electron injection layer/cathode
(D6) anode/hole injection layer/second light emitting layer (second organic layer) /first light emitting layer (first organic layer) /electron transporting layer/electron injection layer/cathode
(D7) anode/hole injection layer/hole transporting layer (second organic layer)/first light emitting layer (first organic layer)/cathode
(D8) anode/hole injection layer/hole transporting layer (second organic layer)/first light emitting layer (first organic layer)/electron transporting layer/cathode
(D9) anode/hole injection layer/hole transporting layer (second organic layer)/first light emitting layer (first organic layer)/electron injection layer/cathode
(D10) anode/hole injection layer/hole transporting layer (second organic layer)/first light emitting layer (first organic layer) /electron transporting layer/electron injection layer/cathode
(D11) anode/hole injection layer/hole transporting layer/second light emitting layer (second organic layer) /first light emitting layer (first organic layer)/electron transporting layer/electron injection layer/cathode
(D12) anode/hole injection layer/hole transporting layer (second organic layer)/first light emitting layer (first organic layer)/second light emitting layer/electron transporting layer/electron injection layer/cathode
(D13) anode/hole injection layer/hole transporting layer/first light emitting layer (first organic layer) /second light emitting layer (second organic layer)/electron transporting layer/electron injection layer/cathode
(D14) anode/hole injection layer/hole transporting layer/first light emitting layer (first organic layer)/electron transporting layer (second organic layer)/electron injection layer/cathode
(D15) anode/hole injection layer/hole transporting layer (second organic layer) /second light emitting layer/first light emitting layer (first organic layer)/electron transporting layer/electron injection layer/cathode

In (D1) to (D15), "/" means that layers before and after it are laminated adjacent to each other. Specifically, "second light emitting layer (second organic layer)/first light emitting layer (first organic layer) " means that a second light emitting layer (second organic layer) and a first light emitting layer (first organic layer) are laminated adjacent to each other.

Layer constitutions represented by (D3) to (D12) are preferable, layer constitutions represented by (D7) to (D10) are more preferable, since the light emitting device of the present invention is more excellent in light emission efficiency.

In the light emitting device of the present invention, two or more layers of the anode, the hole injection layer, the hole transporting layer, the second light emitting layer, the electron transporting layer, the electron injection layer and the cathode may be provided, respectively, as necessary

When a plurality of anodes, hole injection layers, hole transporting layers, second light emitting layers, electron transporting layers, electron injection layers and cathodes are present, they may be the same or different at each occurrence.

The thicknesses of the anode, the hole injection layer, the hole transporting layer, the first light emitting layer, the second light emitting layer, the electron transporting layer, the electron injection layer and the cathode are each usually 1 nm to 1 µm, preferably 2 nm to 500 nm, further preferably 5 nm to 150 nm.

In the light emitting device of the present invention, the order, the number and the thickness of layers to be laminated may be adjusted in consideration of the light emission efficiency, the driving voltage and the device life of the light emitting device.

### [Second light emitting layer]

The second light emitting layer is usually a layer containing a second organic layer and a light emitting material, and preferably a layer containing a light emitting material. When the second light emitting layer is a layer containing a light emitting material, the light emitting material contained in the second light emitting layer includes, for example, light emitting materials which the first composition may contain described above. The light emitting material contained in the second light emitting layer may be contained singly or in combination of two or more kinds thereof.

When the light emitting device of the present invention has a second light emitting layer and when a hole transporting layer described later and an electron transporting layer described later are not a second organic layer, it is preferable that the second light emitting layer is a second organic layer.

### [Hole transporting layer]

The hole transporting layer is usually a layer containing a second organic layer or a hole transporting material, and preferably a second organic layer. When the hole transporting layer is a layer containing a hole transporting material, the hole transporting material includes, for example, hole transporting materials which the first composition may contain described above. The hole transporting material contained in the hole transporting layer may be contained singly or in combination of two or more kinds thereof.

When the light emitting device of the present invention has a hole transporting layer and when a second light emitting layer described above and an electron transporting layer described later are not a second organic layer, it is preferable that the hole transporting layer is a second organic layer.

### [Electron transporting layer]

The electron transporting layer is usually a layer containing a second organic layer or an electron transporting material, and is preferably a layer containing an electron transporting material. When the electron transporting layer is a layer containing an electron transporting material, the electron transporting material contained in the electron transporting layer includes, for example, electron transporting materials which the first composition may contain described above. The electron transporting material contained in the electron transporting layer may be contained singly or in combination of two or more kinds thereof.

When the light emitting device of the present invention has an electron transporting layer and when a second light emitting layer described above and a hole transporting layer described above are not a second organic layer, it is preferable that the electron transporting layer is a second organic layer.

### [Hole injection layer and electron injection layer]

The hole injection layer is a layer containing a hole injection material. The hole injection material contained in the hole injection layer includes, for example, hole injection materials which the first composition may contain described above. The hole injection material contained in the hole injection layer may be contained singly or in combination of two or more kinds thereof.

The electron injection layer is a layer containing an electron injection material. The electron injection material contained in the electron injection layer includes, for example, electron injection materials which the first composition may contain described above. The electron injection material contained in the electron injection layer may be contained singly or in combination of two or more kinds thereof.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; argentine-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

In the light emitting device of the present invention, at least one of the anode and the cathode is usually transparent or semi-transparent, and it is preferable that the anode is transparent or semi-transparent.

The method for forming the anode and the cathode includes, for example, a vacuum vapor deposition method, a sputtering method, an ion plating method, a plating method and a lamination method.

### [Production method of light emitting device]

The method for forming each of the first light emitting layer, the second light emitting layer, the hole transporting layer, the electron transporting layer, the hole injection layer, the electron injection layer and the like in the light emitting device of the present invention includes, when a low molecular compound is used, for example, a method of vacuum vapor deposition from a powder and a method of forming a film from a solution or melted state, and when a polymer compound is used, for example, a method of forming a film from a solution or melted state.

The first light emitting layer, the second light emitting layer, the hole transporting layer, the electron transporting layer, the hole injection layer and the electron injection layer can be formed by application methods such as a spin coat method, an inkjet printing method and the like using the first ink, the second ink, and inks containing the light emitting material, the hole transporting material, the electron transporting material, the hole injection material and the electron injection material described above, respectively.

### [Application of light emitting device]

In order to obtain planar light emission using a light emitting device, the planar anode and the planar cathode may be arranged so as to overlap each other. In order to obtain patterned light emission, there are a method of installing a mask having a patterned window on the surface of a planar light emitting device, a method in which a layer to be formed as a non-light emitting part is formed extremely thick so as to cause substantially non light emission and a method of forming an anode or a cathode, or both electrodes in a pattern. A segment type display capable of displaying numerals, letters and the like can be obtained by forming a pattern by any one of these methods and disposing several electrodes so that several electrodes can be turned on and off independently. In order to obtain a dot matrix display, both the anode and the cathode may be formed in a stripe shape and arranged so as to be orthogonal to each other. Partial color display and multicolor display become possible by a method of separately coating plural kinds of polymer compounds having different emission colors or a method using a color filter or a fluorescence conversion filter. The dot matrix display can be driven passively or can be driven actively in combination with a TFT and the like. These displays can be used for displays of computers, televisions, portable terminals, and the like. The planar light emitting device can be suitably used as a planar light source for backlight of a liquid crystal display, or as a planar light source for illumination. If a flexible substrate is used, it can be used as a curved light source and a curved display.

### EXAMPLES

The present invention will be illustrated further in detail by examples below, but the present invention is not limited to these examples.

In examples, the polystyrene-equivalent number-average molecular weight (Mn) and the polystyrene-equivalent weight-average molecular weight (Mw) of a polymer compound were determined by size exclusion chromatography (SEC) using tetrahydrofuran as a mobile phase. The measurement conditions of SEC are as follows.

A polymer compound to be measured was dissolved at a concentration of about 0.05% by mass in tetrahydrofuran, and 10 µL of the solution was injected into SEC. The mobile phase was run at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

LC-MS was measured by the following method.

A measurement sample was dissolved in chloroform or tetrahydrofucan so as to give a concentration of about 2 mg/mL, and about 1 µL of the solution was injected into LC-MS (manufactured by Agilent, trade name: 1100LCMSD). As the mobile phase for LC-MS, acetonitrile and tetrahydrofuran were used while changing the ratio of them and run at a flow rate of 0.2 mL/min. As the column, L-column 2 ODS (3 µm) (manufactured by Chemical Evaluation and Research Institute, Japan, internal diameter: 2.1 mm, length: 100 mm, particle size: 3 µm) was used.

NMR was measured by the following method.

A measurement sample of 5 to 10 mg was dissolved in about 0.5 mL of deuterated chloroform (CDCl₃), deuterated tetrahydrofuran, deuterated dimethyl sulfoxide, deuterated acetone, deuterated N,N-dimethylformamide, deuterated toluene, deuterated methanol, deuterated ethanol, deuterated 2-propanol or deuterated methylene chloride, and NMR was measured using an NMR apparatus (manufactured by Agilent, trade name: INOVA300 or MERCURY 400VX).

As an indicator of the purity of the compound, the value of high performance liquid chromatography (HPLC) area percentage was used. This value is a value by HPLC (manufactured by Shimadzu Corp., trade name: LC-20A) at UV = 254 nm unless otherwise stated. In this procedure, the compound to be measured was dissolved in tetrahydrofuran or chloroform so as to give a concentration of 0.01 to 0.2% by mass, and the solution was injected into HPLC in an amount of 1 to 10 µL depending on the concentration. As the mobile phase of HPLC, acetonitrile and tetrahydrofuran were used at a ratio of acetonitrile/tetrahydrofuran changing from 100/0 to 0/100 (volume ratio), and the solution was run at a flow rate of 1.0 mL/min. As the column, Kaseisorb LC ODS 2000 (manufactured by Tokyo Chemical Industry Co., Ltd.) or an ODS column having the equivalent performance was used. As the detector, a photo diode array detector (manufactured by Shimadzu Corp., trade name: SPD-M20A) was used.

For calculation of ΔE_{ST} and oscillator strength value of a compound, the structure of the ground state of the compound was optimized by the B3LYP level density functional method, and 6-31G* was used as the basis function in this operation. Using Gaussian09 as a quantum chemical calculation program, ΔE_{ST} and oscillator strength of a compound were calculated by the B3LYP level time-dependent density functional method.

### <Synthesis Examples T1 and T2> Synthesis of compounds T1 and T2

A compound T1 was synthesized as well as a method described in International Publication WO2010/136109.

A compound T2 was synthesized as well as a method described in International Publication WO2007/063754.

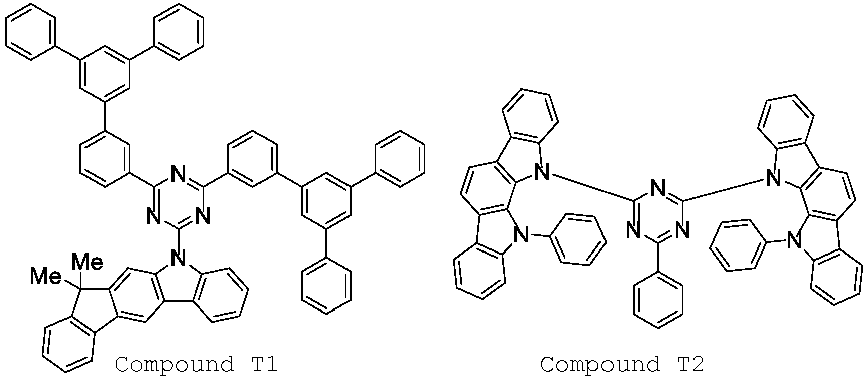

ΔE_{ST} and oscillator strength of the compound T1 were 0.1295 eV and 0.0011, respectively.

ΔE_{ST} and oscillator strength of the compound T2 were 0.1072 eV and 0.0062, respectively.

### <Synthesis Example T3> Synthesis of compound T3

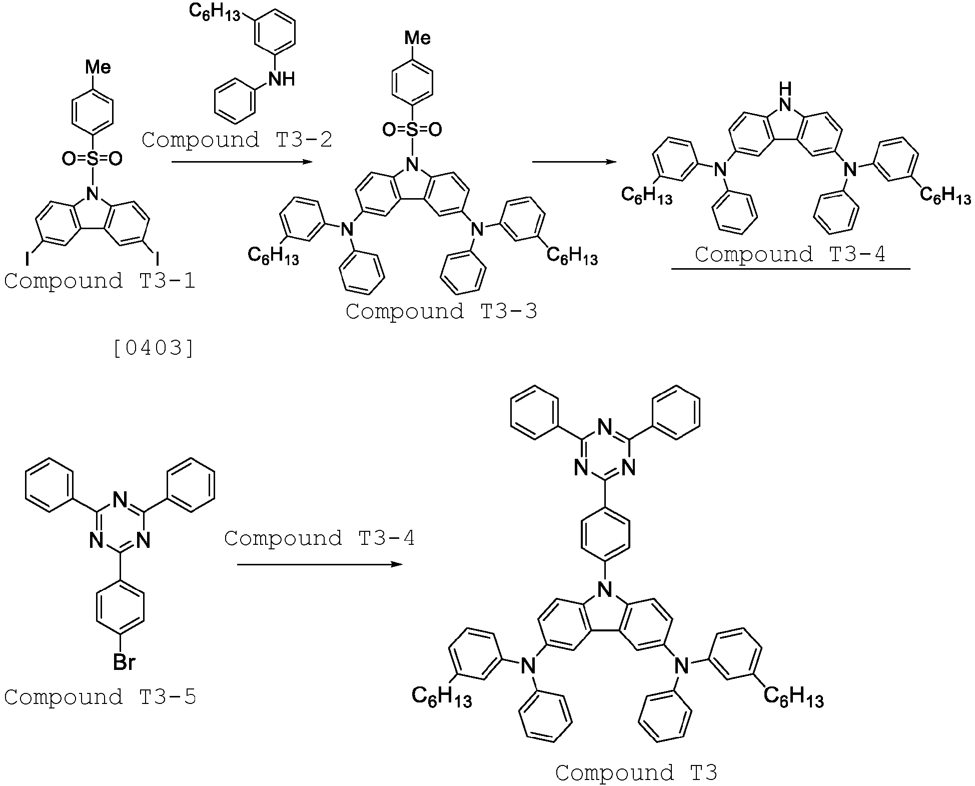

### (Synthesis of compound T3-3)

An argon atmosphere was prepared in a reaction vessel, then, the compound T3-1 (2.5 g), the compound T3-2 (2.8 g), tris(dibenzylideneacetone)dipalladium(0) (0.25 g), tri-tert-butylphosphonium tetrafluoroborate (0.13 g), sodium tert-butoxide (1.3 g) and toluene (75 ml) were added, and stirred at room temperature for 1 hour. Thereafter, to this were added hexane and silica gel, and the mixture was stirred at 50°C, then, filtrated through a filter paved with silica gel. The resultant filtrate was concentrated under reduced pressure, to obtain a solid. The resultant solid was purified by silica gel column chromatography (a mixed solvent of hexane and toluene), then, dried under reduced pressure at 50°C, to obtain a coarse product (3.1 g, brown oil) of a compound T3-3. To the resultant coarse product were added hexane and activated carbon, and the mixture was stirred at room temperature, then, filtrated under reduced pressure. The resultant filtrate was concentrated under reduced pressure, to obtain a compound T3-3 (2.7g, yellow solid). The compound T3-3 had a HPLC area percentage value of 98.5%.

¹H-NMR (CDCl₃, 400 MHz): δ (ppm) = 8.20-8.11 (m, 2H), 7.74-6.85 (m, 26H), 2.50-2.30 (m, 7H), 1.53-0.82 (m,22H).

### (Synthesis of compound T3-4)

A nitrogen atmosphere was prepared in a reaction vessel, then, the compound T3-3 (2.6 g), tetrahydrofuran (26 ml), dimethyl sulfoxide (16 ml) and a 33% by mass potassium hydroxide aqueous solution (5.4 g) were added, and stirred for 6.5 hours under reflux. The resultant mixture was cooled down to room temperature, then, extraction was performed using a mixed solution of ion exchanged water and toluene, and further, the resultant organic layer was washed with ion exchanged water. The resultant organic layer was dried over anhydrous sodium sulfate, then, filtrated, and the resultant filtrate was concentrated under reduced pressure, to obtain a coarse product. The resultant coarse product was purified by silica gel column chromatography (a mixed solvent of hexane and toluene), then, dried under reduced pressure at 50°C, to obtain a compound T3-4 (2.1 g, brown oil). The compound T3-4 had a HPLC area percentage value of 97.6%.

### (Synthesis of compound T3)

A nitrogen atmosphere was prepared in a reaction vessel, then, the compound T3-4 (2.1 g), the compound T3-5 (1.3 g), palladium acetate (0.071 g), tri-tert-butylphosphonium tetrafluoroborate (0.096 g) and xylene (84 ml) were added. Thereafter, to this was added sodium tert-butoxide (0.76 g), and the mixture was stirred at 100°C for 1 hour. The resultant mixture was cooled down to room temperature, then, hexane and silica gel were added and the mixture was stirred at room temperature, then, filtrated through a filter paved with silica gel. The resultant filtrate was concentrated under reduced pressure, to obtain a coarse product. The resultant coarse product was crystallized with a mixed solvent of hexane and ethanol, to obtain a solid. The resultant solid was purified by silica gel column chromatography (a mixed solvent of hexane and toluene), and further, crystallized with a mixed solvent of toluene, ethyl acetate and acetonitrile. The resultant solid was dried under reduced pressure at 50°C, to obtain a compound T3 (1.2 g, yellow solid) . The compound T3 had a HPLC area percentage value of 99.5% or more.

LC-MS (APCI, positive): m/z = 977.5 [M+H]⁺
¹H-NMR (CDCl₃, 400 MHz): δ (ppm) = 9.06-8.98 (m,2H),8.82-8.80(m,4H),7.90-6.80 (m,32H),2.54-2.43 (m,4H),1.53-1.49(m,4H),1.25 (m,12H),0.85-0.83 (m,6H).

ΔE_{ST} and oscillator strength of the compound T3 were 0.1088 eV and 0.1848, respectively.

### <Compounds T4 to T8 and TC1> Synthesis or acquisition of compounds T4 to T8 and TC1

Compounds T4, T5, T6 and TC1 were purchased from Luminescense Technology.

A compound T7 was synthesized as well as a method described in International Publication WO2011/070963.

A compound T8 was synthesized as well as a method described in International Publication WO2008/056746.

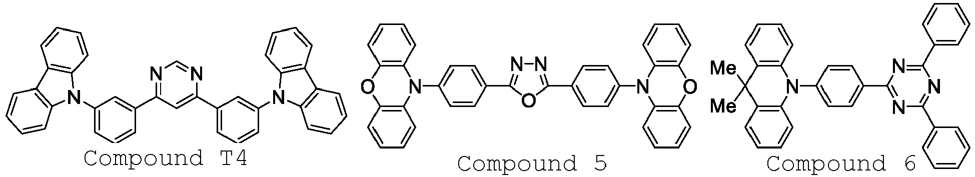

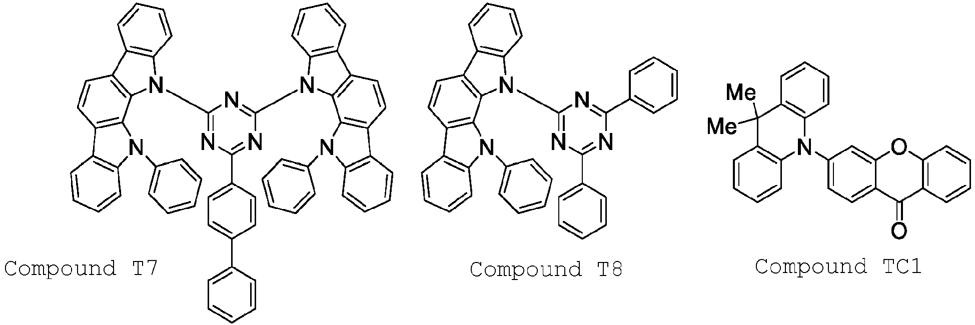

ΔE_{ST} and oscillator strength of the compound T4 were 0.1563 eV and 0.0069, respectively.

ΔE_{ST} and oscillator strength of the compound T5 were 0.0265 eV and 0.0323, respectively.

ΔE_{ST} and oscillator strength of the compound T6 were 0.0065 eV and 0, respectively.

ΔE_{ST} and oscillator strength of the compound T7 were 0.0957eV and 0.0170, respectively.

ΔE_{ST} and oscillator strength of the compound T8 were 0.0659eV and 0.0007, respectively.

ΔE_{ST} and oscillator strength of the compound TC1 were 0.0102 eV and 0, respectively.

### <Fluorescent compounds E1 to E3> Synthesis of or acquisition of fluorescent compounds E1 to E3

A fluorescent compound E1 was synthesized according to a method described in International Publication WO2007/058368.

A fluorescent compound E2 was purchased from Luminescense Technology.

A fluorescent compound E3 was synthesized as well as a method described in JP-A No. 2007-142171.

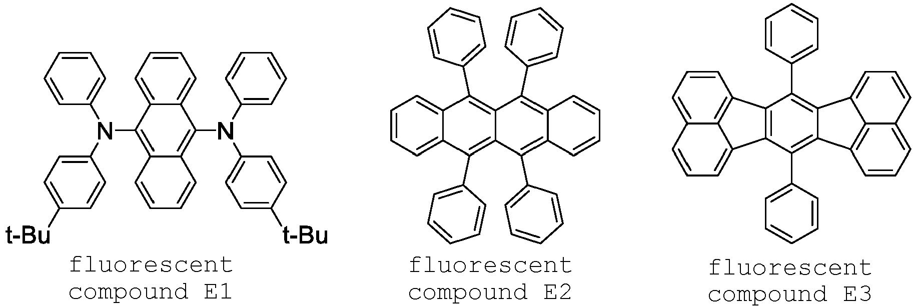

ΔE_{ST} and oscillator strength of the fluorescent compound E1 were 0.7881 eV and 0.1353, respectively.

ΔE_{ST} and oscillator strength of the fluorescent compound E2 were 1.2373 eV and 0.1592, respectively.

ΔE_{ST} and oscillator strength of the fluorescent compound E3 were 0.7002 eV and 0.0161, respectively.

### <Compounds HTL-M1 and HM-1> Acquisition of compounds HTL-M1 and HM-1

Compounds HTL-M1 and HM-1 were purchased from Luminescense Technology.

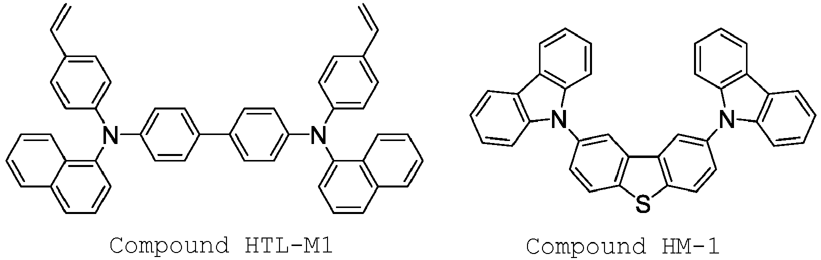

ΔE_{ST} and oscillator strength of the compound HM-1 were 0.2966 eV and 0.0082, respectively.

### <Synthesis Example M1> Synthesis of compounds M1 to M10

A compound M1 was synthesized according to a method described in JP-A No. 2010-189630.

A compound M2 was synthesized according to a method described in International Publication WO2011/049241.

A compound M3 was synthesized according to a method described in International Publication WO2015/145871.

Compounds M4 and M6 were synthesized according to a method described in International Publication WO2013/146806.

A compound M5 was synthesized according to a method described in International Publication WO2005/049546.

Compounds M7 and M9 were synthesized as well as a method described in International Publication WO2002/045184.

A compound M8 was synthesized according to a method described in JP-A No. 2011-174062.

A compound M10 was synthesized according to a method described in JP-A No. 2010-215886.

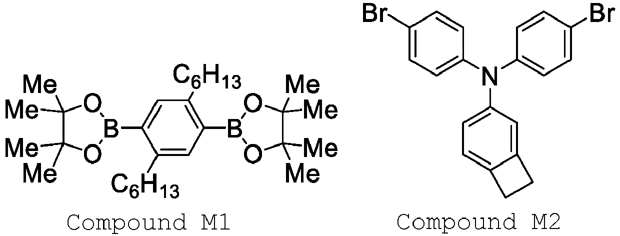

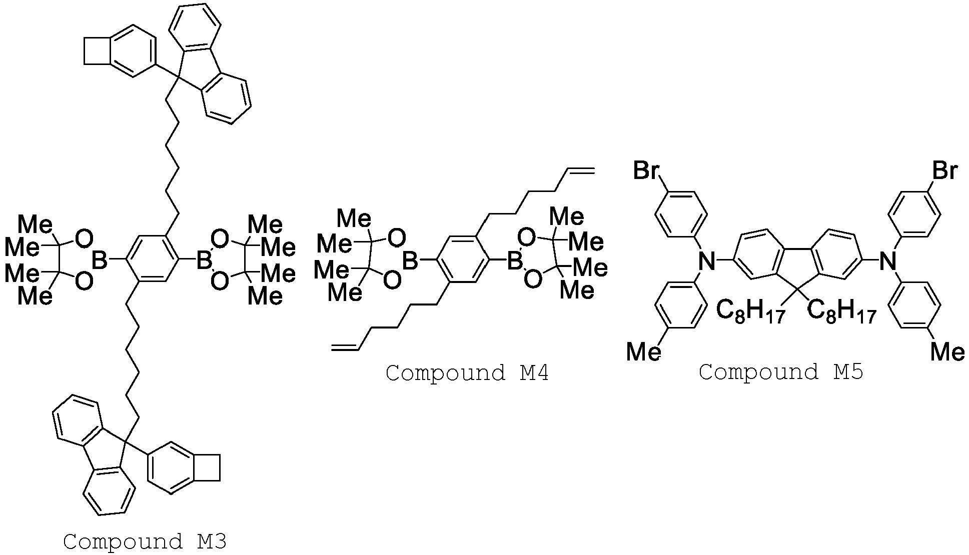

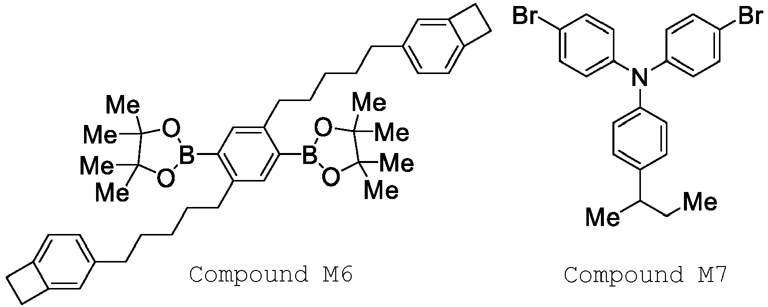

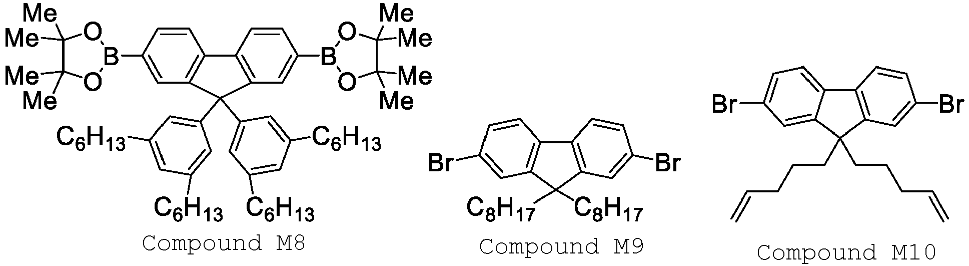

### <Synthesis Example HTL1> Synthesis of polymer compound HTL-1

The polymer compound HTL-1 was synthesized according to a method described in International Publication WO2015/194448 using the compound M1 and the compound M5. The polystyrene-equivalent number-average molecular weight and the polystyrene-equivalent weight-average molecular weight of the polymer compound HTL-1 were Mn = 4.5×10⁴ and Mw = 1.5×10⁵.

The polymer compound HTL-1 is a copolymer constituted of a constitutional unit derived from the compound M1, a constitutional unit derived from the compound M5 at a molar ratio of 50:50 according to the theoretical values determined from the amounts of the charging raw materials.

### <Synthesis Example HTL2> Synthesis of polymer compound HTL-2

The polymer compound HTL-2 was synthesized according to a method described in International Publication WO2013/146806 using the compound M1, the compound M5 and the compound M2. The polymer compound HTL-2 had an Mn of 1.9×10⁴ and an Mw of 9.9×10⁴.

The polymer compound HTL-2 is a copolymer constituted of a constitutional unit derived from the compound M1, a constitutional unit derived from the compound M5, a constitutional unit derived from the compound M2 at a molar ratio of 50:42.5:7.5 according to the theoretical values determined from the amounts of the charging raw materials.

### <Synthesis Example HTL3> Synthesis of polymer compound HTL-3

The polymer compound HTL-3 was synthesized according to a method described in International Publication WO2015/145871 using the compound M3, the compound M4 and the compound M5. The polystyrene-equivalent number-average molecular weight and the polystyrene-equivalent weight-average molecular weight of the polymer compound HTL-3 were Mn = 2.3×10⁴ and Mw = 1.2×10⁵.

The polymer compound HTL-3 is a copolymer constituted of a constitutional unit derived from the compound M3, a constitutional unit derived from the compound M4, a constitutional unit derived from the compound M5 at a molar ratio of 45: 5: 50 according to the theoretical values determined from the amounts of the charging raw materials.

### <Synthesis Example HTL4> Synthesis of polymer compound HTL-4

The polymer compound HTL-4 was synthesized according to a method described in International Publication WO2016/125560 using the compound M6, the compound M4 and the compound M7. The polymer compound HTL-4 had an Mn of 3.6×10⁴ and an Mw of 2.0×10⁵.

The polymer compound HTL-4 is a copolymer constituted of a constitutional unit derived from the compound M6, a constitutional unit derived from the compound M4, a constitutional unit derived from the compound M7 at a molar ratio of 40:10:50 according to the theoretical values determined from the amounts of the charging raw materials.

### <Synthesis Example HTL5> Synthesis of polymer compound HTL-5

The polymer compound HTL-5 was synthesized as well as a method described in JP-A No. 2012-144722 using the compound M8, the compound M5, the compound M9 and the compound M10. The polymer compound HTL-5 had an Mn of 5.0×10⁴ and an Mw of 2.5×10⁵.

The polymer compound HTL-5 is a copolymer constituted of a constitutional unit derived from the compound M8, a constitutional unit derived from the compound M5, a constitutional unit derived from the compound M9, a constitutional unit derived from the compound M10 at a molar ratio of 50:30:12.5:7.5 according to the theoretical values determined from the amounts of the charging raw materials.

### <Example D1> Fabrication and evaluation of light emitting device D1

### (Formation of anode and hole injection layer)

An ITO film was deposited with a thickness of 45 nm on a glass substrate by a sputtering method to form an anode. On the anode, ND-3202 (manufactured by Nissan Chemical Industries, Ltd.) as a hole injection material was spin-coated to form a film with a thickness of 50 nm. Under an air atmosphere, the film was heated at 50°C for 3 minutes, and further, heated at 230°C for 15 minutes, to form a hole injection layer.

### (Formation of second organic layer)

The polymer compound HTL-3 was dissolved at a concentration of 0.6% by mass in xylene. The resultant xylene solution was spin-coated on the hole injection layer, to form a film with a thickness of 20 nm, and the film was heated on a hot plate at 200°C for 30 minutes under a nitrogen gas atmosphere, to form a second organic layer. By this heating, the polymer compound HTL-3 became a crosslinked body.

### (Formation of first organic layer)

The compound T1 and the fluorescent compound E1 (compound T1/fluorescent compound E1 = 70% by mass/30% by mass) were dissolved at a concentration of 2.6% by mass in chlorobenzene. The resultant chlorobenzene solution was spin-coated on the second organic layer to form a film with a thickness of 70 nm, and the film was heated at 130°C for 10 minutes under a nitrogen gas atmosphere, to form a first organic layer.

### (Formation of cathode)

The substrate carrying the first organic layer formed was placed in a vapor deposition machine, and the pressure in the machine was reduced to 1.0×10⁻⁴ Pa or less, then, sodium fluoride was vapor-deposited with a thickness of about 4 nm on the first organic layer, then, aluminum was vapor-deposited with a thickness of about 80 nm on the sodium fluoride layer, as a cathode. After vapor deposition, sealing with a glass substrate was performed, to fabricate a light emitting device D1.

### (Evaluation of light emitting device)

By applying voltage to the light emitting device D1, EL emission was observed. At 100 cd/m², the light emission efficiency was 11.9 cd/A, and the CIE chromaticity coordinate (x, y) = (0.31, 0.63).

### <Example D2> Fabrication and evaluation of light emitting device D2

A light emitting device D2 was fabricated in the same manner as in Example D1 except that "the polymer compound HTL-2" was used instead of "the polymer compound HTL-3" in (Formation of second organic layer) in Example D1.

By applying voltage to the light emitting device D2, EL emission was observed. At 100 cd/m², the light emission efficiency was 8.7 cd/A, and the CIE chromaticity coordinate (x,y) = (0.30, 0.64).

### <Example D3> Fabrication and evaluation of light emitting device D3

A light emitting device D3 was fabricated in the same manner as in Example D1 except that "the compound HTL-M1" was used instead of "the polymer compound HTL-3" in (Formation of second organic layer) in Example D1.

By applying voltage to the light emitting device D3, EL emission was observed. At 100 cd/m², the light emission efficiency was 12.1 cd/A, and the CIE chromaticity coordinate (x, y) = (0.29, 0.64).

### <Example D4> Fabrication and evaluation of light emitting device D4

A light emitting device D4 was fabricated in the same manner as in Example D1 except that "the compound T1 and the fluorescent compound E1 (compound T1/fluorescent compound E1 = 80% by mass/20% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D4, EL emission was observed. At 100 cd/m², the light emission efficiency was 12.5 cd/A, and the CIE chromaticity coordinate (x,y) = (0.31,0.63).

### <Example D5> Fabrication and evaluation of light emitting device D5

A light emitting device D5 was fabricated in the same manner as in Example D1 except that "the polymer compound HTL-2" was used instead of "the polymer compound HTL-3" in (Formation of second organic layer) in Example D1, and "the compound T1 and the fluorescent compound E1 (compound T1/fluorescent compound E1 = 80% by mass/20% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D5, EL emission was observed. At 100 cd/m², the light emission efficiency was 11.8 cd/A, and the CIE chromaticity coordinate (x,y) = (0.30, 0.63).

### <Example D6> Fabrication and evaluation of light emitting device D6

A light emitting device D6 was fabricated in the same manner as in Example D1 except that "the polymer compound HTL-2" was used instead of "the polymer compound HTL-3" in (Formation of second organic layer) in Example D1, and "the compound T1 and the fluorescent compound E1 (compound T1/fluorescent compound E1 = 90% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D6, EL emission was observed. At 100 cd/m², the light emission efficiency was 10.8 cd/A, and the CIE chromaticity coordinate (x, y) = (0.32, 0.62).

### <Example D7> Fabrication and evaluation of light emitting device D7

A light emitting device D7 was fabricated in the same manner as in Example D1 except that "the polymer compound HTL-4" was used instead of "the polymer compound HTL-3" in (Formation of second organic layer) in Example D1, and "the compound T1 and the fluorescent compound E1 (compound T1/fluorescent compound E1 = 90% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D7, EL emission was observed. At 100 cd/m², the light emission efficiency was 12.0 cd/A, and the CIE chromaticity coordinate (x, y) = (0.29, 0.63) .

### <Comparative Example CD1> Fabrication and evaluation of light emitting device CD1

A light emitting device CD1 was fabricated in the same manner as in Example D1 except that "the polymer compound HTL-1" was used instead of "the polymer compound HTL-3" in (Formation of second organic layer) in Example D1. By applying voltage to the light emitting device CD1, EL emission was observed. At 100 cd/m², the light emission efficiency was 3.5 cd/A, and the CIE chromaticity coordinate (x,y) = (0.30,0.64).

**[Table 2]**

| | light emitting device | second organic layer | first organic layer | | light emission efficiency (cd/A) (100 cd/m²) |
|---|---|---|---|---|---|
| | | | composition | composition ratio (% by mass) | |
| Example D1 | D1 | crosslinked body of HTL-3 | T1/E1 | 70/30 | 11.9 |
| Example D2 | D2 | crosslinked body of HTL-2 | T1/E1 | 70/30 | 8.7 |
| Example D3 | D3 | crosslinked body of HTL-M1 | T1/E1 | 70/30 | 12.1 |
| Example D4 | D4 | crosslinked body of HTL-3 | T1/E1 | 80/20 | 12.5 |
| Example D5 | D5 | crosslinked body of HTL-2 | T1/E1 | 80/20 | 11.8 |
| Example D6 | D6 | crosslinked body of HTL-2 | T1/E1 | 90/10 | 10.8 |
| Example D7 | D7 | crosslinked body of HTL-4 | T1/E1 | 90/10 | 12.0 |
| Comparative Example CD1 | CD1 | HTL-1 | T1/E1 | 70/30 | 3.5 |

### <Example D8> Fabrication and evaluation of light emitting device D8

A light emitting device D8 was fabricated in the same manner as in Example D1 except that "the polymer compound HTL-2" was used instead of "the polymer compound HTL-3" in (Formation of second organic layer) in Example D1, and "the compound HM1, the compound T1 and the fluorescent compound E1 (compound HM1/compound T1/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D8, EL emission was observed. At 100 cd/m², the light emission efficiency was 11.7 cd/A, and the CIE chromaticity coordinate (x,y) = (0.29, 0.64).

### <Example D9> Fabrication and evaluation of light emitting device D9

A light emitting device D9 was fabricated in the same manner as in Example D8 except that "the compound HM1, the compound T2 and the fluorescent compound E1 (compound HM1/compound T2/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D8.

By applying voltage to the light emitting device D9, EL emission was observed. At 100 cd/m², the light emission efficiency was 13.7 cd/A, and the CIE chromaticity coordinate (x,y) = (0.29, 0.64).

### <Example D10> Fabrication and evaluation of light emitting device D10

A light emitting device D10 was fabricated in the same manner as in Example D8 except that "the compound HM1, the compound T3 and the fluorescent compound E1 (compound HM1/compound T3/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D8.

By applying voltage to the light emitting device D10, EL emission was observed. At 100 cd/m², the light emission efficiency was 15.4 cd/A, and the CIE chromaticity coordinate (x,y) = (0.31,0.63).

### <Example D11> Fabrication and evaluation of light emitting device D11

A light emitting device D11 was fabricated in the same manner as in Example D8 except that "the compound HM1, the compound T4 and the fluorescent compound E1 (compound HM1/compound T4/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D8.

By applying voltage to the light emitting device D11, EL emission was observed. At 100 cd/m², the light emission efficiency was 11.7 cd/A, and the CIE chromaticity coordinate (x,y) = (0.29, 0.64).

### <Example D12> Fabrication and evaluation of light emitting device D12

A light emitting device D12 was fabricated in the same manner as in Example D8 except that "the compound HM1, the compound T5 and the fluorescent compound E1 (compound HM1/compound T5/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D8.

By applying voltage to the light emitting device D12, EL emission was observed. At 100 cd/m², the light emission efficiency was 9.6 cd/A, and the CIE chromaticity coordinate (x,y) = (0.29, 0.64).

### <Example D13> Fabrication and evaluation of light emitting device D13

A light emitting device D13 was fabricated in the same manner as in Example D8 except that "the compound HM1, the compound T6 and the fluorescent compound E1 (compound HM1/compound T6/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D8.

By applying voltage to the light emitting device D13, EL emission was observed. At 100 cd/m², the light emission efficiency was 13.2 cd/A, and the CIE chromaticity coordinate (x,y) = (0.29, 0.64).

### <Example D14> Fabrication and evaluation of light emitting device D14

A light emitting device D14 was fabricated in the same manner as in Example D1 except that "the compound HM1, the compound T1 and the fluorescent compound E1 (compound HM1/compound T1/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D14, EL emission was observed. At 100 cd/m², the light emission efficiency was 12.2 cd/A, and the CIE chromaticity coordinate (x,y) = (0.29, 0.64).

### <Example D15> Fabrication and evaluation of light emitting device D15

A light emitting device D15 was fabricated in the same manner as in Example D1 except that "the compound HM1, the compound T2 and the fluorescent compound E1 (compound HM1/compound T2/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D15, EL emission was observed. At 100 cd/m², the light emission efficiency was 15.9 cd/A, and the CIE chromaticity coordinate (x,y) = (0.29, 0.64).

### <Example D16> Fabrication and evaluation of light emitting device D16

A light emitting device D16 was fabricated in the same manner as in Example D1 except that "the compound HM1, the compound T4 and the fluorescent compound E1 (compound HM1/compound T4/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D16, EL emission was observed. At 100 cd/m², the light emission efficiency was 14.1 cd/A, and the CIE chromaticity coordinate (x,y) = (0.29, 0.64).

### <Example D17> Fabrication and evaluation of light emitting device D17

A light emitting device D17 was fabricated in the same manner as in Example D1 except that "the compound HM1, the compound T5 and the fluorescent compound E1 (compound HM1/compound T5/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D17, EL emission was observed. At 100 cd/m², the light emission efficiency was 10.6 cd/A, and the CIE chromaticity coordinate (x,y) = (0.29, 0.64).

### <Example D18> Fabrication and evaluation of light emitting device D18

A light emitting device D18 was fabricated in the same manner as in Example D1 except that "the compound HM1, the compound T6 and the fluorescent compound E1 (compound HM1/compound T6/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D18, EL emission was observed. At 100 cd/m², the light emission efficiency was 16.0 cd/A, and the CIE chromaticity coordinate (x,y) = (0.29, 0.64).

### <Example D19> Fabrication and evaluation of light emitting device D19

A light emitting device D19 was fabricated in the same manner as in Example D1 except that "the compound HM1, the compound T8 and the fluorescent compound E1 (compound HM1/compound T8/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D19, EL emission was observed. At 100 cd/m², the light emission efficiency was 13.9 cd/A, and the CIE chromaticity coordinate (x,y) = (0.29, 0.64).

### <Example D20> Fabrication and evaluation of light emitting device D20

A light emitting device D20 was fabricated in the same manner as in Example D1 except that "the compound HM1, the compound T3 and the fluorescent compound E1 (compound HM1/compound T3/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D20, EL emission was observed. At 100 cd/m², the light emission efficiency was 19.8 cd/A, and the CIE chromaticity coordinate (x,y) = (0.31,0.63).

### <Example D21> Fabrication and evaluation of light emitting device D21

A light emitting device D21 was fabricated in the same manner as in Example D1 except that "the compound HM1, the compound T3 and the fluorescent compound E1 (compound HM1/compound T3/fluorescent compound E1 = 82% by mass/15% by mass/3% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D21, EL emission was observed. At 100 cd/m², the light emission efficiency was 27.4 cd/A, and the CIE chromaticity coordinate (x, y) = (0.31, 0.61).

### <Example D22> Fabrication and evaluation of light emitting device D22

A light emitting device D22 was fabricated in the same manner as in Example D1 except that "the compound HM1, the compound T3 and the fluorescent compound E1 (compound HM1/compound T3/fluorescent compound E1 = 84% by mass/15% by mass/1% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D22, EL emission was observed. At 100 cd/m², the light emission efficiency was 31.8 cd/A, and the CIE chromaticity coordinate (x,y) = (0.32, 0.60).

### <Example D23> Fabrication and evaluation of light emitting device D23

A light emitting device D23 was fabricated in the same manner as in Example D1 except that "the polymer compound HTL-5" was used instead of "the polymer compound HTL-3" in (Formation of second organic layer) in Example D1, and "the compound HM1, the compound T1 and the fluorescent compound E1 (compound HM1/compound T1/fluorescent compound E1 = 75% by mass/15% by mass/10% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device D23, EL emission was observed. At 100 cd/m², the light emission efficiency was 10.1 cd/A, and the CIE chromaticity coordinate (x,y) = (0.29, 0.64).

### <Example D24> Fabrication and evaluation of light emitting device D24

A light emitting device D24 was fabricated in the same manner as in Example D23 except that "the compound HM1, the compound T3 and the fluorescent compound E1 (compound HM1/compound T3/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D23.

By applying voltage to the light emitting device D24, EL emission was observed. At 100 cd/m², the light emission efficiency was 11.4 cd/A, and the CIE chromaticity coordinate (x,y) = (0.31,0.63).

### <Comparative Example CD2> Fabrication and evaluation of light emitting device CD2

A light emitting device CD2 was fabricated in the same manner as in Example D23 except that "the compound HM1, the compound TC1 and the fluorescent compound E1 (compound HM1/compound TC1/fluorescent compound E1 = 75% by mass/15% by mass/10% by mass) " were used instead of "the compound HM1, the compound T1 and the fluorescent compound E1 (compound HM1/compound T1/fluorescent compound E1 = 75% by mass/15% by mass/10% by mass)" in (Formation of first organic layer) in Example D23.

By applying voltage to the light emitting device CD2, EL emission was observed. At 100 cd/m², the light emission efficiency was 7.5 cd/A, and the CIE chromaticity coordinate (x,y) = (0.29, 0.64).

**[Table 3]**

| | light emitting device | second organic layer | first organic layer | | light emission efficiency (cd/A) (100 cd/m²) |
|---|---|---|---|---|---|
| | | | composition | composition ratio (% by mass) | |
| Example D8 | D8 | crosslinked body of HTL-2 | HM-1/T1/E1 | 75/15/10 | 11.7 |
| Example D9 | D9 | crosslinked body of HTL-2 | HM-1/T2/E1 | 75/15/10 | 13.7 |
| Example D10 | D10 | crosslinked body of HTL-2 | HM-1/T3/E1 | 75/15/10 | 15.4 |
| Example D11 | D11 | crosslinked body of HTL-2 | HM-1/T4/E1 | 75/15/10 | 11.7 |
| Example D12 | D12 | crosslinked body of HTL-2 | HM-1/T5/E1 | 75/15/10 | 9.6 |
| Example D13 | D13 | crosslinked body of HTL-2 | HM-1/T6/E1 | 75/15/10 | 13.2 |
| Example D14 | D14 | crosslinked body of HTL-3 | HM-1/T1/E1 | 75/15/10 | 12.2 |
| Example D15 | D15 | crosslinked body of HTL-3 | HM-1/T2/E1 | 75/15/10 | 15.9 |
| Example D16 | D16 | crosslinked body of HTL-3 | HM-1/T4/E1 | 75/15/10 | 14.1 |
| Example D17 | D17 | crosslinked body of HTL-3 | HM-1/T5/E1 | 75/15/10 | 10.6 |
| Example D18 | D18 | crosslinked body of HTL-3 | HM-1/T6/E1 | 75/15/10 | 16.0 |
| Example D19 | D19 | crosslinked body of HTL-3 | HM-1/T8/E1 | 75/15/10 | 13.9 |
| Example D20 | D20 | crosslinked body of HTL-3 | HM-1/T3/E1 | 75/15/10 | 19.8 |
| Example D21 | D21 | crosslinked body of HTL-3 | HM-1/T3/E1 | 82/15/3 | 27.4 |
| Example D22 | D22 | crosslinked body of HTL-3 | HM-1/T3/E1 | 84/15/1 | 31.8 |
| Example D23 | D23 | crosslinked body of HTL-5 | HM-1/T1/E1 | 75/15/10 | 10.1 |
| Example D24 | D24 | crosslinked body of HTL-5 | HM-1/T3/E1 | 75/15/10 | 11.4 |
| Comparative Example CD2 | CD2 | crosslinked body of HTL-5 | HM-1/TC1/E1 | 75/15/10 | 7.5 |

### <Example D25> Fabrication and evaluation of light emitting device D25

A light emitting device D25 was fabricated in the same manner as in Example D1 except that "the compound HM1, the compound T6 and the fluorescent compound E2 (compound HM1/compound T6/fluorescent compound E2 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D25, EL emission was observed. At 50 cd/m², the light emission efficiency was 10.1 cd/A, and the CIE chromaticity coordinate (x,y) = (0.49, 0.50).

### <Example D26> Fabrication and evaluation of light emitting device D26

A light emitting device D26 was fabricated in the same manner as in Example D1 except that "the compound HM1, the compound T1 and the fluorescent compound E2 (compound HM1/compound T1/fluorescent compound E2 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D26, EL emission was observed. At 50 cd/m², the light emission efficiency was 8.1 cd/A, and the CIE chromaticity coordinate (x,y) = (0.49, 0.50).

### <Example D27> Fabrication and evaluation of light emitting device D27

A light emitting device D27 was fabricated in the same manner as in Example D1 except that "the compound HM1, the compound T7 and the fluorescent compound E2 (compound HM1/compound T7/fluorescent compound E2 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D27, EL emission was observed. At 50 cd/m², the light emission efficiency was 7.5 cd/A, and the CIE chromaticity coordinate (x,y) = (0.49, 0.50).

### <Example D28> Fabrication and evaluation of light emitting device D28

A light emitting device D28 was fabricated in the same manner as in Example D1 except that "the compound HM1, the compound T3 and the fluorescent compound E2 (compound HM1/compound T3/fluorescent compound E2 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D28, EL emission was observed. At 50 cd/m², the light emission efficiency was 5.8 cd/A, and the CIE chromaticity coordinate (x,y) = (0.49, 0.50).

### <Example D29> Fabrication and evaluation of light emitting device D29

A light emitting device D29 was fabricated in the same manner as in Example D1 except that "the compound T1 and the fluorescent compound E2 (compound T1/fluorescent compound E2 = 70% by mass/30% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D29, EL emission was observed. At 50 cd/m², the light emission efficiency was 2.8 cd/A, and the CIE chromaticity coordinate (x,y) = (0.50,0.50).

### <Comparative Example CD3> Fabrication and evaluation of light emitting device CD3

A light emitting device CD3 was fabricated in the same manner as in Example D1 except that "the polymer compound HTL-1" was used instead of "the polymer compound HTL-3" in (Formation of second organic layer) in Example D1, and further, "the compound T1 and the fluorescent compound E2 (compound T1/fluorescent compound E2 = 70% by mass/30% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device CD3, EL emission was observed. At 50 cd/m², the light emission efficiency was 0.8 cd/A, and the CIE chromaticity coordinate (x,y) = (0.50,0.50).

**[Table 4]**

| | light emitting device | second organic layer | first organic layer | | light emission efficiency (cd/A) (50 cd/m²) |
|---|---|---|---|---|---|
| | | | composition | composition ratio (% by mass) | |
| Example D25 | D25 | crosslinked body of HTL-3 | HM-1/T6/E2 | 75/20/5 | 10.1 |
| Example D26 | D26 | crosslinked body of HTL-3 | HM-1/T1/E2 | 75/20/5 | 8.1 |
| Example D27 | D27 | crosslinked body of HTL-3 | HM-1/T7/E2 | 75/20/5 | 7.5 |
| Example D28 | D28 | crosslinked body of HTL-3 | HM-1/T3/E2 | 75/20/5 | 5.8 |
| Example D29 | D29 | crosslinked body of HTL-3 | T1/E2 | 70/30 | 2.8 |
| Comparative Example CD3 | CD3 | HTL-1 | T1/E2 | 70/30 | 0.8 |

### <Example D30> Fabrication and evaluation of light emitting device D30

A light emitting device D30 was fabricated in the same manner as in Example D1 except that "the compound HM1, the compound T6 and the fluorescent compound E3 (compound HM1/compound T6/fluorescent compound E3 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D30, EL emission was observed. At 50 cd/m², the light emission efficiency was 5.3 cd/A, and the CIE chromaticity coordinate (x, y) = (0.26, 0.51).

### <Example D31> Fabrication and evaluation of light emitting device D31

A light emitting device D31 was fabricated in the same manner as in Example D1 except that "the compound HM1, the compound T1 and the fluorescent compound E3 (compound HM1/compound T1/fluorescent compound E3 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D31, EL emission was observed. At 50 cd/m², the light emission efficiency was 4.0 cd/A, and the CIE chromaticity coordinate (x, y) = (0.26, 0.50).

### <Example D32> Fabrication and evaluation of light emitting device D32

A light emitting device D32 was fabricated in the same manner as in Example D1 except that "the compound HM1, the compound T7 and the fluorescent compound E3 (compound HM1/compound T7/fluorescent compound E3 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D32, EL emission was observed. At 50 cd/m², the light emission efficiency was 4.4 cd/A, and the CIE chromaticity coordinate (x,y) = (0.25, 0.49).

### <Example D33> Fabrication and evaluation of light emitting device D33

A light emitting device D33 was fabricated in the same manner as in Example D1 except that "the compound HM1, the compound T3 and the fluorescent compound E3 (compound HM1/compound T3/fluorescent compound E3 = 75% by mass/20% by mass/5% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D33, EL emission was observed. At 50 cd/m², the light emission efficiency was 8.0 cd/A, and the CIE chromaticity coordinate (x,y) = (0.33, 0.57).

### <Example D34> Fabrication and evaluation of light emitting device D34

A light emitting device D34 was fabricated in the same manner as in Example D1 except that "the compound T1 and the fluorescent compound E3 (compound T1/fluorescent compound E3 = 70% by mass/30% by mass) " were used instead of "the compound T1 and the fluorescent compound E1 (compound T1/fluorescent compound E1 = 70% by mass/30% by mass) " in (Formation of first organic layer) in Example D1.

By applying voltage to the light emitting device D34, EL emission was observed. At 50 cd/m², the light emission efficiency was 1.8 cd/A, and the CIE chromaticity coordinate (x,y) = (0.40, 0.53).

### <Comparative Example CD4> Fabrication and evaluation of light emitting device CD4

A light emitting device CD4 was fabricated in the same manner as in Example D1 except that "the polymer compound HTL-1" was used instead of "the polymer compound HTL-3" in (Formation of second organic layer) in Example D1, and "the compound T1 and the fluorescent compound E3 (compound T1/fluorescent compound E3 = 70% by mass/30% by mass)" were used instead of "the compound T1 and the fluorescent compound E1 (compound T1/fluorescent compound E1 = 70% by mass/30% by mass)" in (Formation of first organic layer) in Example D1.

By applying voltage to the light emitting device CD4, EL emission was observed. At 50 cd/m², the light emission efficiency was 0.6 cd/A, and the CIE chromaticity coordinate (x,y) = (0.37, 0.52).

**[Table 5]**

| | light emitting device | second organic layer | first organic layer | | light emission efficiency (cd/A) (50 cd/m²) |
|---|---|---|---|---|---|
| | | | composition | composition ratio (% by mass) | |
| Example D30 | D30 | crosslinked body of HTL-3 | HM-1/T6/E3 | 75/20/5 | 5.3 |
| Example D31 | D31 | crosslinked body of HTL-3 | HM-1/T1/E3 | 75/20/5 | 4.0 |
| Example D32 | D32 | crosslinked body of HTL-3 | HM-1/T7/E3 | 75/20/5 | 4.4 |
| Example D33 | D33 | crosslinked body of HTL-3 | HM-1/T3/E3 | 75/20/5 | 8.0 |
| Example D34 | D34 | crosslinked body of HTL-3 | T1/E3 | 70/30 | 1.8 |
| Comparative Example CD4 | CD4 | HTL-1 | T1/E3 | 70/30 | 0.6 |

### Industrial Applicability

According to the present invention, it is possible to provide a light emitting device excellent in light emission efficiency.

## Claims

1. A light emitting device having an anode, a cathode, a first organic layer disposed between the anode and the cathode and a second organic layer disposed between the anode and the cathode, wherein
said first organic layer is a layer containing a compound represented by the formula (T) and a fluorescent compound represented by the formula (B),
said second organic layer is a layer containing a crosslinked body of a crosslink material,
the absolute value of the difference between the energy level at the lowest triplet excited state and the energy level at the lowest singlet excited state of said compound represented by the formula (T) is 0.50 eV or less,
the absolute value of the difference between the energy level at the lowest triplet excited state and the energy level at the lowest singlet excited state of said fluorescent compound represented by the formula (B) is 0.55 eV or more and 2.5 eV or less,
the compound represented by the formula (T) is a host material having at least one function selected from the group consisting of hole injectability, hole transportability, electron injectability and electron transportability,
the fluorescent compound represented by the formula (B) is a light emitting material, and
the lowest excited triplet state of the host material is at an energy level higher than that of the lowest excited triplet state of the light emitting material, and the lowest excited singlet state of the host material is at an energy level that is higher than the lowest excited singlet state of the light emitting material,
wherein the energy level at the lowest triplet excited state and the energy level at the lowest singlet excited state of a compound are calculated by optimizing the structure of the ground state of the compound with the B3LYP level density functional method and using 6-31G* as the basis function in this operation, using Gaussian09 as a quantum chemical calculation program and the B3LYP level time-dependent density functional method, and, when an atom for which 6-31G* cannot be used is contained, using LANL2DZ for the atom: 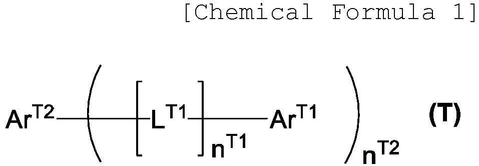 wherein,
n^{T1} represents an integer of 0 or more and 5 or less, when a plurality of n^{T1} are present, they may be the same or different,
n^{T2} represents an integer of 1 or more and 10 or less,
Ar^{T1} is a single-ring or condensed-ring monovalent hetero ring group containing a nitrogen atom having no double bond as a ring constituent atom and not containing a nitrogen atom having a double bond as a ring constituent atom, and the group optionally has a substituent, when a plurality of such substituents are present, they may be combined together to form a ring together with atoms to which they are attached, when a plurality of Ar^{T1} are present, they may be the same or different,
L^{T1} represents an alkylene group, a cycloalkylene group, an arylene group, a divalent hetero ring group, a group represented by -N(R^{T1'})-, an oxygen atom or a sulfur atom, and these groups optionally have a substituent, R^{T1'} represents a hydrogen atom, an alkyl group, a cycloalkyl group, an aryl group or a monovalent hetero ring group, and these groups optionally have a substituent, when a plurality of L^{T1} are present, they may be the same or different,
Ar^{T2} is a single-ring or condensed-ring hetero ring group containing a nitrogen atom having a double bond as a ring constituent atom, and the group optionally has a substituent, when a plurality of such substituents are present, they may be combined together to form a ring together with atoms to which they are attached,
[Chemical Formula 2]
**Ar^{1B}(̵R^{1B})**_{n1B} **(B)**
wherein,
n^{1B} represents an integer of 0 or more and 15 or less,
Ar^{1B} represents a condensed-ring aromatic hydrocarbon group, and these groups optionally have a substituent, when a plurality of such substituents are present, they may be combined together to form a ring together with atoms to which they are attached,
R^{1B} represents an alkyl group, a cycloalkyl group, an alkoxy group, a cycloalkoxy group, an aryl group, a monovalent hetero ring group, a substituted amino group, an alkenyl group, a cycloalkenyl group, an alkynyl group or a cycloalkynyl group, and these groups optionally have a substituent, and when a plurality of R^{1B} are present, they may be the same or different and may be combined together to form a ring together with carbon atoms to which they are attached.

2. The light emitting device according to Claim 1, wherein
said Ar^{1B} is a group obtained by removing from a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring at least one hydrogen atom bonding directly to a carbon atom constituting the ring, the group optionally having a substituent.

3. The light emitting device according to Claim 1 or 2, wherein
said R^{1B} is an alkyl group, an aryl group or a substituted amino group, these groups optionally having a substituent.

4. The light emitting device according to any one of Claims 1 to 3, wherein
said crosslink material is a low molecular compound having at least one crosslink group selected from Group A of crosslink group or a polymer compound containing a crosslink constitutional unit having at least one crosslink group selected from Group A of crosslink group:
(Group A of crosslink group) 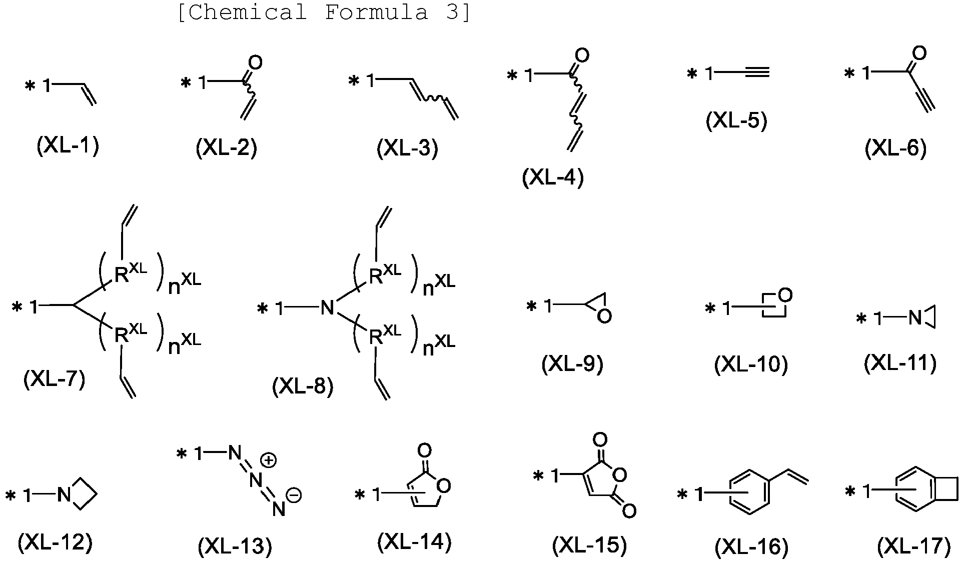 wherein, R^{XL} represents a methylene group, an oxygen atom or a sulfur atom and n^{XL} represents an integer of 0 to 5, when a plurality of R^{XL} are present, they may be the same or different and when a plurality of n^{XL} are present, they may be the same or different, *1 represents a binding position, and these crosslink groups optionally have a substituent.

5. The light emitting device according to Claim 4, wherein
said crosslink material is a polymer compound containing a crosslink constitutional unit having at least one crosslink group selected from said Group A of crosslink group and
said crosslink constitutional unit is a constitutional unit represented by the formula (2) or a constitutional unit represented by the formula (2'): 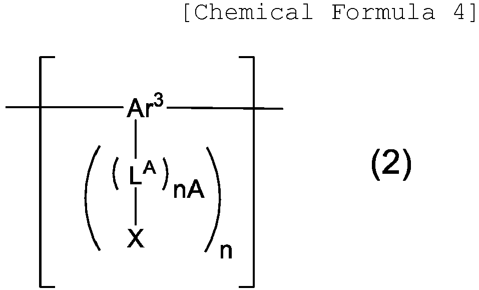 wherein,
nA represents an integer of 0 to 5, and n represents 1 or 2, when a plurality of nA are present, they may be the same or different,
Ar³ represents an aromatic hydrocarbon group or a hetero ring group, and these groups optionally have a substituent,
L^{A} represents an alkylene group, a cycloalkylene group, an arylene group, a divalent hetero ring group, a group represented by -N(R')-, an oxygen atom or a sulfur atom, and these groups optionally have a substituent, R' represents a hydrogen atom, an alkyl group, a cycloalkyl group, an aryl group or a monovalent hetero ring group, and these groups optionally have a substituent, when a plurality of L^{A} are present, they may be the same or different,
X represents a crosslink group selected from said Group A of crosslink group, when a plurality of X are present, they may be the same or different, 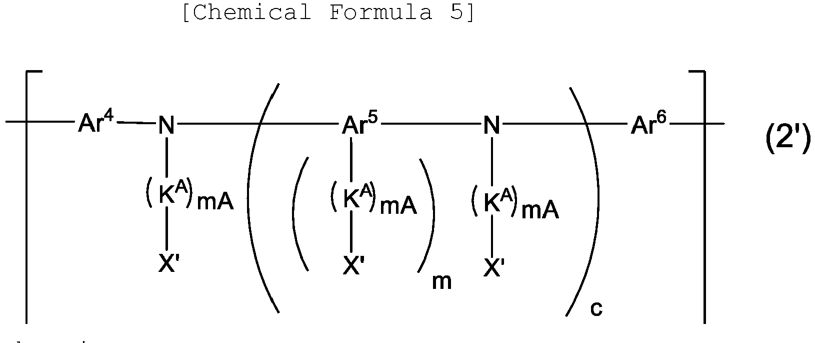
wherein,
mA represents an integer of 0 to 5, m represents an integer of 1 to 4 and c represents an integer of 0 or 1, when a plurality of mA are present, they may be the same or different,
Ar⁵ represents an aromatic hydrocarbon group, a hetero ring group or a group in which at least one aromatic hydrocarbon ring and at least one hetero ring are bonded directly, and these groups optionally have a substituent,
Ar⁴ and Ar⁶ each independently represent an arylene group or a divalent hetero ring group, and these groups optionally have a substituent,
Ar⁴, Ar⁵ and Ar⁶ each may be bonded directly or bonded via an oxygen atom or a sulfur atom to a group other than this group, bonded to a nitrogen atom to which the group is attached, to form a ring,
K^{A} represents an alkylene group, a cycloalkylene group, an arylene group, a divalent hetero ring group, a group represented by -N(R')-, an oxygen atom or a sulfur atom, and these groups optionally have a substituent, R' represents a hydrogen atom, an alkyl group, a cycloalkyl group, an aryl group or a monovalent hetero ring group, and these groups optionally have a substituent, when a plurality of K^{A} are present, they may be the same or different,
X' represents a crosslink group selected from said Group A of crosslink group, a hydrogen atom, an alkyl group, a cycloalkyl group, an aryl group or a monovalent hetero ring group, and these groups optionally have a substituent, when a plurality of X' are present, they may be the same or different, however, at least one X' is a crosslink group selected from said Group A of crosslink group.

6. The light emitting device according to any one of Claims 1 to 3, wherein
said crosslink material is a low molecular compound represented by the formula (3): 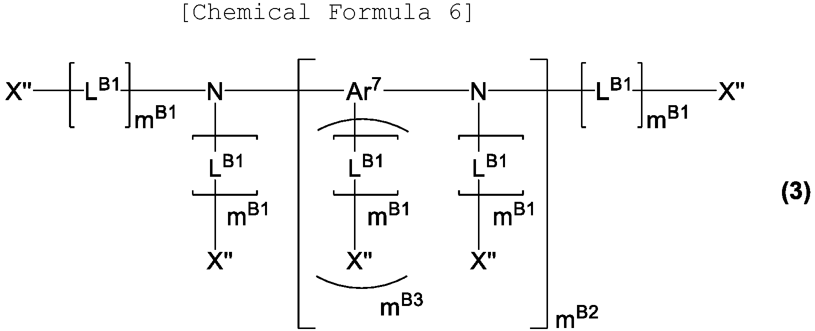 wherein,
m^{B1}, m^{B2} and m^{B3} each independently represent an integer of 0 or more and 10 or less, a plurality of m^{B1} may be the same or different, when a plurality of m^{B3} are present, they may be the same or different,
Ar⁷ represents an aromatic hydrocarbon group, a hetero ring group or a group in which at least one aromatic hydrocarbon ring and at least one hetero ring are bonded directly, and these groups optionally have a substituent, when a plurality of Ar⁷ are present, they may be the same or different,
L^{B1} represents an alkylene group, a cycloalkylene group, an arylene group, a divalent hetero ring group, a group represented by -N (R''') -, an oxygen atom or a sulfur atom, and these groups optionally have a substituent, R''' represents a hydrogen atom, an alkyl group, a cycloalkyl group, an aryl group or a monovalent hetero ring group, and these groups optionally have a substituent, when a plurality of L^{B1} are present, they may be the same or different,
X" represents a crosslink group selected from said Group A of crosslink group, a hydrogen atom, an alkyl group, a cycloalkyl group, an aryl group or a monovalent hetero ring group, and these groups optionally have a substituent, a plurality of X" may be the same or different, and at least one of a plurality of X" is a crosslink group selected from said Group A of crosslink group.

7. The light emitting device according to any one of Claims 1 to 6, wherein
said Ar^{T1} is a group represented by the formula (T1-1): 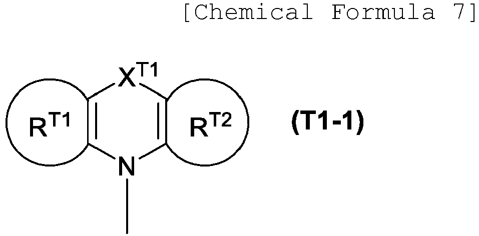 wherein,
the ring R^{T1} and the ring R^{T2} each independently represent an aromatic hydrocarbon ring or a hetero ring not containing a nitrogen atom having a double bond as a ring constituent atom, and these rings optionally have a substituent, when a plurality of such substituents are present, they may be combined together to form a ring together with atoms to which they are attached,
X^{T1} represents a single bond, an oxygen atom, a sulfur atom, a group represented by -N(R^{XT1})- or a group represented by -C(R^{XT1}')₂-, R^{XT1} and R^{XT1}' each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent, a plurality of R^{XT1}' may be the same or different and may be combined together to form a ring together with carbon atoms to which they are attached,
R^{XT1} and the substituent which the ring R^{T1} optionally has, R^{XT1} and the substituent which the ring R^{T2} optionally has, R^{XT1}' and the substituent which the ring R^{T1} optionally has, and R^{XT1}' and the substituent which the ring R^{T2} optionally has each may be combined together to form a ring together with atoms to which they are attached.

8. The light emitting device according to Claim 7, wherein
said group represented by the formula (T1-1) is a group represented by the formula (T1-1A), a group represented by the formula (T1-1B), a group represented by the formula (T1-1C) or a group represented by the formula (T1-1D): 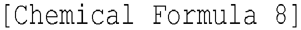 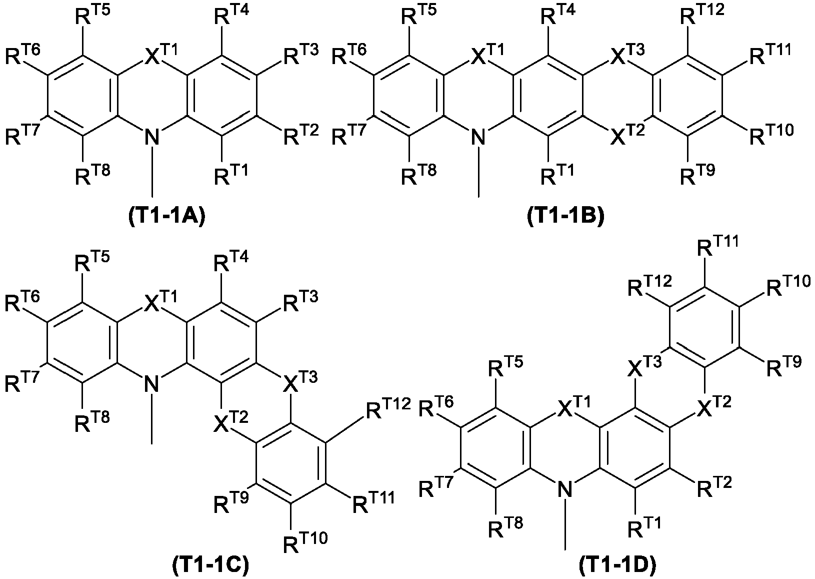 wherein,
X^{T1} represents the same meaning as described above,
X^{T2} and X^{T3} each independently represent a single bond, an oxygen atom, a sulfur atom, a group represented by -N(R^{XT2})-or a group represented by -C(R^{XT2}')₂-, R^{XT2} and R^{XT2}' each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent, a plurality of R^{XT2}' may be the same or different and may be combined together to form a ring together with carbon atoms to which they are attached,
R^{T1}, R^{T2}, R^{T3}, R^{T4}, R^{T5}, R^{T6}, R^{T7}, R^{T8}, R^{T9}, R^{T10}, R^{T11} and R^{T12} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a substituent,
R^{T1} and R^{T2}, R^{T2} and R^{T3}, R^{T3} and R^{T4}, R^{T5} and R^{T6}, R^{T6} and R^{T7}, R^{T7} and R^{T8}, R^{T9} and R^{T10}, R^{T10} and R^{T11}, and R^{T11} and R^{T12} each may be combined together to form a ring together with carbon atoms to which they are attached.

9. The light emitting device according to any one of Claims 1 to 8, wherein
said Ar^{T2} is a group obtained by removing from a diazole ring, a triazole ring, an oxadiazole ring, a thiadiazole ring, a thiazole ring, an oxazole ring, an isothiazole ring, an isooxazole ring, a benzodiazole ring, a benzotriazole ring, a benzooxadiazole ring, a benzothiadiazole ring, a benzothiazole ring, a benzooxazole ring, an azacarbazole ring, a diazacarbazole ring, a pyridine ring, a diazabenzene ring, a triazine ring, an azanaphthalene ring, a diazanaphthalene ring, a triazanaphthalene ring, a tetraazanaphthalene ring, an azaanthracene ring, a diazaanthracene ring, a triazaanthracene ring, a tetraazaanthracene ring, an azaphenanthrene ring, a diazaphenanthrene ring, a triazaphenanthrene ring or a tetraazaphenanthrene ring at least one hydrogen atom bonding directly to an atom constituting the ring, the group optionally having a substituent.

10. The light emitting device according to any one of Claims 1 to 9, wherein
said first organic layer is a layer not containing a phosphorescent metal complex.

11. The light emitting device according to any one of Claims 1 to 10, wherein
said first organic layer further contains at least one selected from the group consisting of a hole transporting material, a hole injection material, an electron transporting material, an electron injection material, a light emitting material and an antioxidant.

12. The light emitting device according to any one of Claims 1 to 11, wherein
said first organic layer and said second organic layer are adjacent.

13. The light emitting device according to any one of Claims 1 to 12, wherein
said second organic layer is a layer disposed between said anode and said first organic layer.

## Patentansprüche

1. Licht emittierende Vorrichtung mit einer Anode, einer Kathode, einer ersten organischen Schicht, die zwischen der Anode und der Kathode angeordnet ist, und einer zweiten organischen Schicht, die zwischen der Anode und der Kathode angeordnet ist, wobei
die erste organische Schicht eine Schicht ist, die eine durch die Formel (T) dargestellte Verbindung und eine durch die Formel (B) dargestellte fluoreszierende Verbindung enthält.
die zweite organische Schicht eine Schicht ist, die einen vernetzten Körper eines Vernetzungsmaterials enthält,
der absolute Wert der Differenz zwischen dem Energieniveau im niedrigsten angeregten Triplettzustand und dem Energieniveau im niedrigsten angeregten Singulettzustand der durch die Formel (T) dargestellten Verbindung 0,50 eV oder weniger beträgt,
der absolute Wert der Differenz zwischen dem Energieniveau im niedrigsten angeregten Triplettzustand und dem Energieniveau im niedrigsten angeregten Singulettzustand der durch die Formel (B) dargestellten fluoreszierenden Verbindung 0,55 eV oder mehr und 2,5 eV oder weniger beträgt,
die durch die Formel (T) dargestellte Verbindung ein Wirtsmaterial mit mindestens einer Funktion ist, die aus der Gruppe ausgewählt wird, die aus Lochinjektierbarkeit, Lochtransportierbarkeit, Elektroneninjektierbarkeit und Elektronentransportierbarkeit besteht,
die durch die Formel (B) dargestellte fluoreszierende Verbindung ein lichtemittierendes Material ist und
der niedrigste angeregte Triplettzustand des Wirtsmaterials auf einem höheren Energieniveau als der niedrigste angeregte Triplettzustand des lichtemittierenden Materials liegt, und der niedrigste angeregte Singulettzustand des Wirtsmaterials auf einem Energieniveau liegt, das höher ist als der niedrigste angeregte Singulettzustand des lichtemittierenden Materials,
wobei das Energieniveau im niedrigsten angeregten Triplettzustand und das Energieniveau im niedrigsten angeregten Singulettzustand einer Verbindung berechnet werden, indem die Struktur des Grundzustands der Verbindung mit dem B3LYP-Niveaudichtefunktionsverfahren optimiert wird und 6-31G* als Basisfunktion in dieser Operation unter Verwendung von Gaussian09 als quantenchemisches Berechnungsprogramm und des zeitabhängigen Dichtefunktionsverfahrens auf B3LYP-Ebene verwendet wird, und wenn ein Atom enthalten ist, für das 6-31G* nicht verwendet werden kann, Verwenden von LANL2DZ für das Atom: 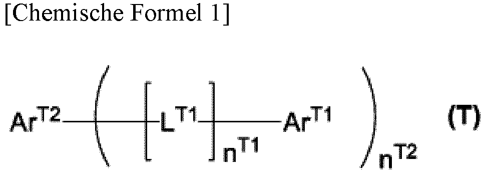 wobei
n^{T1} eine ganze Zahl von 0 oder mehr und 5 oder weniger darstellt, wenn mehrere n^{T1} vorhanden sind, können sie gleich oder verschieden sein,
n^{T2} eine ganze Zahl von 1 oder mehr und 10 oder weniger darstellt,
Ar^{T1} eine einwertige oder kondensierte einwertige Heteroringgruppe mit kondensiertem Ring ist, die ein Stickstoffatom ohne Doppelbindung als Ringbestandteilatom enthält und kein Stickstoffatom mit einer Doppelbindung als Ringbestandteilatom enthält, wobei die Gruppe optional einen Substituenten aufweist, wenn mehrere solcher Substituenten vorhanden sind, sie zusammen mit Atomen, an die sie gebunden sind, einen Ring bilden können, wenn mehrere Ar^{T1} vorhanden sind, sie gleich oder verschieden sein können,
L^{T1} eine Alkylengruppe, eine Cycloalkylengruppe, eine Arylengruppe, eine zweiwertige Heteroringgruppe, eine durch -N(R^{T1}')-, ein Sauerstoffatom oder ein Schwefelatom dargestellte Gruppe darstellt, wobei diese Gruppen optional einen Substituenten aufweisen, R^{T1}' ein Wasserstoffatom, eine Alkylgruppe, eine Cycloalkylgruppe, eine Arylgruppe oder eine einwertige Heteroringgruppe darstellt, wobei diese Gruppen optional einen Substituenten aufweisen, wenn mehrere L^{T1} vorhanden sind, sie gleich oder verschieden sein können,
Ar^{T2} eine Einzelring- oder Kondensationsring-Heteroringgruppe ist, die ein Stickstoffatom mit einer Doppelbindung als Ringbestandteilatom enthält, wobei die Gruppe optional einen Substituenten aufweist, wenn mehrere solcher Substituenten vorhanden sind, sie zusammen mit Atomen, an die sie gebunden sind, einen Ring bilden können,
[Chemische Formel 2]
Ar^{1B}-(-R^{1B})_{n1B} (B)
wobei
n^{1B} eine ganze Zahl von 0 oder mehr und 15 oder weniger darstellt,
Ar^{1B} eine aromatische Kohlenwasserstoffgruppe mit kondensiertem Ring darstellt und diese Gruppen optional einen Substituenten aufweisen, wenn mehrere solcher Substituenten vorhanden sind, sie zusammen mit Atomen, an die sie gebunden sind, einen Ring bilden können,
R^{1B} eine Alkylgruppe, eine Cycloalkylgruppe, eine Alkoxygruppe, eine Cycloalkoxygruppe, eine Arylgruppe, eine einwertige Heteroringgruppe, eine substituierte Aminogruppe, eine Alkenylgruppe, eine Cycloalkenylgruppe, eine Alkinylgruppe oder eine Cycloalkinylgruppe darstellt und diese Gruppen optional einen Substituenten aufweisen, und wenn mehrere R^{1B} vorhanden sind, sie gleich oder verschieden sein können und zusammen mit Kohlenstoffatomen, an die sie gebunden sind, zu einem Ring kombiniert werden können.

2. Licht emittierende Vorrichtung nach Anspruch 1,
wobei das Ar^{1B} eine Gruppe ist, die erhalten wird, indem von einem Naphthalinring, einem Anthracenring, einem Phenanthrenring, einem Dihydrophenanthrenring, einem Triphenylenring, einem Naphthacenring, einem Fluorenring, einem Spirobifluorenring, einem Pyrenring, einem Perylenring, einem Chrysenring, einem Indenring, einem Fluoranthenring, einem Benzofluoranthenring oder einem Acenaphthofluoranthenring mindestens ein Wasserstoffatom entfernt wird, das direkt an ein Kohlenstoffatom bindet, das den Ring bildet, wobei die Gruppe optional einen Substituenten aufweist.

3. Lichtemissionsvorrichtung nach Anspruch 1 oder 2, wobei
das R^{1B} eine Alkylgruppe, eine Arylgruppe oder eine substituierte Aminogruppe ist, wobei diese Gruppen optional einen Substituenten aufweisen.

4. Licht emittierende Vorrichtung nach einem der Ansprüche 1 bis 3, wobei
das Vernetzungsmaterial eine niedermolekulare Verbindung mit mindestens einer Vernetzungsgruppe ist, die aus Gruppe A der Vernetzungsgruppe ausgewählt wird, oder eine Polymerverbindung ist, die eine Vernetzungs-Konstitutionseinheit mit mindestens einer Vernetzungsgruppe enthält, die aus Gruppe A der Vernetzungsgruppe ausgewählt wird:
(Gruppe A der Vernetzungsgruppe) 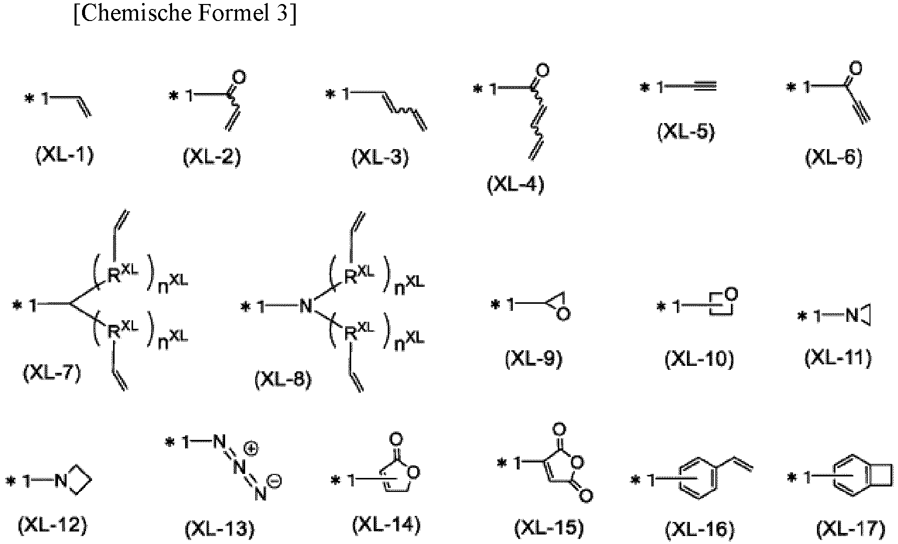 wobei R^{XL} eine Methylengruppe, ein Sauerstoffatom oder ein Schwefelatom darstellt und n^{XL} eine ganze Zahl von 0 bis 5 darstellt, wenn mehrere R^{XL} vorhanden sind, sie gleich oder verschieden sein können, und wenn mehrere n^{XL} vorhanden sind, sie gleich oder verschieden sein können, *1 eine Bindungsposition darstellt und diese Vernetzungsgruppen optional einen Substituenten aufweisen.

5. Licht emittierende Vorrichtung nach Anspruch 4, wobei
das Vernetzungsmaterial eine Polymerverbindung ist, die eine Vernetzungs-Konstitutionseinheit mit mindestens einer Vernetzungsgruppe enthält, die aus der Gruppe A der Vernetzungsgruppe ausgewählt wird, und
die Vernetzungs-Konstitutionseinheit eine Konstitutionseinheit ist, die durch die Formel (2) dargestellt wird, oder eine Konstitutionseinheit ist, die durch die Formel (2') dargestellt wird. 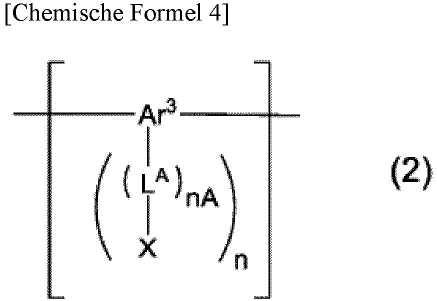 wobei
nA eine ganze Zahl von 0 bis 5 darstellt, und n 1 oder 2 darstellt, wenn mehrere nA vorhanden sind, sie gleich oder verschieden sein können,
Ar³ eine aromatische Kohlenwasserstoffgruppe oder eine Heteroringgruppe darstellt, und diese Gruppen optional einen Substituenten aufweisen,
L^{A} eine Alkylengruppe, eine Cycloalkylengruppe, eine Arylengruppe, eine zweiwertige Heteroringgruppe, eine durch -N(R')-, ein Sauerstoffatom oder ein Schwefelatom dargestellte Gruppe darstellt, wobei diese Gruppen optional einen Substituenten aufweisen, R' ein Wasserstoffatom, eine Alkylgruppe, eine Cycloalkylgruppe, eine Arylgruppe oder eine einwertige Heteroringgruppe darstellt, wobei diese Gruppen optional einen Substituenten aufweisen, wenn mehrere L^{A} vorhanden sind, sie gleich oder verschieden sein können,
X eine Vernetzungsgruppe darstellt, die aus der Gruppe A der Vernetzungsgruppe ausgewählt ist, wenn mehrere X vorhanden sind, sie gleich oder verschieden sein können, 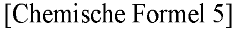 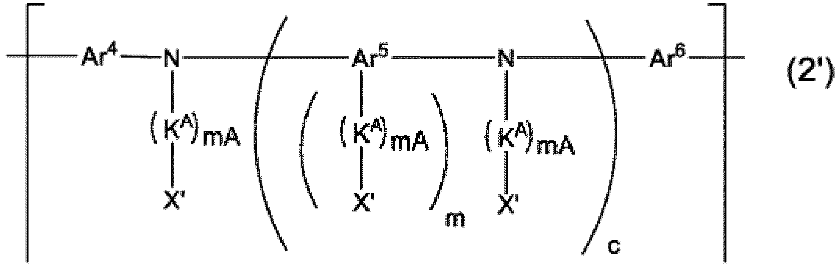
wobei
mA eine ganze Zahl von 0 bis 5 darstellt, m eine ganze Zahl von 1 bis 4 darstellt und c eine ganze Zahl von 0 oder 1 darstellt, wenn mehrere mA vorhanden sind, sie gleich oder verschieden sein können,
Ar⁵ eine aromatische Kohlenwasserstoffgruppe, eine Heteroringgruppe oder eine Gruppe darstellt, in der mindestens ein aromatischer Kohlenwasserstoffring und mindestens ein Heteroring direkt gebunden sind und diese Gruppen optional einen Substituenten aufweisen,
Ar⁴ und Ar⁶ jeweils unabhängig voneinander eine Arylengruppe oder eine zweiwertige Heteroringgruppe darstellen, und diese Gruppen optional einen Substituenten aufweisen,
Ar⁴, Ar⁵ und Ar⁶ jeweils direkt oder über ein Sauerstoffatom oder ein Schwefelatom an eine andere Gruppe als diese Gruppe gebunden sein können, die an ein Stickstoffatom gebunden ist, an das die Gruppe gebunden ist, um einen Ring zu bilden.
K^{A} eine Alkylengruppe, eine Cycloalkylengruppe, eine Arylengruppe, eine zweiwertige Heteroringgruppe, eine durch -N(R')-, ein Sauerstoffatom oder ein Schwefelatom dargestellte Gruppe darstellt, wobei diese Gruppen optional einen Substituenten aufweisen, R' ein Wasserstoffatom, eine Alkylgruppe, eine Cycloalkylgruppe, eine Arylgruppe oder eine einwertige Heteroringgruppe darstellt, wobei diese Gruppen optional einen Substituenten aufweisen, wenn mehrere KA vorhanden sind, sie gleich oder verschieden sein können,
X' eine Vernetzungsgruppe darstellt, ausgewählt aus der Gruppe A der Vernetzungsgruppe, einem Wasserstoffatom, einer Alkylgruppe, einer Cycloalkylgruppe, einer Arylgruppe oder einer einwertigen Heteroringgruppe, wobei diese Gruppen optional einen Substituenten aufweisen, wenn mehrere X' vorhanden sind, sie gleich oder verschieden sein können, jedoch ist mindestens ein X' eine Vernetzungsgruppe, ausgewählt aus der Gruppe A der Vernetzungsgruppe.

6. Licht emittierende Vorrichtung nach einem der Ansprüche 1 bis 3, wobei
das Vernetzungsmaterial eine niedermolekulare Verbindung ist, dargestellt durch die Formel (3): 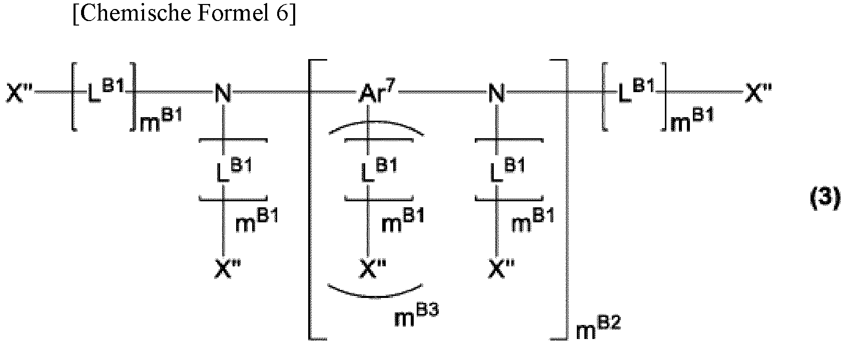 wobei
m^{B1}, m^{B2} und m^{B3} jeweils unabhängig voneinander eine ganze Zahl von 0 oder mehr und 10 oder weniger darstellen, mehrere von m^{B1} gleich oder verschieden sein können, wenn mehrere m^{B3} vorhanden sind, sie gleich oder verschieden sein können,
Ar⁷ eine aromatische Kohlenwasserstoffgruppe, eine Heteroringgruppe oder eine Gruppe darstellt, in der mindestens ein aromatischer Kohlenwasserstoffring und mindestens ein Heteroring direkt gebunden sind und diese Gruppen optional einen Substituenten aufweisen, wenn mehrere Ar⁷ vorhanden sind, sie gleich oder verschieden sein können,
L^{B1} eine Alkylengruppe, eine Cycloalkylengruppe, eine Arylengruppe, eine zweiwertige Heteroringgruppe, eine durch -N(R''')-, ein Sauerstoffatom oder ein Schwefelatom dargestellte Gruppe darstellt, wobei diese Gruppen optional einen Substituenten aufweisen, R'" ein Wasserstoffatom, eine Alkylgruppe, eine Cycloalkylgruppe, eine Arylgruppe oder eine einwertige Heteroringgruppe darstellt, wobei diese Gruppen optional einen Substituenten aufweisen, wenn mehrere L^{B1} vorhanden sind, sie gleich oder verschieden sein können,
X" eine Vernetzungsgruppe darstellt, ausgewählt aus der Gruppe A der Vernetzungsgruppe, einem Wasserstoffatom, einer Alkylgruppe, einer Cycloalkylgruppe, einer Arylgruppe oder einer einwertigen Heteroringgruppe, wobei diese Gruppen optional einen Substituenten aufweisen, mehrere von X" gleich oder verschieden sein können, und mindestens eines von mehreren X" eine Vernetzungsgruppe ist, die aus der Gruppe A der Vernetzungsgruppe ausgewählt ist.

7. Licht emittierende Vorrichtung nach einem der Ansprüche 1 bis 6, wobei
das Ar^{T1} eine Gruppe ist, die durch die Formel (T1-1) dargestellt wird. 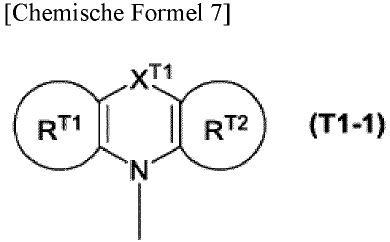 wobei
der Ring R^{T1} und der Ring R^{T2} jeweils unabhängig voneinander einen aromatischen Kohlenwasserstoffring oder einen Heteroring darstellen, der kein Stickstoffatom mit einer Doppelbindung als Ringbestandteilatom enthält, wobei diese Ringe optional einen Substituenten aufweisen, wenn mehrere solcher Substituenten vorhanden sind, sie zusammen mit Atomen, an die sie gebunden sind, einen Ring bilden können,
X^{T1} eine Einfachbindung, ein Sauerstoffatom, ein Schwefelatom, eine Gruppe dargestellt durch -N(R^{XX1})- oder eine Gruppe dargestellt durch -C(R^{XT1}')₂- darstellt, R^{XT1} und R^{XT1}' jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe, ein Halogenatom oder eine Cyanogruppe darstellen, wobei diese Gruppen optional einen Substituenten aufweisen, mehrere von R^{XT1}' gleich oder verschieden sein können und zusammen mit Kohlenstoffatomen, an die sie gebunden sind, zu einem Ring kombiniert werden können,
R^{XT1} und der Substituent, den der Ring R^{X1} optional aufweist, R^{XT1} und der Substituent, den der Ring R^{T2} optional aufweist, R^{XT1}' und der Substituent, den der Ring R^{T1} optional aufweist, und R^{XT1}' und der Substituent, den der Ring R^{T2} optional aufweist, zusammen mit Atomen, an die sie gebunden sind, einen Ring bilden können.

8. Licht emittierende Vorrichtung nach Anspruch 7,
wobei die durch die Formel (T1-1) dargestellte Gruppe eine durch die Formel (T1-1A) dargestellte Gruppe, eine durch die Formel (T1-1B) dargestellte Gruppe, eine durch die Formel (T1-1C) dargestellte Gruppe oder eine durch die Formel (T1-1D) dargestellte Gruppe ist: 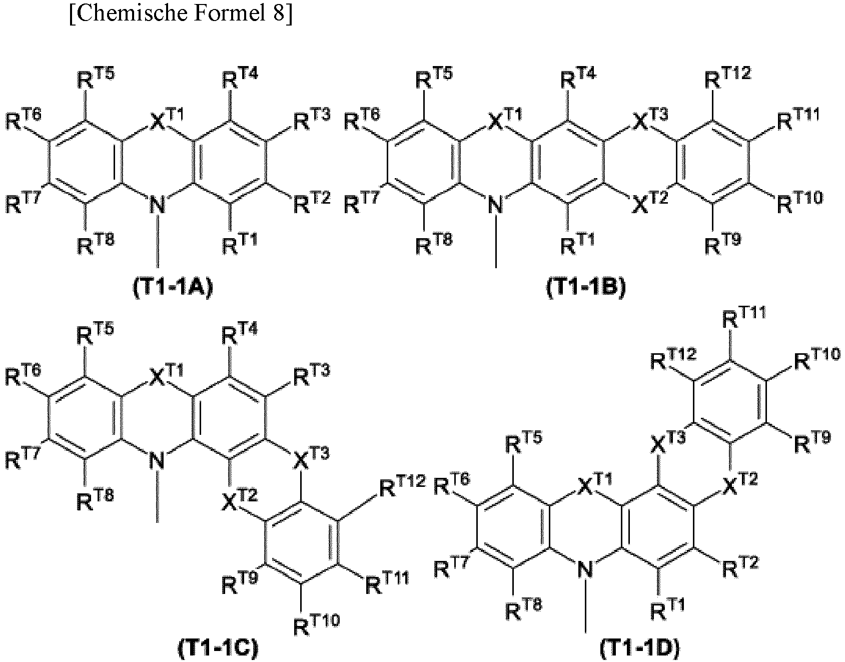 wobei
X^{T1} die gleiche Bedeutung wie oben beschrieben hat,
X^{T2} und X^{T3} jeweils unabhängig voneinander eine Einfachbindung, ein Sauerstoffatom, ein Schwefelatom, eine durch -N(R^{XT2}) dargestellte Gruppe - oder eine durch -C(R^{XT2}')₂- dargestellte Gruppe darstellen, R^{XT2} und R^{XT2}' jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe, ein Halogenatom oder eine Cyanogruppe darstellen, wobei diese Gruppen optional einen Substituenten aufweisen, mehrere R^{XT2}' gleich oder verschieden sein können und zusammen mit Kohlenstoffatomen, an die sie gebunden sind, zu einem Ring kombiniert werden können,
R^{T1}, R^{T2}, R^{T3} , R^{T4}, R^{T5}, R^{T6}, R^{T7}, R^{T8}, R^{T9}, R^{T10}, R^{T11} und R^{T12} jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe, ein Halogenatom oder eine Cyanogruppe darstellen, wobei diese Gruppen optional einen Substituenten aufweisen,
R^{T1} und R^{T2}, R^{T2} und R^{T3} , R^{T3} und R^{T4}, R^{T5} und R^{T6}, R^{T6} und R^{T7}, R^{T7} und R^{T8}, R^{T9} und R^{T10}, R^{T10} und R^{T11} und R^{T11} und R^{T12} jeweils kombiniert werden können, um einen Ring zusammen mit Kohlenstoffatomen, an die sie gebunden sind, zu bilden.

9. Licht emittierende Vorrichtung nach einem der Ansprüche 1 bis 8, wobei
das Ar^{T2} eine Gruppe ist, die erhalten wird, indem von einem Diazolring, einem Triazolring, einem Oxadiazolring, einem Thiadiazolring, einem Thiazolring, einem Oxazolring, einem Isothiazolring, einem Isooxazolring, einem Benzodiazolring, einem Benzotriazolring, einem Benzooxadiazolring, einem Benzothiadiazolring, einem Benzothiazolring, einem Benzooxazolring, einem Azacarbazolring, einem Diazacarbazolring, einem Pyridinring, einem Diazabenzolring, einem Triazinring, einem Anazanaphthalinring, einem Diazanaphthalinring, einem Triazon einem Tetraazanaphthalinring, einem Azaanthracenring, einem Diazaanthracenring, einem Triazaanthracenring, einem Tetraazaanthracenring, einem Azaphenanthrenring, einem Diazaphenanthrenring, einem Triazaphenanthrenring oder einem Tetraazaphenanthrenring mindestens ein Wasserstoffatom entfernt wird, das direkt an ein den Ring bildendes Atom bindet, wobei die Gruppe optional einen Substituenten aufweist.

10. Licht emittierende Vorrichtung nach einem der Ansprüche 1 bis 9, wobei
die erste organische Schicht eine Schicht ist, die keinen phosphoreszierenden Metallkomplex enthält.

11. Licht emittierende Vorrichtung nach einem der Ansprüche 1 bis 10, wobei
die erste organische Schicht ferner mindestens eines umfasst, das aus der Gruppe ausgewählt ist, die aus einem Lochtransportmaterial, einem Lochinjektionsmaterial, einem Elektronentransportmaterial, einem Elektroneninjektionsmaterial, einem lichtemittierenden Material und einem Antioxidationsmittel besteht.

12. Licht emittierende Vorrichtung nach einem der Ansprüche 1 bis 11, wobei
die erste organische Schicht und die zweite organische Schicht benachbart angeordnet sind.

13. Licht emittierende Vorrichtung nach einem der Ansprüche 1 bis 12, wobei
die zweite organische Schicht eine Schicht ist, die zwischen der Anode und der ersten organischen Schicht angeordnet ist.

## Revendications

1. Dispositif électroluminescent comportant une anode, une cathode, une première couche organique disposée entre l'anode et la cathode et une seconde couche organique disposée entre l'anode et la cathode, dans lequel
ladite première couche organique est une couche contenant un composé représenté par la formule (T) et un composé fluorescent représenté par la formule (B),
ladite seconde couche organique est une couche contenant un corps réticulé d'un matériau de réticulation,
la valeur absolue de la différence entre le niveau d'énergie à l'état excité du triplet le plus bas et le niveau d'énergie à l'état excité du singulet le plus bas dudit composé représenté par la formule (T) est de 0,50 eV ou moins,
la valeur absolue de la différence entre le niveau d'énergie à l'état excité du triplet le plus bas et le niveau d'énergie à l'état excité du singulet le plus bas dudit composé fluorescent représenté par la formule (B) est de 0,55 eV ou plus et 2,5 eV ou moins,
le composé représenté par la formule (T) est un matériau hôte ayant au moins une fonction choisie dans le groupe constitué par l'injectabilité des trous, la transportabilité des trous, l'injectabilité des électrons et la transportabilité des électrons,
le composé fluorescent représenté par la formule (B) est un matériau électroluminescent et
l'état excité du triplet le plus bas du matériau hôte est à un niveau d'énergie supérieur à celui de l'état excité du triplet le plus bas du matériau électroluminescent, et l'état excité du singulet le plus bas du matériau hôte est à un niveau d'énergie supérieur à celui de l'état excité du singulet le plus bas du matériau électroluminescent,
dans lequel le niveau d'énergie à l'état excité du triplet le plus bas et le niveau d'énergie à l'état excité du singulet le plus bas d'un composé sont calculés en optimisant la structure de l'état fondamental du composé avec le procédé fonctionnel de densité de niveau B3LYP et en utilisant 6-31G* comme fonction de base dans ce opération, en utilisant Gaussian09 comme programme de calcul de chimie quantique et le procédé fonctionnel de densité dépendant du temps au niveau B3LYP, et, lorsqu'un atome pour lequel 6-31G* ne peut pas être utilisé est contenu, en utilisant LANL2DZ pour l'atome : 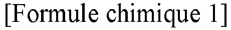 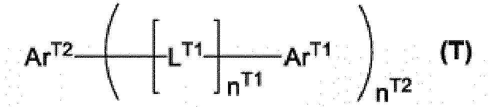
dans lequel, n^{T1} représente un entier de 0 ou plus et 5 ou moins, lorsqu'une pluralité de n^{T1} sont présents, ils peuvent être identiques ou différents,
n^{T2} représente un entier de 1 ou plus et 10 ou moins,
Ar^{T1} est un cycle unique ou un groupe hétérocyclique monovalent à cycle condensé contenant un atome d'azote n'ayant pas de double liaison en tant qu'atome constituant le cycle et ne contenant pas un atome d'azote ayant une double liaison en tant qu'atome constitutuant le cycle, et le groupe a éventuellement un substituant, lorsqu'une pluralité de tels substituants sont présents, ils peuvent être combinés ensemble pour former un cycle avec les atomes auxquels ils sont liés, lorsqu'une pluralité d'Ar^{T1} sont présents, ils peuvent être identiques ou différents,
L^{T1} représente un groupe alkylène, un groupe cycloalkylène, un arylène, un groupe hétérocyclique divalent, un groupe représenté par -N(R^{T1}')-, un atome d'oxygène ou un atome de soufre, et ces groupes ont éventuellement un substituant, R^{T1}' représente un atome d'hydrogène, un groupe alkyle, un groupe cycloalkyle, un groupe aryle ou un groupe hétérocyclique monovalent, et ces groupes ont éventuellement un substituant, lorsqu'une pluralité de L^{T1} sont présents, ils peuvent être identiques ou différents,
Ar^{T2} est un groupe hétérocyclique à cycle unique ou à cycle condensé contenant un atome d'azote ayant une double liaison comme un atome constituant le cycle, et le groupe a éventuellement un substituant, lorsqu'une pluralité de ces substituants sont présents, ils peuvent être combinés ensemble pour former un cycle avec les atomes auxquels ils sont liés,
[formule chimique 2]
Ar^{1B} -(R^{1B})-_{n1B} (B)
dans lequel,
n^{1B} représente un entier de 0 ou plus et 15 ou moins,
Ar^{1B} représente un groupe hydrocarboné aromatique à cycle condensé, et ces groupes ont éventuellement un substituant, lorsqu'une pluralité de ces substituants sont présents, ils peuvent être combinés ensemble pour former un cycle avec les atomes auxquels ils sont liés,
R^{1B} représente un groupe alkyle, un groupe cycloalkyle, un groupe alcoxy, un groupe cycloalcoxy, un groupe aryle, un groupe hétérocyclique monovalent, un groupe amino substitué, un groupe alcényle, un groupe cycloalcényle, un groupe alcynyle ou un groupe cycloalcynyle, et ces groupes ont éventuellement un substituant, et lorsqu'une pluralité de R^{1B} sont présents, ils peuvent être identiques ou différents et peuvent être combinés ensemble pour former un cycle avec des atomes de carbone auxquels ils sont liés.

2. Dispositif électroluminescent selon la revendication 1, dans lequel ledit Ar^{1B} est un groupe obtenu par élimination d'un cycle naphtalène, d'un cycle anthracène, d'un cycle phénanthrène, d'un cycle dihydrophénanthrène, d'un cycle triphénylène, d'un cycle naphtacène, d'un cycle fluorène, d'un cycle spirobifluorène, d'un cycle pyrène, d'un cycle pérylène, d'un cycle chrysène, d'un cycle indène, d'un cycle fluoranthène, d'un cycle benzofluoranthène ou d'un cycle acénaphtofluoranthène au moins un atome d'hydrogène se liant directement à un atome de carbone constituant le cycle, le groupe ayant éventuellement un substituant.

3. Dispositif électroluminescent selon la revendication 1 ou 2, dans lequel ledit R^{1B} est un groupe alkyle, un groupe aryle ou un groupe amino substitué, ces groupes ayant éventuellement un substituant.

4. Dispositif électroluminescent selon l'une quelconque des revendications 1 à 3, dans lequel
ledit matériau de réticulation est un composé de faible poids moléculaire ayant au moins un groupe de réticulation choisi dans le groupe A du groupe de réticulation ou un composé polymère contenant une unité constitutionnelle de réticulation ayant au moins un groupe de réticulation choisi dans le groupe A du groupe de réticulation :
(groupe A du groupe de réticulation) 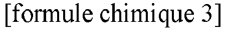 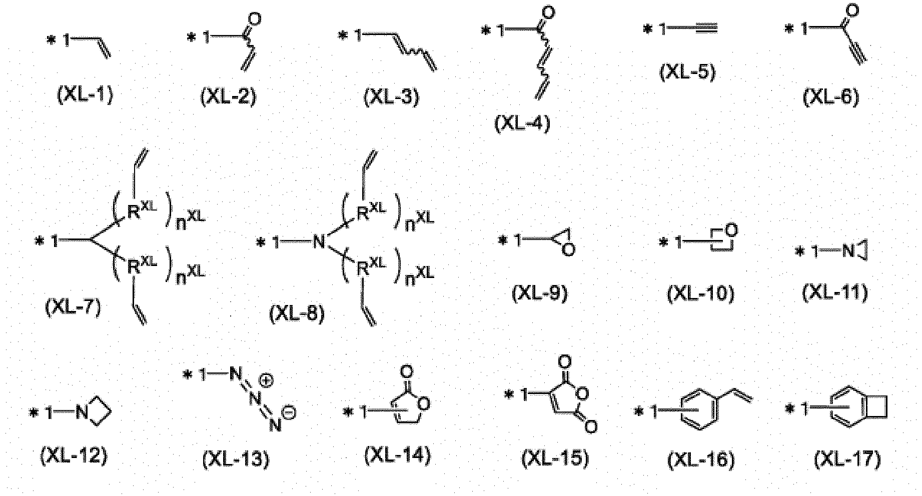 dans lequel, R^{XL} représente un groupe méthylène, un atome d'oxygène ou un atome de soufre et n^{XL} représente un entier de 0 à 5, lorsqu'une pluralité de R^{XL} sont présents, ils peuvent être identiques ou différents et lorsqu'une pluralité de n^{XL} sont présents, ils peuvent être identiques ou différents, *1 représente une position de liaison, et ces groupes de réticulation ont éventuellement un substituant.

5. Dispositif électroluminescent selon la revendication 4, dans lequel
ledit matériau de réticulation est un composé polymère contenant une unité constitutionnelle de réticulation ayant au moins un groupe de réticulation choisi dans ledit groupe A du groupe de réticulation et ladite unité constitutionnelle de réticulation est une unité constitutionnelle représentée par la formule (2) ou une unité constitutionnelle représentée par la formule (2') : 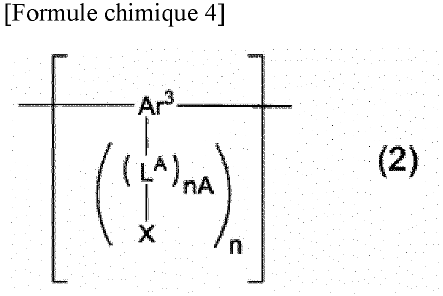 dans lequel,
nA représente un entier de 0 à 5, et n représente 1 ou 2, lorsqu'une pluralité de nA sont présents, ils peuvent être identiques ou différents,
Ar³ représente un groupe hydrocarboné aromatique ou un groupe hétérocyclique, et ces groupes ont éventuellement un substituant,
L^{A} représente un groupe alkylène, un groupe cycloalkylène, un groupe arylène, un groupe hétérocyclique divalent, un groupe représenté par -N(R')-, un atome d'oxygène ou un atome de soufre, et ces groupes ont éventuellement un substituant, R' représente un atome d'hydrogène, un groupe alkyle, un groupe cycloalkyle, un groupe aryle ou un groupe hétérocyclique monovalent, et ces groupes ont éventuellement un substituant, lorsqu'une pluralité de L^{A} sont présents, ils peuvent être identiques ou différents,
X représente un groupe de réticulation choisi dans ledit groupe A du groupe de réticulation, lorsqu'une pluralité de X sont présents, ils peuvent être identiques ou différents, 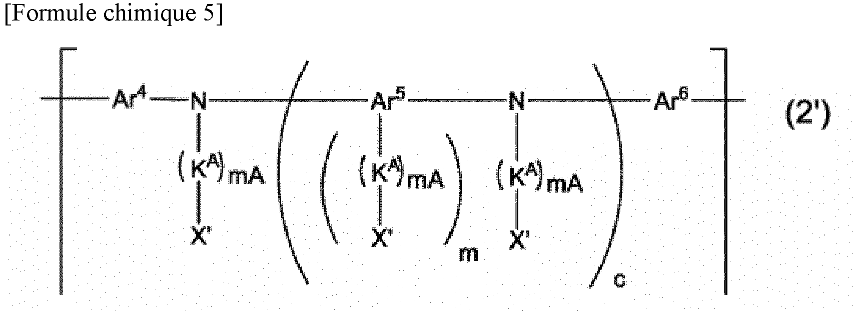
dans lequel,
mA représente un entier de 0 à 5, m représente un entier de 1 à 4 et c représente un entier de 0 ou 1, lorsqu'une pluralité de mA sont présents, ils peuvent être identiques ou différents,
Ar⁵ représente un groupe hydrocarboné aromatique, un groupe hétérocyclique ou un groupe dans lequel au moins un cycle hydrocarboné aromatique et au moins un hétérocycle sont liés directement, et ces groupes ont éventuellement un substituant,
Ar⁴ et Ar⁶ représentent chacun indépendamment un groupe arylène ou un groupe hétérocyclique divalent, et ces groupes ont éventuellement un substituant,
Ar⁴, Ar⁵ et Ar⁶ peuvent chacun être liés directement ou liés via un atome d'oxygène ou un atome de soufre à un groupe autre que ce groupe, lié à un atome d'azote auquel le groupe est lié, pour former un cycle,
K^{A} représente un groupe alkylène, un groupe cycloalkylène, un groupe arylène, un groupe hétérocyclique divalent, un groupe représenté par -N(R')-, un atome d'oxygène ou un atome de soufre, et ces groupes ont éventuellement un substituant, R' représente un atome d'hydrogène, un groupe alkyle, un groupe cycloalkyle, un groupe aryle ou un groupe hétérocyclique monovalent, et ces groupes ont éventuellement un substituant, lorsqu'une pluralité de K^{A} sont présents, ils peuvent être identiques ou différents,
X' représente un groupe de réticulation choisi dans ledit groupe A du groupe de réticulation, d'un atome d'hydrogène, d'un groupe alkyle, d'un groupe cycloalkyle, d'un groupe aryle ou d'un groupe hétérocyclique monovalent, et ces groupes ont éventuellement un substituant, lorsqu'une pluralité de X' sont présents, ils peuvent être identiques ou différents, cependant, au moins un X' est un groupe de réticulation choisi dans ledit groupe A du groupe de réticulation.

6. Dispositif électroluminescent selon l'une quelconque des revendications 1 à 3, dans lequel
ledit matériau de réticulation est un composé de faible poids moléculaire représenté par la formule (3) : 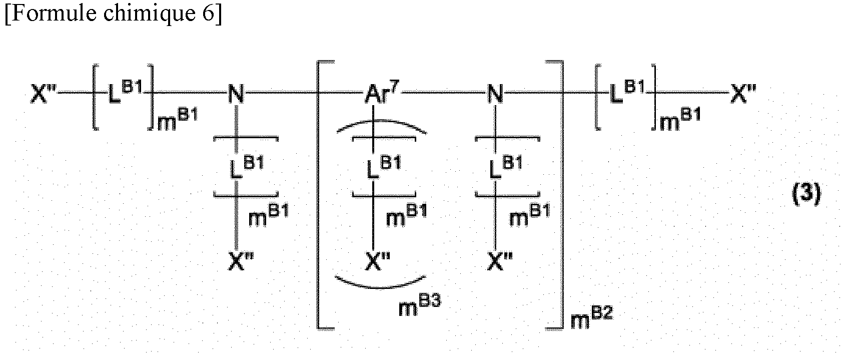
dans lequel, m^{B1}, m^{B2} et m^{B3} représentent chacun indépendamment un entier de 0 ou plus et 10 ou moins, une pluralité de m^{B1} peuvent être identiques ou différents, lorsqu'une pluralité de m^{B3} sont présents, ils peuvent être identiques ou différents,
Ar⁷ représente un groupe hydrocarboné aromatique, un groupe hétérocyclique ou un groupe dans lequel au moins un cycle hydrocarboné aromatique et au moins un hétérocycle sont liés directement, et ces groupes ont éventuellement un substituant, lorsqu'une pluralité d'Ar⁷ sont présents, ils peuvent être le identiques ou différents,
L^{B1} représente un groupe alkylène, un groupe cycloalkylène, un groupe arylène, un groupe hétérocyclique divalent, un groupe représenté par -N(R''')-, un atome d'oxygène ou un atome de soufre, et ces groupes ont éventuellement un substituant, R'" représente un atome d'hydrogène, un groupe alkyle, un groupe cycloalkyle, un groupe aryle ou un groupe hétérocyclique monovalent, et ces groupes ont éventuellement un substituant, lorsqu'une pluralité de L^{B1} sont présents, ils peuvent être identiques ou différents,
X" représente un groupe de réticulation choisi dans ledit groupe A du groupe de réticulation, d'un atome d'hydrogène, d'un groupe alkyle, d'un groupe cycloalkyle, d'un groupe aryle ou d'un groupe hétérocyclique monovalent, et ces groupes ont éventuellement un substituant, une pluralité de X" peuvent être identiques ou différents, et au moins l'un d'une pluralité de X" est un groupe de réticulation choisi dans ledit groupe A du groupe de réticulation.

7. Dispositif électroluminescent selon l'une quelconque des revendications 1 à 6, dans lequel
ledit Ar^{T1} est un groupe représenté par la formule (T1-1) : 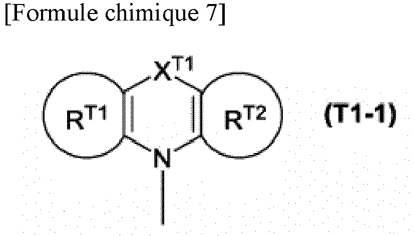
dans lequel, le cycle R^{T1} et le cycle R^{T2} représentent chacun indépendamment un cycle hydrocarboné aromatique ou un hétérocycle ne contenant pas un atome d'azote ayant une double liaison comme atome constituant le cycle, et ces cycles ont éventuellement un substituant, lorsqu'une pluralité de tels substituants sont présents, ils peuvent être combinés ensemble pour former un cycle avec les atomes auxquels ils sont liés,
X^{T1} représente une liaison simple, un atome d'oxygène, un atome de soufre, un groupe représenté par -N(R^{XT1})- ou un groupe représenté par -C(R^{XT1}')₂-, R^{XT1} et R^{XX1}' représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocycle monovalent, un groupe amino substitué, un atome d'halogène ou un groupe cyano, et ces groupes ont éventuellement un substituant, une pluralité de R^{XX1}' peuvent être identiques ou différents et peuvent être combinés ensemble pour former un cycle avec des atomes de carbone auxquels ils sont liés,
R^{XT1} et le substituant que le cycle R^{T1} a éventuellement, R^{XT1} et le substituant que le cycle R^{T2} a éventuellement, R^{XX1}' et le substituant que le cycle R^{T1} a éventuellement, et R^{XT1}' et le substituant que le cycle R^{T2} a éventuellement peuvent chacun être combinés pour former un cycle avec les atomes auxquels ils sont liés.

8. Dispositif électroluminescent selon la revendication 7, dans lequel ledit groupe représenté par la formule (T1-1) est un groupe représenté par la formule (T1-1A), un groupe représenté par la formule (T1-1B), un groupe représenté par la formule (T1-1C) ou un groupe représenté par la formule (T1-1D) : 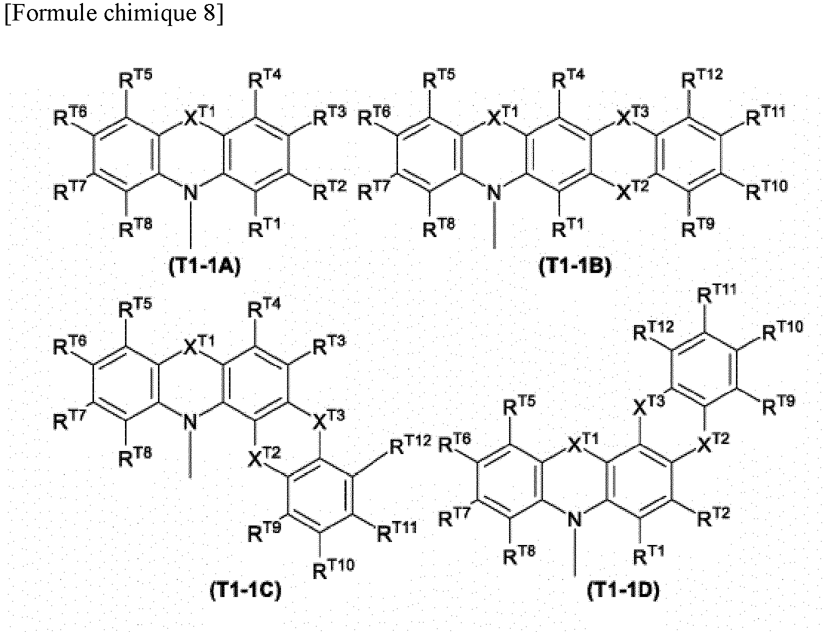 dans lequel,
X^{T1} représente la même signification que celle décrite ci-dessus,
X^{T2} et X^{T3} représentent chacun indépendamment une liaison simple, un atome d'oxygène, un atome de soufre, un groupe représenté par -N(R^{XT2})- ou un groupe représenté par -C(R^{XT2}')₂-, R^{XT2} et R^{XT2}' représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué, un atome d'halogène ou un groupe cyano, et ces groupes ont éventuellement un substituant, une pluralité de R^{XT2}' peuvent être identiques ou différents et peuvent être combinés ensemble pour former un cycle avec des atomes de carbone auxquels ils sont liés,
R^{T1}, R^{T2}, R^{T3}, R^{T4}, R^{T5}, R^{T6}, R^{T7}, R^{T8}, R^{T9}, R^{T10}, R^{T11} et R^{T12} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué, un atome d'halogène ou un groupe cyano, et ces groupes ont éventuellement un substituant,
R^{T1} et R^{T2}, R^{T2} et R^{T3} , R^{T3} et R^{T4}, R^{T5} et R^{T6}, R^{T6} et R^{T7}, R^{T7} et R^{T8}, R^{T9} et R^{T10}, R^{T10} et R^{T11}, et R^{T11} et R^{T12} peuvent chacun être combinés pour former un cycle avec les atomes de carbone auxquels ils sont liés.

9. Dispositif électroluminescent selon l'une quelconque des revendications 1 à 8, dans lequel
ledit Ar^{T2} est un groupe obtenu par élimination d'un cycle diazole, d'un cycle triazole, d'un cycle oxadiazole, d'un cycle thiadiazole, d'un cycle thiazole, d'un cycle oxazole, d'un cycle isothiazole, d'un cycle isooxazole, d'un cycle benzodiazole, d'un cycle benzotriazole, d'un cycle benzooxadiazole, d'un cycle benzothiadiazole, d'un cycle benzothiazole, d'un cycle benzooxazole, d'un cycle azacarbazole, d'un cycle diazacarbazole, d'un cycle pyridine, d'un cycle diazabenzène, d'un cycle triazine, d'un cycle azanaphtalène, d'un cycle diazanaphtalène, d'un cycle triazanaphtalène, d'un cycle tétraazanaphtalène, d'un cycle azaanthracène, d'un cycle diazaanthracène, d'un cycle triazaanthracène, d'un cycle tétraazaanthracène, d'un cycle azaphénanthrène, d'un cycle diazanphénanthrène, d'un cycle triazanphénanthrène ou d'un cycle tetraanphénanthrène d'au moins un atome d'hydrogène se liant directement à un atome constituant le cycle, le groupe ayant éventuellement un substituant.

10. Dispositif électroluminescent selon l'une quelconque des revendications 1 à 9, dans lequel
ladite première couche organique est une couche ne contenant pas de complexe métallique phosphorescent.

11. Dispositif électroluminescent selon l'une quelconque des revendications 1 à 10, dans lequel
ladite première couche organique contient en outre au moins une couche choisie dans le groupe constitué par un matériau de transport de trous, un matériau d'injection de trous, un matériau de transport d'électrons, un matériau d'injection d'électrons, un matériau électroluminescent et un antioxydant.

12. Dispositif électroluminescent selon l'une quelconque des revendications 1 à 11, dans lequel
ladite première couche organique et ladite seconde couche organique sont adjacentes.

13. Dispositif électroluminescent selon l'une quelconque des revendications 1 à 12, dans lequel
ladite seconde couche organique est une couche disposée entre ladite anode et ladite première couche organique.
